# EUROPEAN PATENT APPLICATION

(11) **EP 4 521 906 A1**
(43) Date of publication of application: **12.03.2025**
(21) Application number: 23799710.1
(22) Date of filing: 04.05.2023
(51) Int. Cl.: H10K 85/60, H10K 50/12, H10K 85/30

(54) **COMPOSITION FOR ORGANIC ELECTROLUMINESCENT DEVICE AND ORGANIC ELECTROLUMINESCENT DEVICE COMPRISING SAME**

(30) Priority: 06.05.2022 KR 20220056288; 29.06.2022 KR 20220079565
(71) Applicant: Solus Advanced Materials Co., Ltd., Iksan-si, Jeollabuk-do 54584 (KR)
(72) Inventor: KIM, Youngbae, Yongin-si, Gyeonggi-do 16858 (KR); PARK, Hocheol, Yongin-si, Gyeonggi-do 16858 (KR); JO, Hyunjong, Yongin-si, Gyeonggi-do 16858 (KR); JUNG, Hwasoon, Yongin-si, Gyeonggi-do 16858 (KR); SONG, Hyobum, Yongin-si, Gyeonggi-do 16858 (KR); KIM, Geunhyeong, Yongin-si, Gyeonggi-do 16858 (KR)
(74) Representative: Office Freylinger
(86) International application number: PCT/KR2023/006131
(87) International publication number: WO 2023/214829

(57) **Abstract**

The present disclosure relates to a composition for an organic electroluminescent device and an organic electroluminescent device comprising same. The composition for an organic electroluminescent device comprises: a first host represented by chemical formula 1; and a second host represented by chemical formula 2, and details of chemical formulas 1 and 2 are as defined in the specification.

## Description

### Technical Field

The present disclosure relates to a composition for an organic electroluminescent device and an organic electroluminescent device including same.

### Background Art

Organic electroluminescent devices (hereinafter, "organic EL devices") operate by applying a voltage between two electrodes, where holes are injected from the anode and electrons are injected into the organic layer from the cathode. When the injected holes and electrons combine, excitons are formed, and light is emitted when these excitons return to the ground state. Depending on the function thereof, the materials used in the organic layer can be classified into emission materials, hole injection materials, hole transport materials, electron transport materials, and electron injection materials.

The materials used for forming the emission layer in organic EL devices can be classified into blue, green, and red emission materials based on the emission color. Additionally, yellow and orange emission materials are also used to achieve better natural color representation. To increase color purity and improve emission efficiency through energy transfer, a host/dopant system can be used as the emission material. The dopant materials are divided into fluorescent dopants, which use organic materials, and phosphorescent dopants, which utilize metal complexes containing heavy atoms such as Ir and Pt. The development of such phosphorescent materials has attracted significant attention, as they theoretically offer up to four times the emission efficiency compared to fluorescent materials. This has increased the interest not only in phosphorescent dopants but also in phosphorescent host materials.

To date, NPB, BCP, and Alq₃ have been widely known as materials for hole injection layers, hole transport layers, and hole blocking layers. Emission materials like anthracene derivatives have been reported as fluorescent dopant/host materials. Particularly as for phosphorescent materials, which offer significant advantages in terms of efficiency, among emission materials, Ir-containing metal complexes such as Firpic, Ir(ppy)₃, and (acac)Ir(btp)₂ are used as blue, green, and red dopant materials. So far, CBP has shown excellent characteristics as a phosphorescent host material.

However, conventional organic layer materials, while advantageous in terms of emission properties, suffer from low glass transition temperatures and poor thermal stability, resulting in unsatisfactory lifespan in organic EL devices. Therefore, there is a need for the development of organic layer materials with superior performance.

### Disclosure of Invention

### Technical Problem

The present disclosure aims to provide a composition that can realize a high-efficiency and long-lifespan organic electroluminescent device.

The present disclosure is also to provide an organic electroluminescent device comprising the aforementioned composition as an organic layer material (e.g., emission layer material), which exhibits low driving voltage, high emission efficiency, and improved lifespan.

### Solution to Problem

To achieve the goals, the present disclosure provides a composition for an organic electroluminescent device, the composition including a first host represented by the following Chemical Formula 1 and a second host represented by the following Chemical Formula 2: 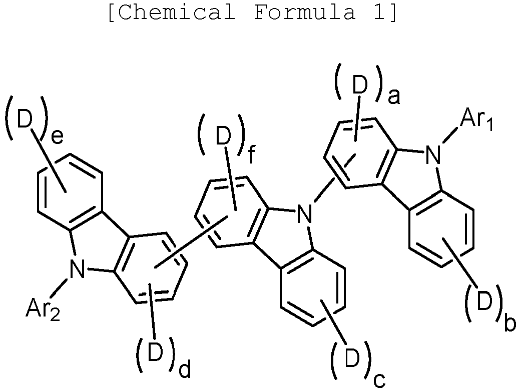 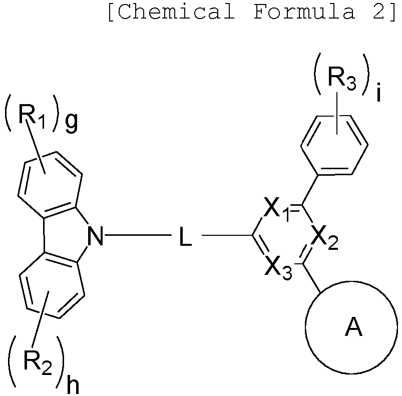 wherein,
Ar₁ and Ar₂ are the same as or different from each other, and are each independently selected from the group consisting of an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀,
X₁ to X₃ are same or different from each other, and are each independently N or C(R₆), with at least two of X₁ to X₃ being each N,
L is a single bond or is selected from the group consisting of an arylene group of C₆-C₆₀ and a heteroarylene group of 5 to 60 nuclear atoms,
A is a substituent represented by the following 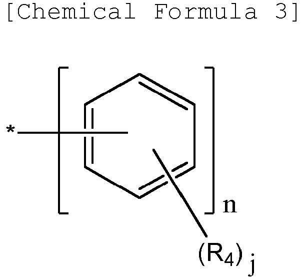 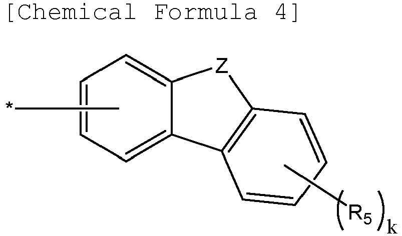
wherein,
Z is selected from the group consisting of O, S, Se, and C(R₇) (R_{B}) ,
R₁ to R₈, which are same or different, are each independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron vof C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀, or may form a fused ring with an adjacent groups,
a, d, and f are each independently an integer of 0 to 3,
b, c, e, g, i, j, and k are each independently an integer of 0 to 4,
n is an integer of 1 to 3,
in Chemical Formula 1, the hydrogen atoms on the benzene rings in the carbazole moiety with no deuterium atoms substituted therein may be substituted by a substituent selected from the group consisting of an alkyl group of C₁-C₄₀, an aryl group of C₆-C₄₀, and a heteroaryl group of 5 to 40 nuclear atoms,
the arylene group and heteroarylene groups of L and the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group and fused ring of Ar₁ to Ar₂ and R₁ to R₈ are each independently substituted with one or more substituents selected from the group consisting of a deuterium atom (D), a halogen group, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an aryl phosphine oxide group of C₆-C₆₀, an aryl phosphine oxide group of C₆-C₆₀, and an arylamine group of C₆-C₆₀, and when the substituents are plural in number, the substituents are the same as or different from each other.

In addition, the present disclosure provides an organic electroluminescent device including: an anode; a cathode; and at least one organic layer interposed between the anode and the cathode, wherein the at least one organic layer includes the aforementioned composition.

### Advantageous Effects of Invention

According to an embodiment of the present disclosure, an organic electroluminescent device wherein a compound with strong hole characteristics and a compound with strong electron characteristics are used in combination as hosts can not only exhibit low driving voltage, high efficiency, and long lifespan characteristics, but also demonstrate excellent phosphorescent emission properties.

The effects of the present disclosure are not limited to the exemplary description provided above and a variety of additional effects are included within the scope of this specification.

### Brief Description of Drawings

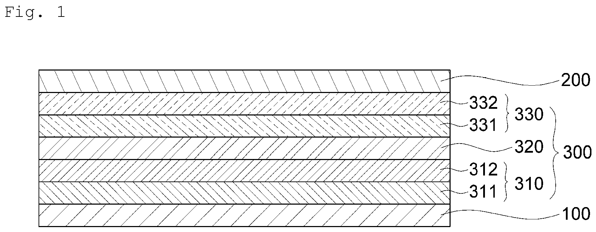

FIG. 1 is a cross-sectional view illustrating the structure of an organic electroluminescent device according to an embodiment of the present disclosure.

### <Description of Reference Numerals>

100: Anode
200: Cathode
300: Organic layer
310: Hole transport region
311: Hole injection layer
312: Hole transport layer
320: Emission layer
330: Electron transport region
331: Electron transport layer
332: Electron injection layer

### Best Mode for Carrying out the Invention

The advantages and features of the present disclosure, and methods for achieving them, will become apparent with reference to the exemplary embodiments described below in detail along with the accompanying drawings. However, the present disclosure is not limited to the embodiments disclosed below and may be implemented in various forms. These embodiments are provided to make the disclosure thorough and to fully convey the scope of the invention to those skilled in the art, and the present disclosure is defined by the scope of the claims. Therefore, in some embodiments, well-known process steps, well-known device structures, and well-known technologies are not described in detail to prevent the present disclosure from being interpreted ambiguously. Throughout the specification, identical reference numerals refer to identical components.

Unless otherwise defined, all terms (including technical and scientific terms) used herein have the meanings commonly understood by those skilled in the art to which the present disclosure pertains. Terms generally defined in dictionaries should be interpreted as having meanings consistent with their standard definitions unless otherwise specified, and should not be overly interpreted.

Furthermore, throughout the specification, when an element is described as "comprising" another element, it means that additional elements may be included unless specifically stated otherwise, rather than excluding other elements.

Additionally, throughout the specification, the terms "above" or "on" are used to include both cases where a component is positioned directly on or above the target part, as well as cases where there are other components in between, without necessarily implying a position relative to gravity.

The terms "first," "second," etc., in this specification are used to distinguish components from each other, not to indicate any particular order or importance.

### <Composition for Organic Electroluminescent Device>

The composition for an organic electroluminescent device according to the present disclosure is a composition for forming an organic layer (e.g., an emission layer) of the organic electroluminescent device, and includes a first host represented by Chemical Formula 1 and a second host represented by Chemical Formula 2.

The first host represented by Chemical Formula 1 is a compound in which at least three carbazole moieties are directly bonded without a linker, and it is a P-type host with relatively strong hole characteristics. The second host represented by Chemical Formula 2 is an asymmetric compound including an azine moiety having a variety of substituents (e.g., R₃-containing rings, A) introduced thereinto, and a carbozole moiety, with a connection therebetween either by a direct bond or via a linker (L). This second host is an N-type host with relatively strong electron characteristics. With the first and second hosts employed in combination, the composition of the present disclosure can realize a high-efficiency and long-lifespan organic electroluminescent device.

Specifically, the first host is a novel P-type host composed of triscarbazole, which has stronger hole characteristics than conventional host materials, thereby maximizing the performance of N-type hosts, particularly the second host. Additionally, due to its superior hole stability compared to conventional P-type hosts, the first host can consistently maintain stable lifespan characteristics in the initial properties of the device. Therefore, the P-type host composed of at least three carbazole groups enhance the hole stability of the device itself, allowing for the fabrication of high-performance OLED devices.

Moreover, the first host may have at least 13, specifically at least 15, and more specifically at least 21 deuterium (D) atoms substituted into at least three carbazole groups. Due to the higher molecular mass and lower zero-point energy of deuterium compared to hydrogen (H), the dissociation of deuterium is relatively more difficult in reactions. The lower zero-point energy increases the bond dissociation energy, reducing reactivity, and thereby enhancing the stability of the deuterium-containing molecule. Consequently, the first host can achieve greater color purity in green emission, strengthen the molecular bond between carbon and hydrogen, and improve material stability, thereby significantly enhancing the lifespan characteristics of the device.

Furthermore, the second host is an asymmetric N-type host that includes an azine moiety (e.g., pyrimidine, triazine) and a carbazole moiety within the molecule thereof, with a connection therebetween either by a direct bone or via a linker (L). The combined employment of the N-type second host with strong electron characteristics and the P-type first host of Chemical Formula 1 with relatively strong hole characteristics provides the organic EL device with enhanced efficiency due to the rapid hole and electron transport thereof and with optimal performance due to the reinforced stability of the emission layer (EML).

Specifically, in the first host represented by Chemical Formula 1, a, d, and f are each an integer of 0 to 3, and b, c, and e are each an integer of 0 to 4. Here, given that a, b, c, d, e, and f are each 0, it is meant that none of the hydrogen atoms on the compound are substituted with deuterium (D). Given that a, d, and f are each an integer of 1 to 3 and b, c, and e are each an integer of 1 to 4, it is meant that one or more hydrogen atoms on the compound are substituted with deuterium (D). In this regard, there may be 13≤a+b+c+d+e+f≤21. According to an embodiment, the number of deuterium atoms (D) contained in the compound of Chemical Formula 1 may be at least 13, or specifically at least 21. Preferably, the compound of Chemical Formula 1 contains at least 21 deuterium atoms in which a = d = f = 3 and b = c = e = 4. This compound of Chemical Formula 1 can enhance the stability of the chemical structure through deuterium (D) substitution, enabling the simultaneous realization of characteristics such as low voltage, high efficiency, and long lifespan of the organic electroluminescent device.

The deuterium (D) may also be substituted with another substituent (R). When there are multiple substituents (R), they may be same or different and may each be selected from the group consisting of a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀. Specifically, the hydrogen of the benzene ring in the carbazole group with no deuterium atoms substituted therein may be substituted by an alkyl of C₁-C₄₀, an aryl of C₆-C₄₀, or a heteroaryl of 5 to 40 nuclear atoms.

In the first host represented by Chemical Formula 1, Ar₁ and Ar₂ may be introduced as substituents into the N atoms of the two carbazole moieties located at both terminal ends among the three carbazole moieties (Cz). Ar₁ and Ar₂, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀. Specifically, Ar₁ and Ar₂, which are same or different, may each be independently selected from the group consisting of an aryl of C₆-C₆₀ and a heteroaryl of 5 to 60 nuclear atoms. More specifically, Ar₁ and Ar₂ may each be independently an aryl group of C₆-C₄₀, wherein the aryl groups of Ar₁-Ar₂ may not or may each independently have at least one substituent selected from the group consisting of a deuterium atom (D), an aryl group of C₆-C₄₀, and a heteroaryl group of 5 to 40 nuclear atoms. When there are multiple substituents, they may be same or different. Here, the aryl groups of Ar₁-Ar₂ may not or may be partially substituted with at least one deuterium atom (D), or at least one deuterium (D) may partially substitute the aryl groups of Ar₁-Ar₂, but it may be excluded that all positions on the aryl groups of Ar₁-Ar₂ are substituted with a deuterium atom (D).

In particular, to confirm the deuteration substitution effect, the compound represented by Chemical Formula 1 preferably has a degree of deuteration of at least 67% or higher, without setting a specific upper limit.

In a specific embodiment, Ar₁ and Ar₂, which are same or different, may each be independently selected from the substituents S1 to S9, but with no limitations thereto: 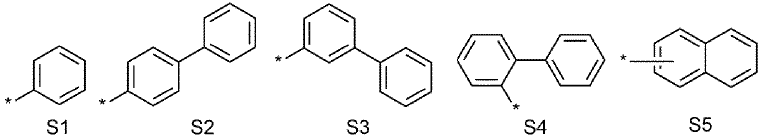 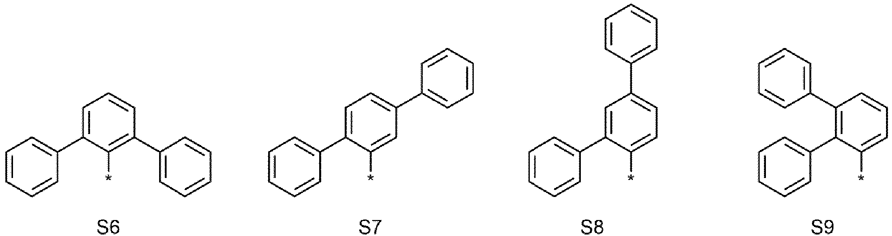 wherein, * represents a bonding site to Chemical Formula 1.

Depending on the types of Ar₁ and Ar₂, the first host represented by Chemical Formula 1 may be a compound represented by the following Chemical Formula 1A, but with no limitations thereto:

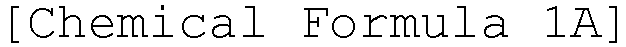

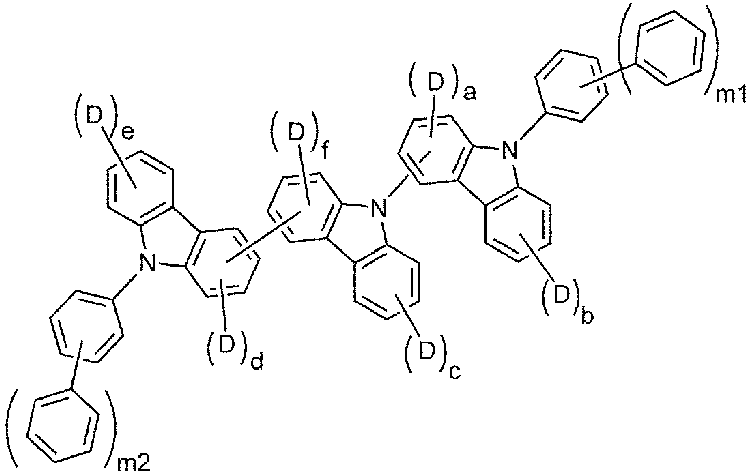

wherein,
a, b, c, d, e, f, Ar₁, and Ar₂ are each as defined in Chemical Formula 1, and
m1 and m2 are each 0 or 1.

In an embodiment of the present disclosure, the first host represented by Chemical Formula 1 may be specifically embodied as any one of Chemical Formulas 1a to 1d, depending on the bonding positions of the three carbazole groups:

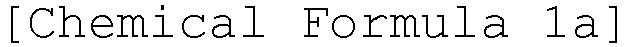

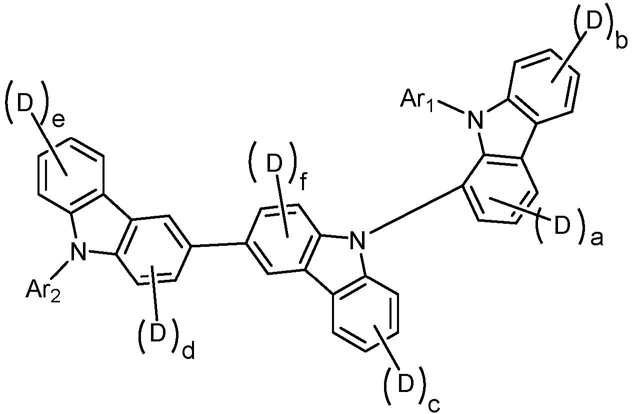

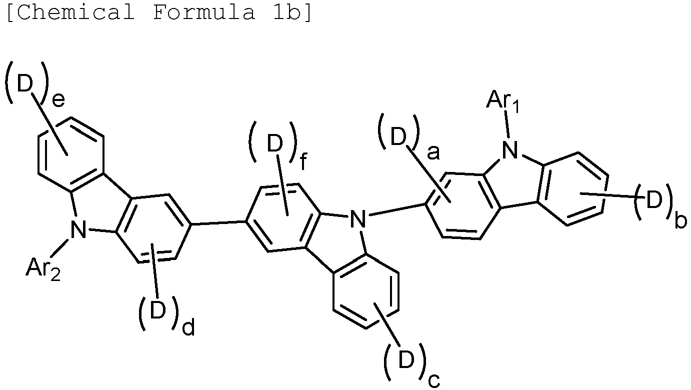

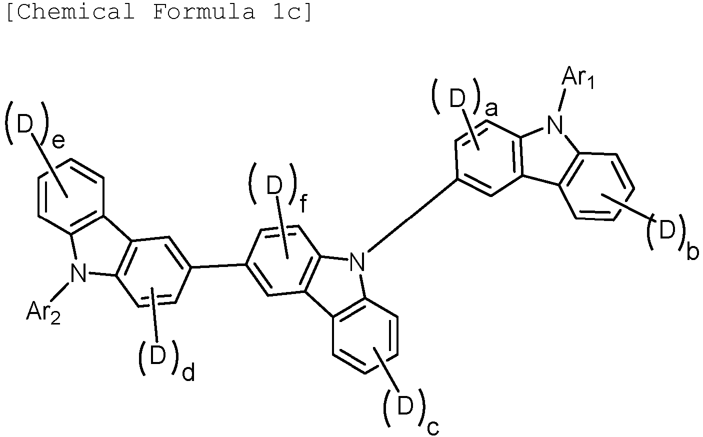

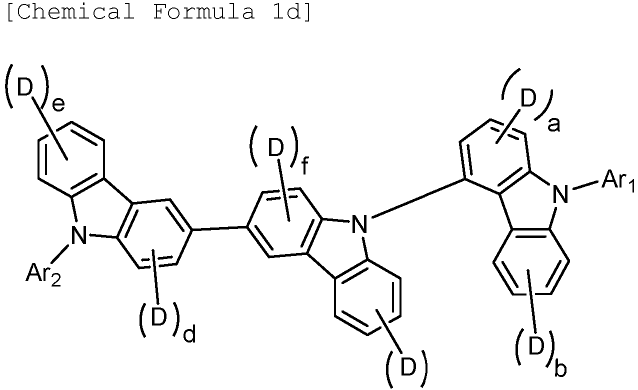

wherein,
a, b, c, d, e, f, Ar₁, and Ar₂ are as defined in Chemical Formula 1, and
m1 and m2 are each 0 or 1. The compounds represented by Chemical Formulas 1a to 1d may secure superior hole stability in terms of structure. More preferably, at least three carbazole moieties are bonded, and the compound may be one represented by Chemical Formula 1c, in which a bond is made at the active site, position 3, of the carbazole group.

The first host represented by Chemical Formula 1 according to the present disclosure, as described above, may be further specified as an exemplary compound, such as anyone of Compounds A-1 to D-4. However, the compound represented by Chemical Formula 1 of the present disclosure is not limited to the examples provided below:

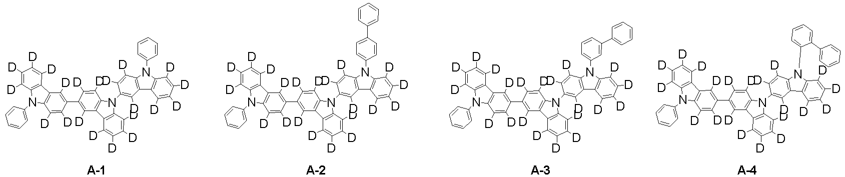

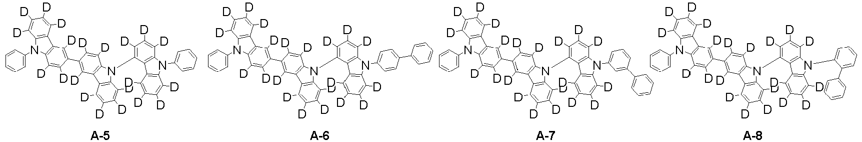

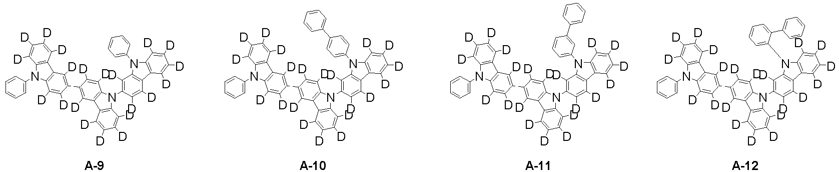

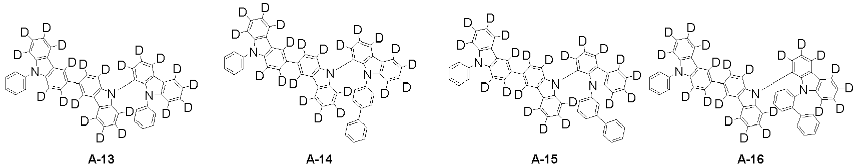

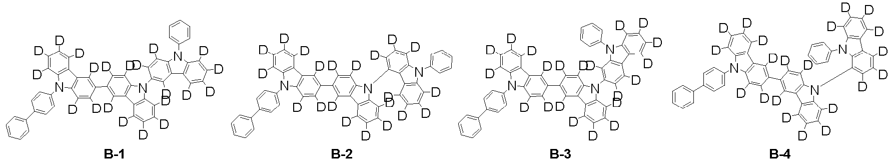

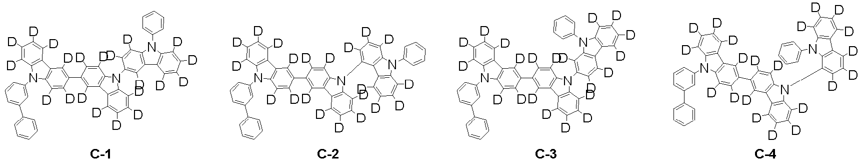

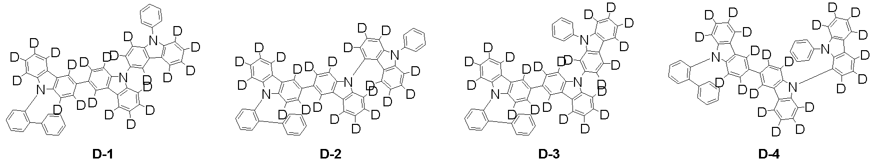

The second host represented by Chemical Formula 2 according to the present disclosure has an asymmetric structure that includes an azine moiety (e.g., a heterocycle containing X₁-X₃) and a carbazole moiety, with a connection therebetween either by directly bonding or via a linker (L).

In Chemical Formula 2, X₁ to X₃, which are same or different, may each be independently N or C(R₆), with a proviso that at least two of X₁ to X₃ are N. Such nitrogen-containing heterocycles (e.g., rings bearing X₁-X₃) include at least two nitrogen atoms in a monocyclic heteroaryl group (e.g., azine), exhibiting superior electron absorption properties, which is advantageous for electron injection and transport.

Here, R₆ may be selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀. Specifically, R₆ may be selected from the group consisting of a hydrogen atom, a deuterium atom (D), a halogen group, a cyano group, an alkyl group of C₁-C₄₀, an aryl group of C₆-C₆₀, and a heteroaryl group of 5 to 60 nuclear atoms.

Various substituents may be introduced into the heterocycle containing X₁ to X₃ in the second host. According to an embodiment, the substituent may be selected from the group consisting of an aryl group of C₆-C₆₀ and a heteroaryl group of 5 to 60 nuclear atoms. Specifically, one of the substituents introduced into the heterocycle containing X₁ to X₃ may be an aryl group (e.g., an R₃-containing ring), and another may be represented by either Chemical Formula 3 or 4:

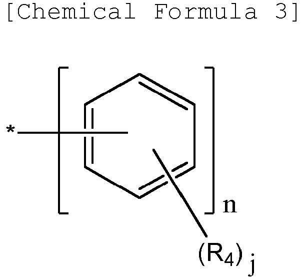

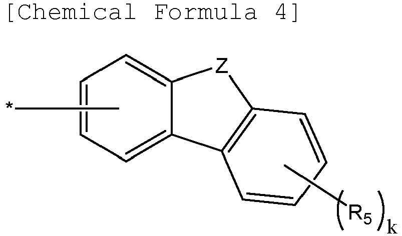

wherein,
n is an integer from 1 to 3, and
Z is selected from the group consisting of O, S, Se, and C(R₇) (R₈). Depending on Z, the dibenzo moiety may be a monovalent dibenzofuran group, a monovalent dibenzothiophene group, or a monovalent fluorene group. Additionally, the case where Z is a monovalent benzoselenophene group is also within the scope of the present disclosure.

The substituents R₃ to R₈ introduced into the heterocycle containing X₁ to X₃, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀, or may form a fused ring with an adjacent groups. Specifically, R₃ to R₈ may be independently selected from the group consisting of a hydrogen atom, a deuterium atom (D), a halogen atom, a cyano group, an alkyl group of C₁-C₄₀, an aryl group of C₆-C₆₀, and a heteroaryl group of 5 to 60 nuclear atoms. The number of substituents for R₃ to R₅ is not particularly limited, and for example, i, j, and k may each be independently an integer of 0 to 4. The fused ring may be selected from the group consisting of a fused aliphatic ring of C₃-C₆₀ (specifically, a fused aliphatic ring of C₃-C₃₀), a fused aromatic ring of C₆-C₆₀ (specifically, a fused aromatic ring of C₆-C₃₀), a 5- to 60-membered fused heteroaromatic ring (specifically, a 5- to 30-membered, fused heteroaromatic ring), a spiro ring of C₃-C₆₀, or a combination thereof.

Various substituents R₁ and R₂ may be introduced into both the benzene rings of the carbazole group connected to the heterocycle containing X₁ to X₃.

R₁ and R₂, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀, or may form a fused ring with an adjacent groups (e.g., adjacent R₁, R₂, one phenyl ring in the carbazole moiety). Specifically, R₁ and R₂ may be independently selected from the group consisting of a hydrogen atom, a deuterium atom (D), a halogen group, a cyano group, an alkyl group of C₁-C₄₀, an aryl group of C₆-C₆₀, and a heteroaryl group of 5 to 60 nuclear atoms. The number of substituents for R₁ and R₂ is not particularly limited, and for example, g and h may each be independently an integer from 0 to 4. More specifically, R₁ may be an aryl group of C₆-C₁₈, and g is preferably 1. The fused ring may be selected from the group consisting of a fused aliphatic ring of C₃-C₆₀ (specifically, a fused aliphatic ring of C₃-C₃₀), a fused aromatic ring of C₆-C₆₀ (specifically, a fused aromatic ring of C₆-C₃₀), a fused heteroaromatic ring of 5 to 60 members (specifically, a 5- to 30-membered, fused heteroaromatic ring), a spiro ring of C₃-C₆₀, or a combination thereof, and more specifically may be a fused aromatic ring of C₆-C₃₀.

The second host according to the present disclosure has a primary asymmetric structure that includes an azine moiety (e.g., a heterocycle containing X₁ to X₃) and a carbazole moiety within the molecule thereof, with a connection therebetween either by directly bonding or via a linker (L), and a secondary asymmetric structure where an aryl radical (e.g., an R₃-containing ring) and a dibenzo moiety represented by Chemical Formula 4 are bonded around the azine moiety. If a dibenzo moiety represented by Chemical Formula 4 is introduced into the second host, the dibenzo moiety (e.g., dibenzofuranyl, dibenzothiophenyl) may be excluded from the heteroaryl group of R₁ and/or R₂.

The heterocycle containing X₁ to X₃ and the carbazole group may be connected either directly or via a linker (L). This linker may be a conventional divalent group known in the art, for example, it may be selected from the group consisting of an arylene group of C₆-C₆₀ and a substituted or unsubstituted heteroarylene group of 5 to 60 nuclear atoms. Specifically, L may be an arylene of C₆-C₂₄ or a substituted or unsubstituted heteroarylene group of 5 to 18 nuclear atoms, and more specifically, may be phenylene, biphenylene, or terphenylene.

In an embodiment, L may be a single bond or a linker selected from the following structural formulas: 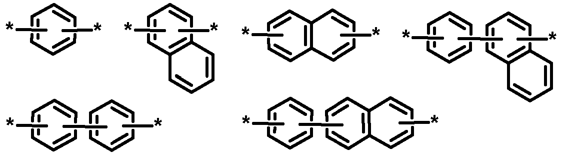 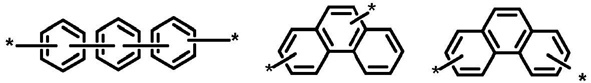 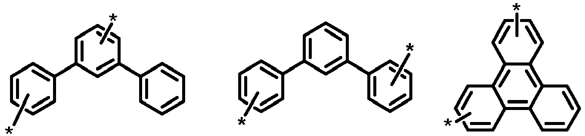 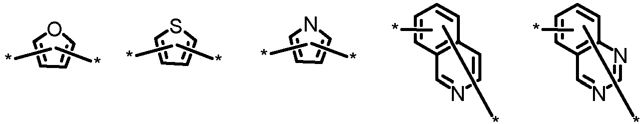 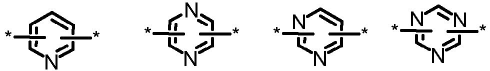 wherein,
* indicates a bonding site to Chemical Formula 2. Additionally, although not shown in the above structural formulas, at least one substituent (e.g., as defined in R₁-R₆) known in the art may be introduced.

In the aforementioned Chemical Formula 2, the arylene group and heteroarylene group of L and the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group and fused ring of Ar₁ to Ar₂ and R₁ to R₈ are each independently substituted with one or more substituents selected from the group consisting of a deuterium atom (D), a halogen group, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an aryl phosphine oxide group of C₆-C₆₀, an aryl phosphine oxide group of C₆-C₆₀, and an arylamine group of C₆-C₆₀, and when the substituents are plural in number, they may be identical or different from each other.

In an embodiment of the present disclosure, the second host represented by Chemical Formula 2 may be specifically embodied as either Chemical Formula 5 or Chemical Formula 6, depending on the type of substituent introduced into the heterocycle containing X₁ to X₃ (e.g., azine moiety): 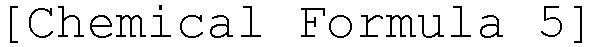 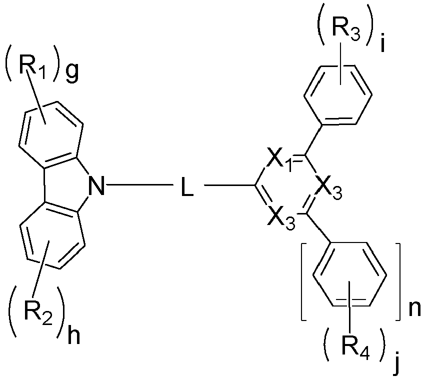 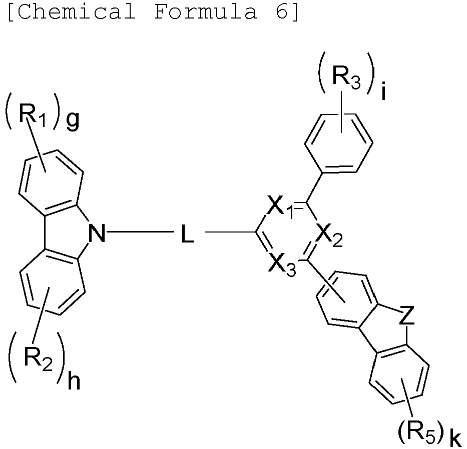 wherein,
X₁- X₃, Z, L, R₁ to R₅, g, h, i, j, k, and n are each as defined in Chemical Formula 2.

In another embodiment of the present disclosure, the second host represented by Chemical Formula 2 may be further specified as any one of Chemical Formulas 7 to 10, depending on the bonding position of the substituent (e.g., R₁) introduced into the carbazole moiety (Cz): 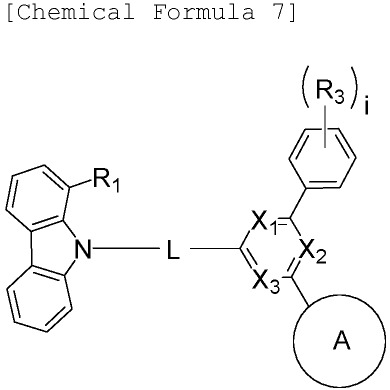 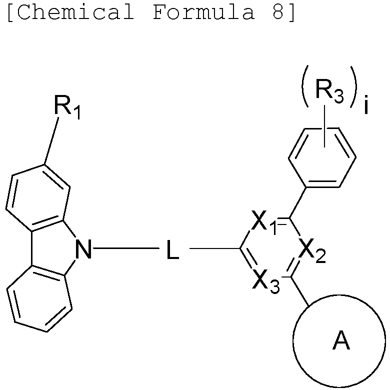 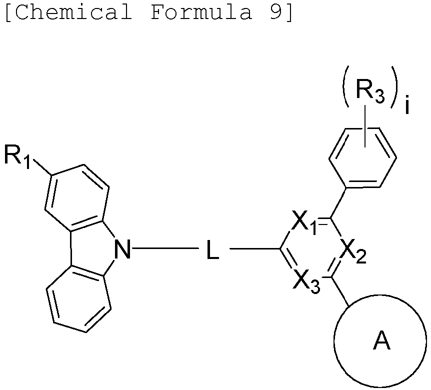 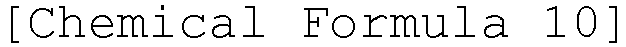 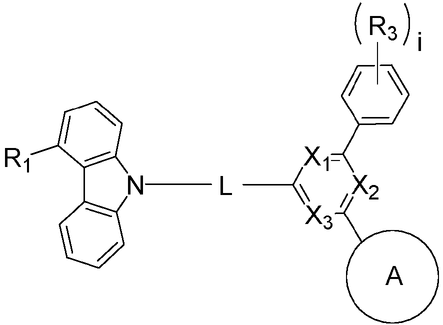 wherein,
X₁ to X₃, A, L, R₁, R₃, and i are each as defined in Chemical Formula 2.

In an embodiment, R₁ may be a substituent selected from the following structural formulas: 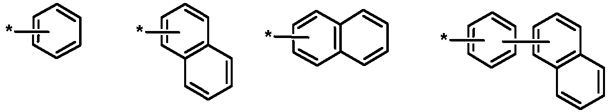 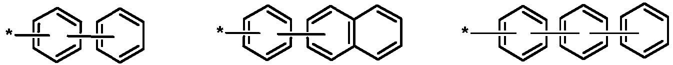 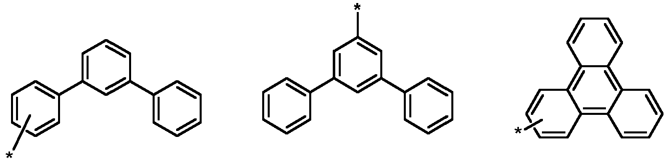 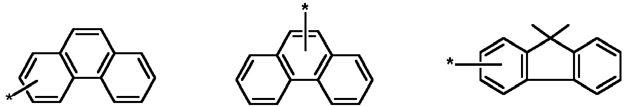 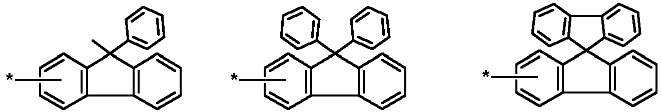 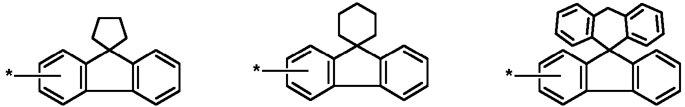 where, * indicates a bonding site to Chemical Formula 2.

In another embodiment of the present disclosure, the second host represented by Chemical Formula 2 may be further specified as any one of Chemical Formulas 11 to 17, depending on the type of heterocycle containing X₁ to X₃ (e.g., azine moiety): 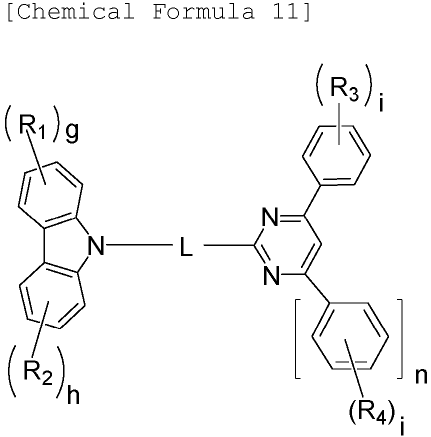 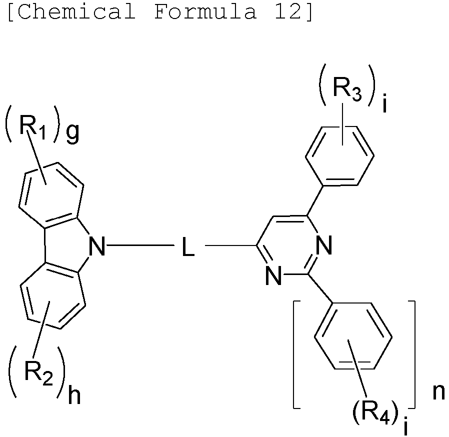 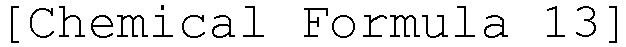 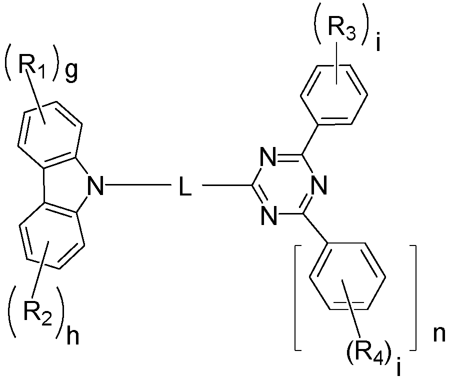 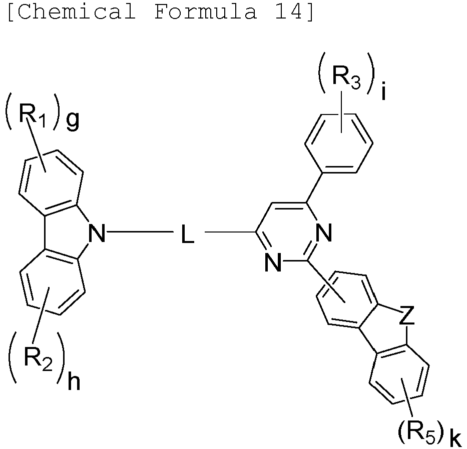 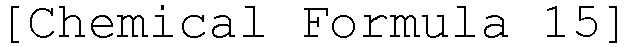 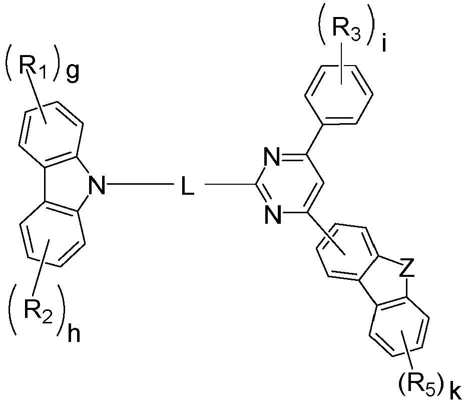 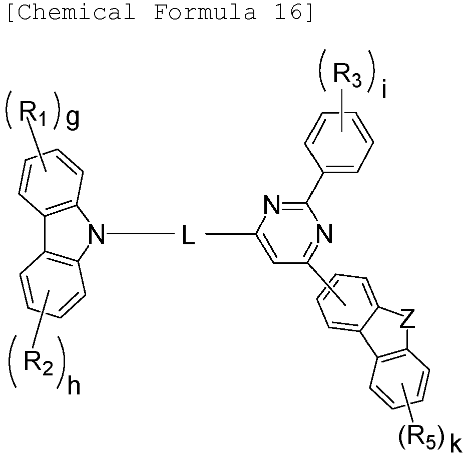 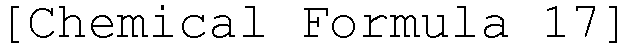 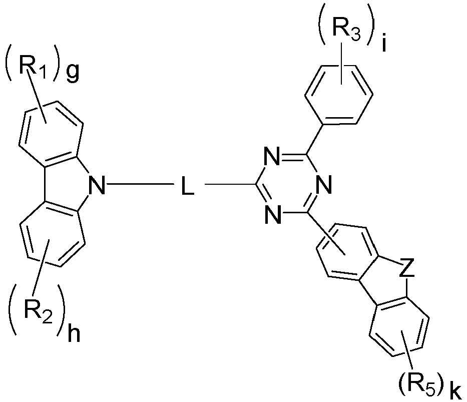 wherein,
Z, L, R₁ to R₅, g, h, i, j, k, and n are each as defined in Chemical Formula 2.

The second host represented by Chemical Formula 2 according to the present disclosure, as described above, can be further specified as an exemplary compound, such as any one of Compounds E-1 to E-10, but with no limitations thereto:

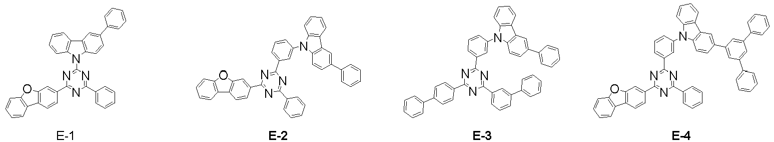

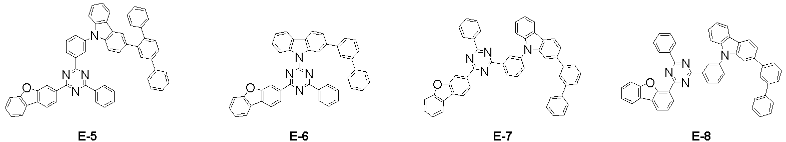

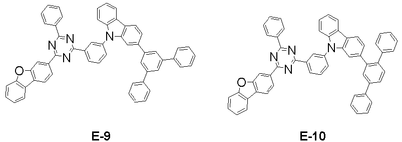

As used herein, the term "alkyl" refers to a monovalent substituent derived from a linear or branched saturated hydrocarbon having 1 to 40 carbon atoms. Examples include methyl, ethyl, propyl, isobutyl, sec-butyl, pentyl, isoamyl, hexyl, and the like, but are not limited thereto.

As used herein, the term "alkenyl" refers to a monovalent substituent derived from a linear or branched unsaturated hydrocarbon of 2 to 40 carbon atoms and containing at least one carbon-carbon double bond. Examples include vinyl, allyl, isopropenyl, 2-butenyl, and the like, but are not limited thereto.

As used herein, the term, "alkynyl" refers to a monovalent substituent derived from a linear or branched unsaturated hydrocarbon of 2 to 40 carbon atoms and containing at least one carbon-carbon triple bond. Examples include ethynyl, 2-propynyl, and the like, but are not limited thereto.

As used herein, the term "cycloalkyl" refers to a monovalent substituent derived from a monocyclic or polycyclic non-aromatic hydrocarbon of 3 to 40 carbon atoms. Examples of cycloalkyl include cyclopropyl, cyclopentyl, cyclohexyl, norbornyl, adamantyl, and the like, but are not limited thereto.

As used herein, the term "heterocycloalkyl" refers to a monovalent substituent derived from a non-aromatic hydrocarbon of 3 to 40 nuclear atoms, in which one or more carbon atoms, preferably 1 to 3 carbon atoms, in the ring are replaced by heteroatoms such as N, O, S, or Se. Examples of heterocycloalkyl include morpholinyl and piperazinyl, but are not limited thereto.

As used herein, the term "aryl" refers to a monovalent substituent derived from an aromatic hydrocarbon of 6 to 60 carbon atoms, either as a single ring or as a combination of two or more rings. The combination may include pendant rings or fused rings. Examples of aryl include phenyl, naphthyl, phenanthryl, and anthryl, but are not limited thereto.

As used herein, the term "heteroaryl" refers to a monovalent substituent derived from a monoheterocyclic or polyheterocyclic aromatic hydrocarbon of 5 to 60 ring atoms, where one or more carbon atoms, preferably 1 to 3 carbon atoms, in the ring are replaced by heteroatoms such as N, O, S, or Se. It may include simple pendant or fused rings and may also include fused forms with aryl groups. Examples of such heteroaryl include pyridyl, pyrazinyl, pyrimidinyl, pyridazinyl, triazinyl (six-membered monocyclic rings), phenoxathienyl, indolizinyl, indolyl, purinyl, quinolyl, benzothiazolyl, carbazolyl, dibenzofuranyl, dibenzothiophenyl (polycyclic rings), 2-furanyl, N-imidazolyl, 2-isoxazolyl, 2-pyridyl, and 2-pyrimidinyl, but are not limited thereto.

As used herein, the term "alkoxy" refers to a monovalent substituent represented by R'O-, where R' refers to an alkyl group of 1 to 40 carbon atoms, which may have a linear, branched, or cyclic structure. Examples of alkoxy include methoxy, ethoxy, n-propoxy, 1-propoxy, t-butoxy, n-butoxy, and pentoxy, but are not limited thereto.

As used herein, the term "aryloxy" refers to a monovalent substituent represented by RO-, where R refers to an aryl of 5 to 40 carbon atoms. Examples of such aryloxy include phenoxy, naphthoxy, diphenoxy, and the like, but are not limited thereto.

As used herein, the term "alkylsilyl" refers to a silyl substituted with an alkyl of 1 to 40 carbon atoms, and includes mono-, di-, and trialkylsilyl groups. In addition, "arylsilyl" refers to a silyl substituted with an aryl of 5 to 60 carbon atoms, and includes mono-, di-, and triarylsilyl, as well as polyarylsilyl.

As used herein, the term "alkylboron" refers to a boron group substituted with an alkyl group of 1 to 40 carbon atoms, and "arylboron" refers to a boron substituted with an aryl of 6 to 60 carbon atoms.

As used herein, the term "alkylphosphinyl" refers to a phosphine substituted with an alkyl of 1 to 40 carbon atoms, and includes mono- as well as dialkylphosphinyl. Likewise, "arylphosphinyl" refers to a phosphine substituted with a monoaryl or diaryl of 6 to 60 carbon atoms, and includes mono- as well as diarylphosphinyl groups.

As used herein, the term "aryl amine" refers to an amine substituted with an aryl of 6 to 60 carbon atoms, and includes mono- as well as diaryl amines.

As used herein, the term "heteroaryl amine" refers to an amine substituted with a heteroaryl of 5 to 60 nuclear atoms, and includes mono- as well as di-heteroaryl amines.

As used herein, " (aryl) (heteroaryl)amine" refers to an amine substituted with an aryl of 6 to 60 carbon atoms and a heteroaryl group of 5 to 60 ring atoms.

As used herein, the term "fused ring" refers to a fused aliphatic ring of 3 to 40 carbon atoms, a fused aromatic ring of 6 to 60 carbon atoms, a fused heteroaliphatic ring of 3 to 60 ring atoms, a fused heteroaromatic ring of 5 to 60 ring atoms, a spiro ring of 3 to 60 carbon atoms, or a combination thereof.

In the aforementioned composition for organic electroluminescent devices, the first host and the second host may be included at a weight ratio ranging from 1:99 to 99:1, more specifically from 20:80 to 80:20, and preferably from 40:60 to 70:30. In this regard, the bipolar characteristics can be more effectively realized, improving both efficiency and lifespan. Particularly, when combining a p-type first host specialized in donor characteristics and an n-type host material according to the present disclosure, it is possible to achieve equal or better effects even when using a smaller amount compared to conventional p-type hosts.

The composition of the present disclosure may further include a phosphorescent dopant. The phosphorescent dopant is a substance that causes luminescence when mixed in trace amounts with the first and second hosts and is not particularly limited as long as it is known in the industry. Non-limiting examples include metal complex compounds containing iridium (Ir) or platinum (Pt). These dopants can cause luminescence through multiple excitations that excite beyond the triplet state.

The dopants may be classified into red dopants, green dopants, and blue dopants, and conventionally known red, green, and blue dopants in the technical field may be used without particular limitation.

Specifically, non-limiting examples of red dopants include PtOEP (Pt(II) octaethylporphyrin), Ir(piq)₃ (tris(2-phenylisoquinoline)iridium), Btp2Ir(acac) (bis(2-(2'-benzothienyl)-pyridinato-N,C₃')iridium(acetylacetonate)), or mixtures of two or more thereof.

Additionally, non-limiting examples of green dopants include Ir(ppy)₃(tris(2-phenylpyridine)iridium), Ir(ppy)₂(acac)(bis(2-phenylpyridine) (acetylacetonato)iridium(III)), Ir(mppy)₃ (tris(2-(4-tolyl)phenylpyridine)iridium), or mixtures of two or more thereof.

Furthermore, non-limiting examples of blue dopants include F2Irpic (Bis[3,5-difluoro-2-(2-pyridyl)phenyl]iridium(III)), (F₂ppy)₂Ir(tmd), Ir(dfppz)_{3,} or mixtures of two or more thereof.

The content of the dopant is not particularly limited and may range from approximately 0 to 10% by weight, based on the total amount of the composition described above. More specifically, it may range from about 0.1 to 10% by weight, and even more specifically from about 1 to 30% by weight.

### <Organic Electroluminescent Device >

An organic electroluminescent device according to an embodiment of the present disclosure includes: an anode; a cathode; and at least one organic layer interposed between the anode and the cathode, wherein the at least one organic layer contains the composition described above. In an embodiment, the at least one organic layer may include an emission layer, and the composition may be included as a host in the emission layer. With the structure, the organic electroluminescent device of the present disclosure exhibits not only low driving voltage, high efficiency, and long lifespan characteristics but also excellent phosphorescent luminescent properties.

Below, a preferred embodiment of the organic electroluminescent device according to the present disclosure will be described with reference to the accompanying drawings. However, it should be understood that the practices of the present disclosure may be modified in various ways, and the scope of the present disclosure is not limited to the embodiments described below. To avoid redundancy, descriptions of the components explained in the aforementioned composition for organic electroluminescent devices will be omitted.

FIG. 1 is a schematic cross-sectional view illustrating the structure of an organic electroluminescent device according to an embodiment of the present disclosure.

Referring to FIG. 1, an organic electroluminescent device according to one embodiment of the present disclosure includes: an anode (100) disposed on a substrate (not shown); a cathode (200) disposed facing the anode; and at least one organic layer (300) interposed between the anode (100) and cathode (200), wherein the at least one organic layer (300) may include a hole transport region (310), an emission layer (320), and an electron transport region (330). In this regard, the emission layer (320) may contain the aforementioned composition as a host. Optionally, the organic electroluminescent device of the present disclosure may further include a capping layer (not shown) disposed on the cathode (200).

The following provides a detailed description of each component of the organic electroluminescent device according to the present disclosure.

### (1) Anode

In the organic electroluminescent device of the present disclosure, the anode (100) is primarily disposed on a substrate and is electrically connected to a driving thin-film transistor to receive a driving current from the driving thin-film transistor. Since the anode (100) is formed from a material with a relatively high work function, it injects holes into the organic layer (300), specifically into the hole transport region (310) [e.g., hole injection layer (311)].

The material used to form the anode is not particularly limited and may include conventional materials known in the industry. Examples include metals such as vanadium, chromium, copper, zinc, and gold; alloys thereof; metal oxides such as zinc oxide, indium oxide, indium tin oxide (ITO), and indium zinc oxide (IZO); combinations of metals and oxides such as ZnO:Al, SnO₂:Sb, etc.; conductive polymers such as polythiophene, poly(3-methylthiophene), poly[3,4-(ethylene-1,2-dioxy)thiophene] (PEDT), polypyrrole, and polyaniline; and carbon black, but are not limited thereto.

The method for manufacturing the anode is not particularly limited and so long as it is known in the art, any manufacturing method may be available. For example, the anode material may be coated on the substrate using known thin-film formation techniques such as sputtering, ion plating, vacuum deposition, or spin coating.

The substrate, which supports the organic electroluminescent device, may be plate-shaped and can be made from materials such as silicon wafers, quartz, glass plates, metal plates, plastic films, or sheets, but with no limitations thereto.

### (2) Cathode

In the organic electroluminescent device of the present disclosure, the cathode (200) is an electrode disposed facing the anode and specifically positioned on the electron transport region (330). Since the cathode (200) is made from a material with a relatively low work function, it injects electrons into the adjacent organic layer, specifically into the electron transport region (330) [e.g., electron injection layer (332)].

The material used to form the cathode is not particularly limited and may include conventional materials known in the industry. Examples include: metals such as magnesium, calcium, sodium, potassium, titanium, indium, yttrium, lithium, gadolinium, aluminum, silver, tin, and lead; alloys thereof; and multilayer structures such as LiF/Al and LiO₂/Al, but with no limitations thereto.

The method for manufacturing the cathode is not particularly limited and, like the anode, may be produced using conventional methods known in the industry. For example, the cathode material may be coated on the at least one organic layer (300), specifically on the electron transport region, such as the electron injection layer (332), using the aforementioned thin-film formation techniques.

### (3) Organic Layer

In the organic electroluminescent device of the present disclosure, at least one organic layer (300) is disposed between the anode (100) and the cathode (200) and includes a hole transport region (310), an emission layer (320), and an electron transport region (330).

According to an embodiment, as shown in FIG. 1, the at least one organic layer (300) may include a hole injection layer (311), a hole transport layer (312), an emission layer (320), an electron transport layer (331), and an electron injection layer (332) sequentially disposed on the anode (100).

The following provides a detailed explanation of each organic layer.

### 1) Hole Transport Region

In the organic electroluminescent device (100) of the present disclosure, the hole transport region (310) is part of the organic layer (300) disposed on the anode (100) and serves to transport holes injected from the anode (100) to the adjacent emission layer (320).

The hole transport region (310) may include at least one selected from the group consisting of a hole injection layer (311) and a hole transport layer (312). Given the characteristics of the organic electroluminescent device, it is preferable that both the hole injection layer (311) and the hole transport layer (312) are included. For example, as shown in FIG. 1, the hole transport region (310) may include a hole injection layer (311) and a hole transport layer (312) sequentially stacked on the anode (100).

The material constituting the hole injection layer (311) and hole transport layer (312) is not particularly limited, as long as it has a low hole injection barrier and high hole mobility. Any conventional material used for hole injection and transport layers in the industry may be used without limitation. The materials for the hole injection layer (311) and the hole transport layer (312) may be same or different.

Specifically, the hole injection layer (311) includes known hole injection materials in the art. Non-limiting examples of such hole injection materials include: phthalocyanine compounds such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris(3-methylphenylphenylamino) triphenylamine), TDATA (4,4'4"-Tris(N,N-diphenylamino)triphenylamine), 2TNATA (4,4',4"-tris{N-(2-naphthyl)-N-phenylamino}-triphenylamine), PEDOT/PSS (Poly(3,4-ethylenedioxythiophene)/Poly(4-styrenesulfonate)), PANI/DBSA (Polyaniline/Dodecylbenzenesulfonic acid), PANI/CSA (Polyaniline/Camphor sulfonic acid), PANI/PSS (Polyaniline/Poly(4-styrenesulfonate)), and the like. These may be used alone or in combination of two or more.

The hole transport layer (312) includes known hole transport materials in the art. Non-limiting examples of such hole transport materials include carbazole derivatives such as N-phenylcarbazole and polyvinylcarbazole; fluorene derivatives; amine derivatives; triphenylamine derivatives such as TPD (N,N'-bis(3-methylphenyl)-N,N'-diphenyl-[1,1-biphenyl]-4,4'-diamine) and TCTA (4,4',4"-tris(N-carbazolyl)triphenylamine); NPB (N,N'-di(1-naphthyl)-N,N'-diphenylbenzidine), TAPC (4,4'-Cyclohexylidene bis[N,N-bis(4-methylphenyl)benzenamine]), and the like. These may be used alone or in combination of two or more.

The hole transport region (310) may be manufactured by conventional methods known in the art. For example, use may be made of vacuum deposition, spin coating, casting, Langmuir-Blodgett (LB) method, inkjet printing, laser printing, laser-induced thermal imaging (LITI), among others, but with no limitations thereto.

### 2) Emission Layer

In the organic electroluminescent device of the present disclosure, the emission layer (320), which is part of the organic layer (300) disposed between the anode (100) and cathode (200), is specifically located on the hole transport region (320). As shown in FIG. 1, the emission layer (320) may be positioned on the hole transport layer (312).

This emission layer (320) is where holes and electrons injected from the anode and cathode, respectively, combine to form excitons. The color of light emitted by the organic electroluminescent device may vary depending on the materials that form the emission layer (320).

The emission layer (320) of the present disclosure includes a composition containing the first host represented by Chemical Formula 1 and the second host represented by Chemical Formula 2, as described above. The composition may optionally include a phosphorescent dopant. By including the aforementioned composition as the material for the emission layer (320), the organic electroluminescent device of the present disclosure can achieve low driving voltage, high efficiency, and long lifespan, while also demonstrating excellent phosphorescent emission characteristics.

The emission layer (320) of the present disclosure may be a red emission layer containing red phosphorescent materials, a green emission layer containing green phosphorescent materials, or a blue emission layer containing blue phosphorescent materials. According to an embodiment, it may be an emission layer containing green phosphorescent materials.

The aforementioned emission layer (320) may be composed of a single layer of one material, a single layer of multiple different materials, or two or more layers of different materials. When the emission layer (320) consists of multiple layers, the organic electroluminescent device can emit various colors of light. Specifically, the present disclosure provides an organic electroluminescent device with multiple emission layers composed of different materials in series, allowing the device to display mixed colors. Additionally, given multiple emission layers, an increased driving voltage is required, but the current in the device remains constant, thereby improving the emission efficiency proportionally to the number of emission layers.

Although not shown in the drawings, the organic electroluminescent device of the present disclosure may include multiple emission stacks (not shown), each containing at least one emission layer.

The multiple emission layers included in the emission stacks may emit light of different colors or the same color. That is, the emission color may vary depending on the materials forming the emission layer. By way of example, the multiple emission stacks may include materials that emit blue, green, red, yellow, or white light, and they may be formed using phosphorescent or fluorescent materials. In this regard, the colors emitted by each emission layer may be complementary to each other. Additionally, a color combination capable of emitting white light may be selected. Each emission layer may include phosphorescent or fluorescent dopants corresponding to the selected color.

Although not shown in the drawings, the organic electroluminescent device of the present disclosure may further include a charge generation layer (CGL) (not shown) disposed between and connecting adjacent emission stacks.

In an organic electroluminescent device that includes multiple emission stacks, the charge generation layer (CGL) is a layer separating adjacent emission stacks without directly contacting the electrodes (e.g., anode, cathode). The charge generation layer, arranged between two adjacent emission stacks, serves as a cathode by generating and supplying electrons to one emission stack, and as an anode by generating and supplying holes to another emission stack. So long as it is known in the art, any charge generation layer material may be used for the charge generation layer, without limitation. In addition, common n-type and/or p-type materials known in the field can be doped to a material for use in the charge generation layer.

The aforementioned emission layer (320) can be manufactured by conventional methods known in the art. Examples include vacuum deposition, spin coating, casting, Langmuir-Blodgett (LB) method, inkjet printing, laser printing, and laser-induced thermal imaging (LITI), but are not limited thereto. In an embodiment, the emission layer may be formed by co-deposition of the first host represented by Chemical Formula 1 and the second host represented by Chemical Formula 2. At this time, a dopant may also be co-deposited.

### 3) Electron Transport Region

In the organic electroluminescent device according to the present disclosure, the electron transport region (330) is an organic layer placed on the emission layer (320) that transports electrons injected from the cathode (200) to the emission layer (320).

The electron transport region (330) may include at least one layer selected from the group consisting of an electron transport layer (331) and an electron injection layer (332).

For example, as shown in FIG. 1, the electron transport region (330) may include an electron transport layer (331) and an electron injection layer (332) sequentially stacked on the emission layer (320).

In the electron transport region (330) of the present disclosure, any electron transport material that facilitates electron injection and has high electron mobility may be used in the electron transport layer (331), without limitation. Non-limiting examples of such electron transport materials include oxazole-based compounds, isooxazole-based compounds, triazole-based compounds, isothiazole-based compounds, oxadiazole-based compounds, thiadiazole-based compounds, perylene-based compounds, aluminum complexes [e.g., Alq₃ (tris(8-quinolinolato)aluminum), BAlq, SAlq, Alph₃, Almq₃], gallium complexes (e.g., Gaq'2OPiv, Gaq'2OAc, 2(Gaq'2)), and the like. These materials may be used alone or in combination with two or more types.

Additionally, the electron injection layer (332) may employ any electron injection material that facilitates electron injection and has high electron mobility, without limitations. Non-limiting examples of such electron injection materials include LiF, Li₂O, BaO, NaCl, CsF; lanthanide metals such as Yb; or halogenated metals such as RbCl, RbI. These materials may be used alone or in combination with two or more types.

The electron transport region (330), specifically the electron transport layer (331) and/or the electron injection layer (332), may also be co-deposited with an n-type dopant to facilitate electron injection from the cathode (200). In this regard, the n-type dopant may be any alkali metal complex known in the field, without limitation. Non-limiting examples include alkali metals, alkaline earth metals, or rare earth metals.

The electron transport region (330) may be manufactured by conventional methods known in the art. For example, use may be made of vacuum deposition, spin coating, casting, Langmuir-Blodgett (LB) method, inkjet printing, laser printing, laser-induced thermal imaging (LITI), and the like, but with no limitations thereto.

### 4) Emission Auxiliary Layer

The organic electroluminescent device of the present disclosure may further include, an emission auxiliary layer, although not shown, disposed between the hole transport region (310) and the emission layer (320).

The emission auxiliary layer serves to transport holes from the hole transport region (310) to the emission layer (320), or to block the movement of electrons and/or excitons while adjusting the thickness of the organic layer (300). Specifically, the emission auxiliary layer has a high LUMO value, which prevents electrons from moving to the hole transport layer (312), and a high triplet energy, which prevents the excitons in the emission layer (320) from diffusing into the hole transport layer (312).

This emission auxiliary layer may include a hole transport material and may be made of the same material as the hole transport region. Additionally, the emission auxiliary layer of red, green, and blue organic electroluminescent elements may be made of the same material.

No particular limitations are imparted to materials of the emission auxiliary layer. Examples include carbazole derivatives and arylamine derivatives. Specifically, examples of the emission auxiliary layer material include NPD (N,N-dinaphthyl-N,N'-diphenyl benzidine), TPD (N,N'-bis-(3-methylphenyl)-N,N'-bis(phenyl)-benzidine), s-TAD, and MTDATA (4,4',4"-Tris(N-3-methylphenyl-Nphenyl-amino)-triphenylamine), but are not limited thereto. These materials can be used alone or in combination with two or more types.

Additionally, the emission auxiliary layer may further include a p-type dopant in addition to the aforementioned materials. The p-type dopant that can be used in the present disclosure is not particularly limited, as long as it is a known p-type dopant commonly used in the field. The content of the p-type dopant can be appropriately adjusted within the known range in the field, for example, about 0.5 to 50 parts by weight based on 100 parts by weight of the hole transport material.

The emission auxiliary layer may be formed by known methods in the field, such as vacuum deposition, spin coating, casting, Langmuir-Blodgett (LB) method, inkjet printing, laser printing, laser-induced thermal imaging (LITI), but with no limitations thereto.

### 5) Hole Blocking Layer

The organic electroluminescent device (100) of the present disclosure may further include a hole blocking layer, although not shown, disposed between the emission layer (320) and the electron transport region (330).

The hole blocking layer (333) prevents excitons or holes generated in the emission layer (320) from diffusing (moving) into the electron transport layer (331), thus improving the lifespan of the organic electroluminescent device.

So long as it is known in the art, any material with typical electron transport properties may be used for the hole blocking layer. Examples include BCP (2,9-dimethyl-4,7-diphenyl-1,10-phenanthroline), bis(2-methyl-8-quinolinolato) (4-phenylphenolate)aluminum(III) (BAlq), etc.

The hole blocking layer can be formed by known methods in the field, such as vacuum deposition, spin coating, casting, Langmuir-Blodgett (LB) method, inkjet printing, laser printing, laser-induced thermal imaging (LITI), but with no limitations thereto.

### (4) Capping Layer

Optionally, the organic electroluminescent device (100) of the present disclosure may further include a capping layer (not shown) disposed on the cathode (200).

The capping layer serves to protect the organic electroluminescent device while also facilitating the efficient emission of light generated in the organic layer to the outside.

The capping layer may include one or more selected from the group consisting of tris-8-hydroxyquinoline aluminum (Alq₃), ZnSe, 2,5-bis(6'-(2',2"-bipyridyl))-1,1-dimethyl-3,4-diphenylsilole, 4'-bis[N-(1-naphthyl)-N-phenyl-amino] biphenyl (α-NPD), N,N'-diphenyl-N,N'-bis(3-methylphenyl)-1,1'-biphenyl-4,4'-diamine (TPD), and 1,1'-bis(di-4-tolylaminophenyl) cyclohexane (TAPC). These materials are generally more cost-effective compared to materials used in other layers of the organic electroluminescent device.

The capping layer may be a single layer or may include two or more layers with different refractive indices to allow for a gradual change in refractive index as light passes through these layers.

The capping layer may be manufactured using known methods in the field, such as vacuum deposition, spin coating, casting, Langmuir-Blodgett (LB) method, or the like.

The organic electroluminescent device of the present disclosure features a structure where the anode (100), organic layer (300), and cathode (200) are sequentially stacked. In some cases, the device may further include an insulating layer (not shown) or an adhesive layer (not shown) disposed between the anode (100) and the organic layer (300) or between the cathode (200) and the organic layer (300). The organic electroluminescent device of the present disclosure may offer excellent lifetime characteristics by maintaining maximum luminous efficiency while extending the half-life time of the initial brightness during voltage and current application.

The organic electroluminescent device of the present disclosure can be fabricated by methods known in the field. For example, after vacuum depositing the anode material on a substrate, the materials for the hole transport region, emission layer, electron transport region, and cathode can be sequentially vacuum deposited on the anode to manufacture the organic electroluminescent device.

Below, a better understanding of the present disclosure may be obtained through the following examples, which are set forth to illustrate, but are not to be construed to limit, the present disclosure.

### [SYNTHESIS EXAMPLES: First Host]

### <Preparation Example 1-1> Synthesis of Cz-D1

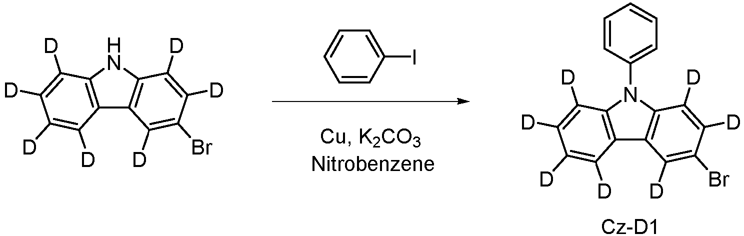

Under a nitrogen atmosphere, a mixture of 3-bromo-9H-carbazole-1,2,4,5,6,7,8-d7 (134.3 g, 530.6 mmol), iodobenzene (130.0 g, 636.7 mmol), Cu (16.8 g, 265.3 mmol), K₂CO₃ (146.7 g, 1,061.3 mmol), and toluene (1000 ml) was stirred at 110°C for 12 hours.

After completion of the reaction, the reaction mixture was subjected to extraction with ethyl acetate, and the extract was dried over MgSO₄ and purified by column chromatography (Hexane:EA = 5:1 (v/v)) to afford Cz-D1 (125.7 g, yield 72%).

Mass (Calcd.: 329.25, Found: 329 g/mol)

### <Preparation Example 1-2> Synthesis of Cz-D2

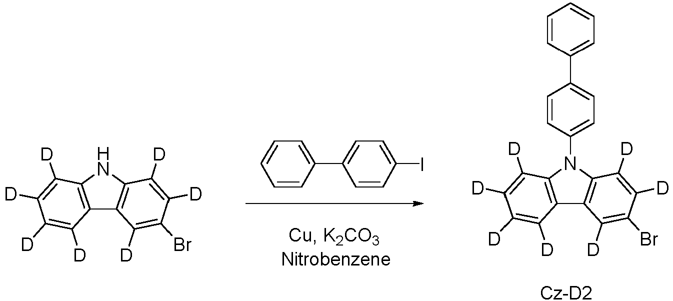

The same procedure as in Preparation Example 1-1, with the exception of using 4-iodo-1,1'-biphenyl (178.3 g, 636.7 mmol) instead of iodobenzene, was conducted to afford the target compound Cz-D2 (135.5 g, yield 63%).

Mass (Calcd.: 405.35, Found: 405 g/mol)

### <Preparation Example 1-3> Synthesis of Cz-D3

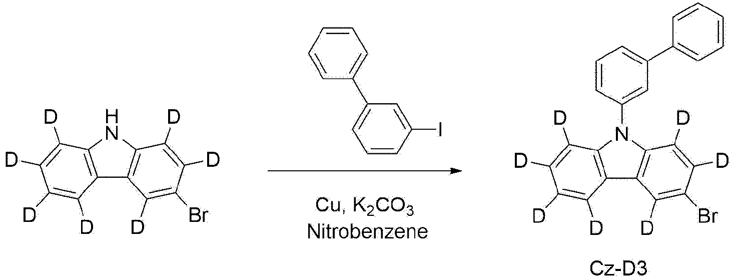

The same procedure as in Preparation Example 1-1, with the exception of using 3-iodo-1,1'-biphenyl (178.3 g, 636.7 mmol) instead of iodobenzene, was conducted to afford the target compound Cz-D3 (148.4 g, yield 69%).

Mass (Calcd.: 405.35, Found: 405 g/mol)

### <Preparation Example 1-4> Synthesis of Cz-D4

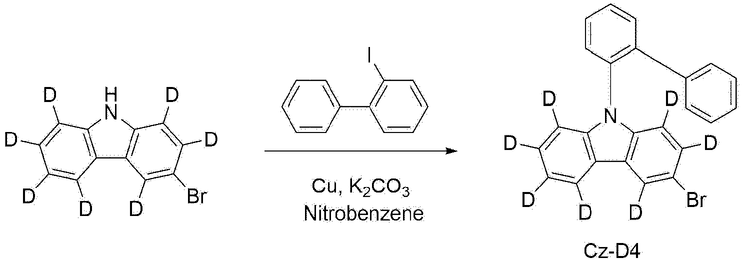

The same procedure as in Preparation Example 1-1, with the exception of using 2-iodo-1,1'-biphenyl (178.3 g, 636.7 mmol) instead of iodobenzene, was conducted to afford the target compound Cz-D4 (96.8 g, yield 45%).

Mass (Calcd.: 405.35, Found: 405 g/mol)

### <Preparation Example 2-1> Synthesis of Cz-D5

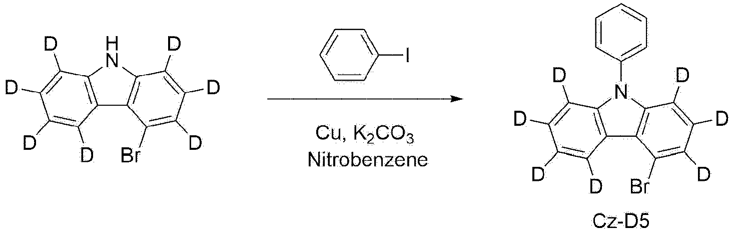

The same procedure as in Preparation Example 1-1, with the exception of using 4-bromo-9H-carbazole-1,2,3,5,6,7,8-d7 (134.3 g, 530.6 mmol) instead of 3-bromo-9H-carbazole-1,2,4,5,6,7,8-d7, was conducted to afford the target compound Cz-D5 (117.1 g, yield 67%).

Mass (Calcd.: 329.25, Found: 329 g/mol)

### <Preparation Example 2-2> Synthesis of Cz-D6

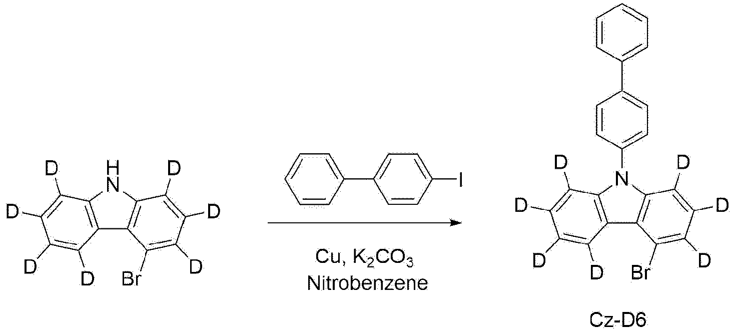

The same procedure as in Preparation Example 2-1, with the exception of using 4-iodo-1,1'-biphenyl (178.3 g, 636.7 mmol) instead of iodobenzene, was conducted to afford the target compound Cz-D6 (139.8 g, yield 65%).

Mass (Calcd.: 405.35, Found: 405 g/mol)

### <Preparation Example 2-3> Synthesis of Cz-D7

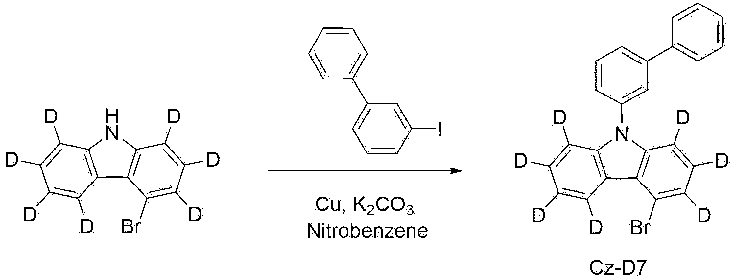

The same procedure as in Preparation Example 2-1, with the exception of using 3-iodo-1,1'-biphenyl (178.3 g, 636.7 mmol) instead of iodobenzene, was conducted to afford the target compound Cz-D7 (152.7 g, yield 71%).

Mass (Calcd.: 405.35, Found: 405 g/mol)

### <Preparation Example 2-4> Synthesis of Cz-D8

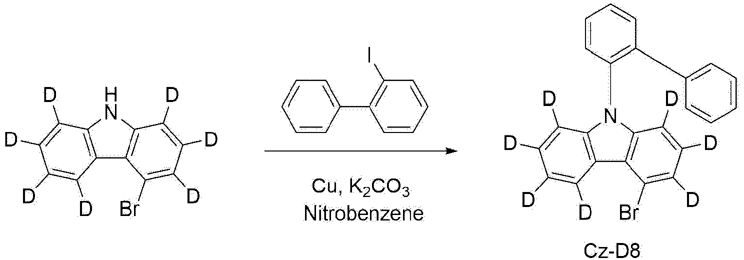

The same procedure as in Preparation Example 2-1, with the exception of using 2-iodo-1,1'-biphenyl (178.3 g, 636.7 mmol) instead of iodobenzene, was conducted to afford the target compound Cz-D8 (75.2 g, yield 35%).

Mass (Calcd.: 405.35, Found: 405 g/mol)

### <Preparation Example 3-1> Synthesis of Cz-D9

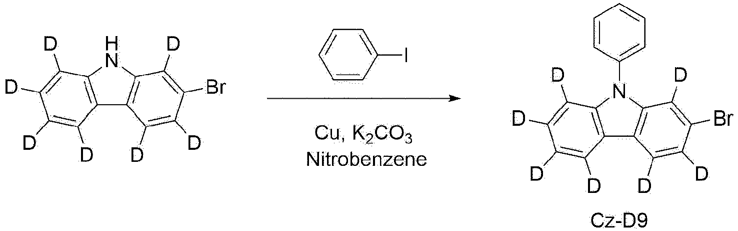

The same procedure as in Preparation Example 1-1, with the exception of using 2-bromo-9H-carbazole-1,3,4,5,6,7,8-d7 (134.3 g, 530.6 mmol) instead of 3-bromo-9H-carbazole-1,2,4,5,6,7,8-d7, was conducted to afford the target compound Cz-D9 (134.5 g, yield 77%).

Mass (Calcd.: 329.25, Found: 329 g/mol)

### <Preparation Example 3-2> Synthesis of Cz-D10

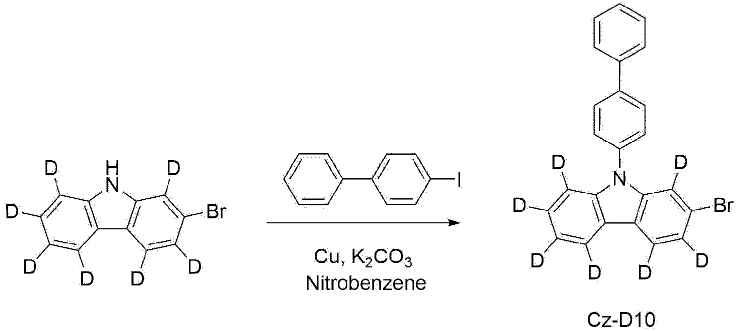

The same procedure as in Preparation Example 3-1, with the exception of using 4-iodo-1,1'-biphenyl (178.3 g, 636.7 mmol) instead of iodobenzene, was conducted to afford the target compound Cz-D10 (159.1 g, yield 74%).

Mass (Calcd.: 405.35, Found: 405 g/mol)

### <Preparation Example 3-3> Synthesis of Cz-D11

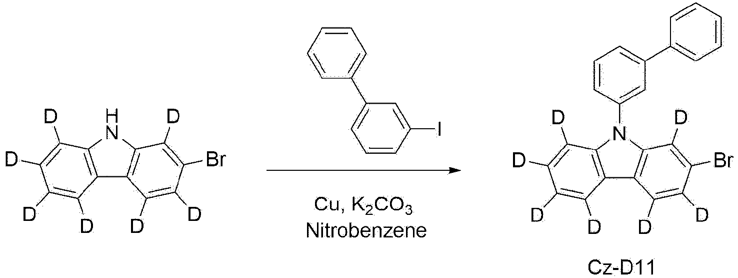

The same procedure as in Preparation Example 3-1, with the exception of using 3-iodo-1,1'-biphenyl (178.3 g, 636.7 mmol) instead of iodobenzene, was conducted to afford the target compound Cz-D11 (163.4 g, yield 76%).

Mass (Calcd.: 405.35, Found: 405 g/mol)

### <Preparation Example 3-4> Synthesis of Cz-D12

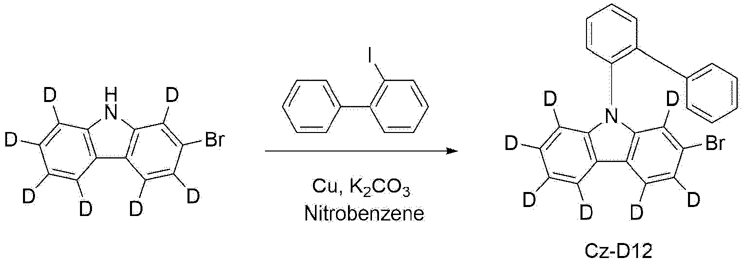

The same procedure as in Preparation Example 3-1, with the exception of using 2-iodo-1,1'-biphenyl (178.3 g, 636.7 mmol) instead of iodobenzene, was conducted to afford the target compound Cz-D12 (92.4 g, yield 43%).

Mass (Calcd.: 405.35, Found: 405 g/mol)

### <Preparation Example 4-1> Synthesis of Cz-D13

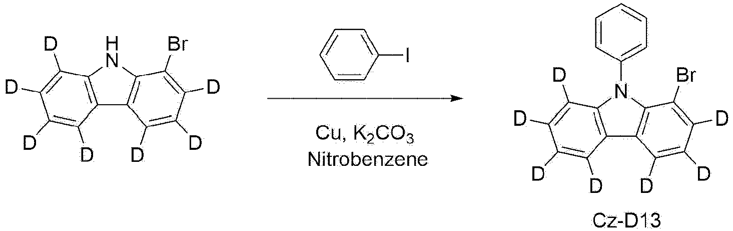

The same procedure as in Preparation Example 1-1, with the exception of using 1-bromo-9H-carbazole-2,3,4,5,6,7,8-d7 (134.3 g, 530.6 mmol) instead of 3-bromo-9H-carbazole-1,2,4,5,6,7,8-d7, was conducted to afford the target compound Cz-D13 (94.3 g, yield 54%).

Mass (Calcd.: 329.25, Found: 329 g/mol)

### <Preparation Example 4-2> Synthesis of Cz-D14

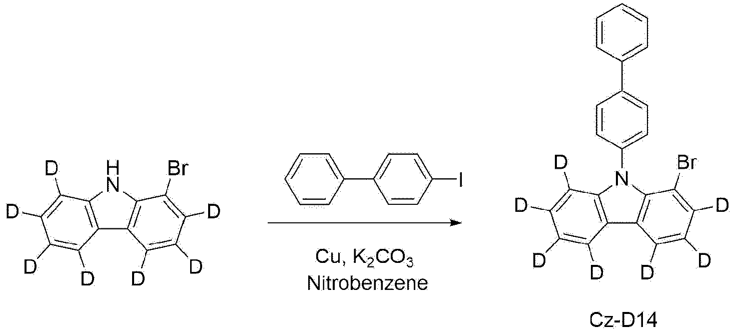

The same procedure as in Preparation Example 4-1, with the exception of using 4-iodo-1,1'-biphenyl (178.3 g, 636.7 mmol) instead of iodobenzene, was conducted to afford the target compound Cz-D14 (122.6 g, yield 57%).

Mass (Calcd.: 405.35, Found: 405 g/mol)

### <Preparation Example 4-3> Synthesis of Cz-D15

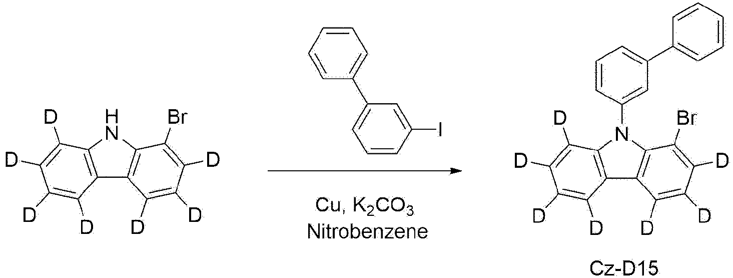

The same procedure as in Preparation Example 4-1, with the exception of using 3-iodo-1,1'-biphenyl (178.3 g, 636.7 mmol) instead of iodobenzene, was conducted to afford the target compound Cz-D15 (111.8 g, yield 52%).

Mass (Calcd.: 405.35, Found: 405 g/mol)

### <Preparation Example 4-4> Synthesis of Cz-D16

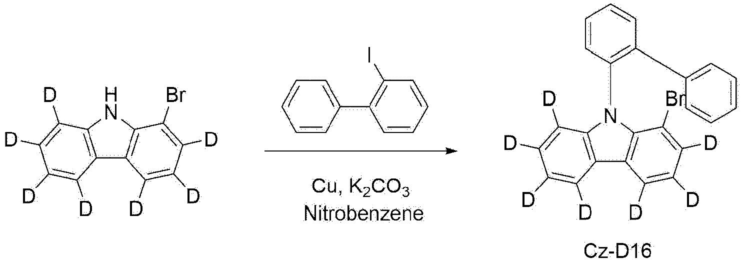

The same procedure as in Preparation Example 4-1, with the exception of using 2-iodo-1,1'-biphenyl (178.3 g, 636.7 mmol) instead of iodobenzene, was conducted to afford the target compound Cz-D16 (68.8 g, yield 32%).

Mass (Calcd.: 405.35, Found: 405 g/mol)

### <Preparation Example 5-1> Synthesis of BCz-D1

### <Step 5-1-1> 9-phenyl-3-(4,4,5,5-tetramethyl-1,3,2-dioxaborolan-2-yl)-9H-carbazole-1,2,4,5,6,7,8-d7

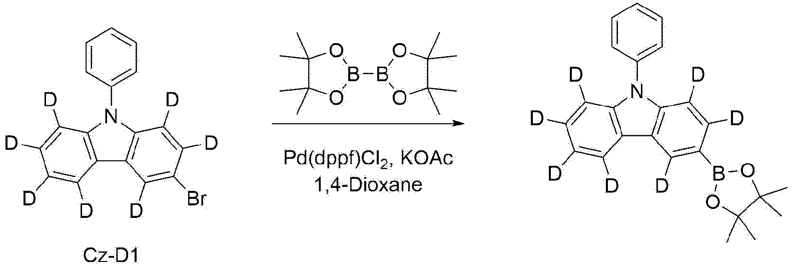

Under a nitrogen atmosphere, a mixture of Cz-D1 (100.0 g, 303.7 mmol), 4,4,4',4',5,5, 5',5'-octamethyl-2,2'-bi(1,3,2-dioxaborolane) (84.8 g, 334.1 mmol), Pd(dppf)Cl₂(26.6 g, 30.3 mmol), KOAc (85.8 g, 911.1 mmol), and 1,4-dioxane (1000 ml) was stirred at 130°C for 12 hours.

After completion of the reaction, the reaction mixture was subjected to extraction with ethyl acetate, and the extract was dried over MgSO₄ and purified by column chromatography (Hexane:EA = 8:1 (v/v)) to afford 9-phenyl-3-(4,4,5,5-tetramethyl-1,3,2-dioxaborolan-2-yl)-9H-carbazole-1,2,4,5,6,7,8-d7 (96.0 g, yield 84%).

Mass (Calcd.: 376.3, Found: 376 g/mol)

### <Step 5-1-2> Synthesis of BCz-D1

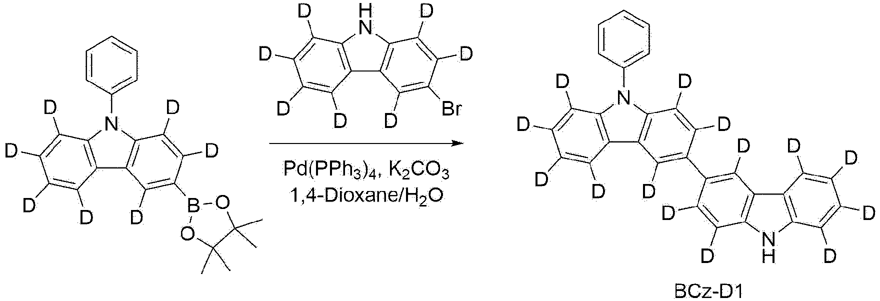

Under a nitrogen atmosphere, a mixture of 9-phenyl-3-(4,4,5,5-tetramethyl-1,3,2-dioxaborolan-2-yl)-9H-carbazole-1,2,4,5,6,7,8-d7 (96.0 g, 255.1 mmol), 3-bromo-9H-carbazole-1,2,4,5,6,7,8-d7 (77.5 g, 306.1 mmol), Pd(PPh₃)₄(14.7 g, 12.7 mmol), K₂CO₃(88.1 g, 637.8 mmol), 1,4-dioxane/H₂O (1000 ml/250 ml) was stirred at 120°C for 4 hours.

After completion of the reaction, the reaction mixture was subjected to methylene chloride and the extract was added with MgSO₄ and filtered. The organic layer thus obtained was cleared of the solvent and purified by column chromatography (Hexane:EA = 7:1 (v/v)) to afford BCz-D1 (71.1 g, yield 66%).

Mass (Calcd.: 422.59, Found: 422 g/mol)

### <Preparation Example 5-2> Synthesis of BCz-D2

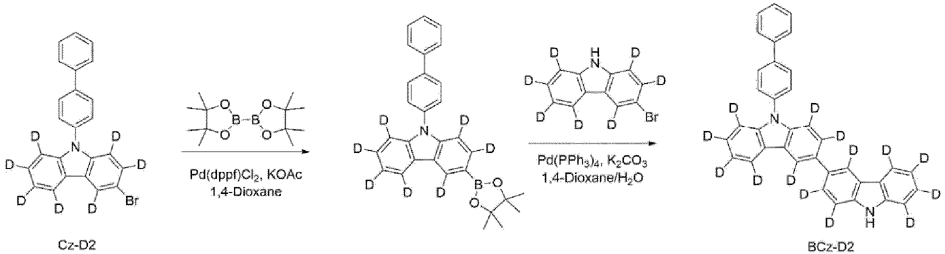

The same procedure as in Preparation Example 5-1, with the exception of using Cz-D2 (100g, 246.7 mmol) instead of Cz-D1, was conducted to afford the target compound BCz-D2 (66.4 g, final yield 54.0%).

Mass (Calcd.: 498.69, Found: 498 g/mol)

### <Preparation Example 5-3> Synthesis of BCz-D3

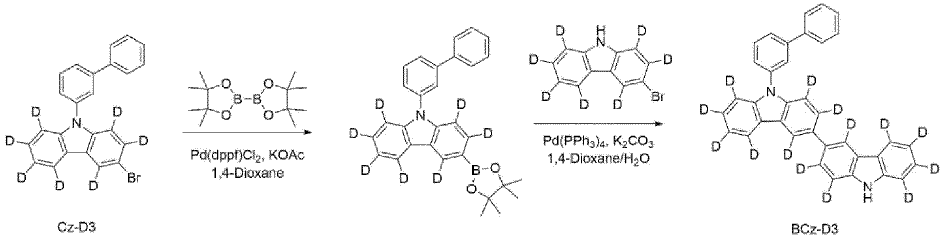

The same procedure as in Preparation Example 5-1, with the exception of using Cz-D3 (100g, 246.7 mmol) instead of Cz-D1, was conducted to afford the target compound BCz-D3 (59.7 g, final yield 48.5%).

Mass (Calcd.: 498.69, Found: 498 g/mol)

### <Preparation Example 5-4> Synthesis of BCz-D4

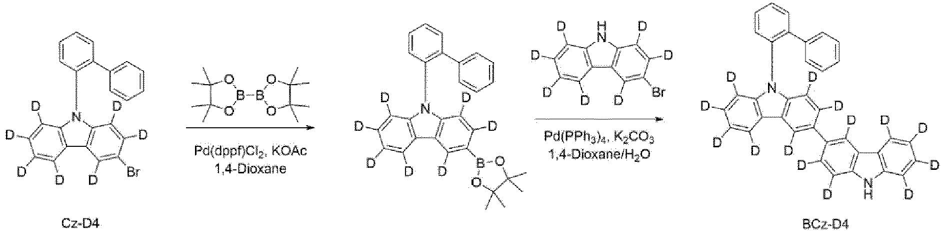

The same procedure as in Preparation Example 5-1, with the exception of using Cz-D4 (100g, 246.7 mmol) instead of Cz-D1, was conducted to afford the target compound BCz-D4 (59.4 g, final yield 48.3%).

Mass (Calcd.: 498.69, Found: 498 g/mol)

### [SYNTHESIS EXAMPLE 1] Synthesis of A-1

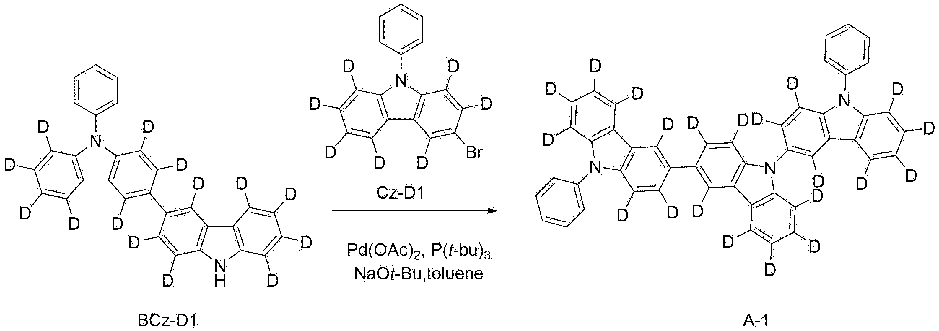

Under a nitrogen atmosphere, a mixture of BCz-D1 (10.0 g, 23.6 mmol), Cz-D1 (9.3 g, 28.3 mmol), Pd(OAc)₂(1.36 g, 1.18 mmol), P(*t*-Bu)₃(0.57 ml, 2.36 mmol), NaO (t-Bu) (4.55 g, 47.3 mmol), and toluene (100 ml) was stirred at 110°C for 5 hours. After completion of the reaction, the reaction mixture was concentrated by removing toluene, and the solid salt was filtered and purified by recrystallization to afford the target compound A-1 (13.0 g, yield 82%).

Mass (Calcd.: 670.93, Found: 670 g/mol)

### [SYNTHESIS EXAMPLE 2] Synthesis of A-2

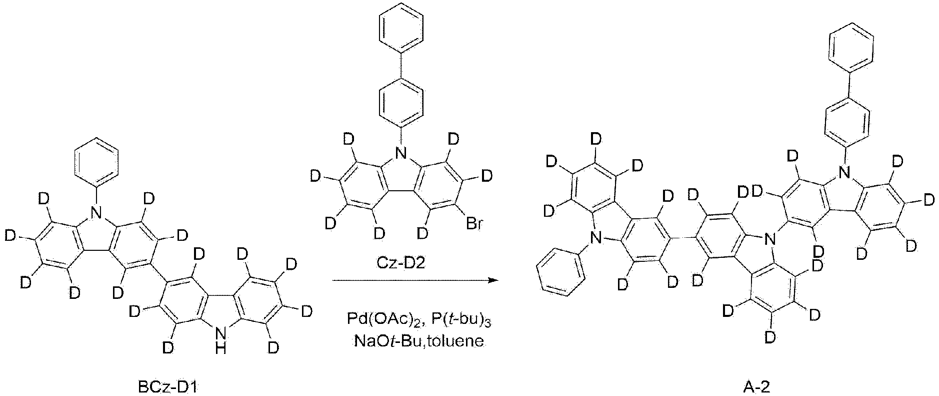

The same procedure as in Synthesis Example 1, with the exception of using Cz-D2 (10.0 g, 23.6 mmol) instead of Cz-D1, was conducted to afford the target compound A-2 (13.8 g, yield 78%).

Mass (Calcd.: 747.02, Found: 747 g/mol)

### [SYNTHESIS EXAMPLE 3] Synthesis of A-3

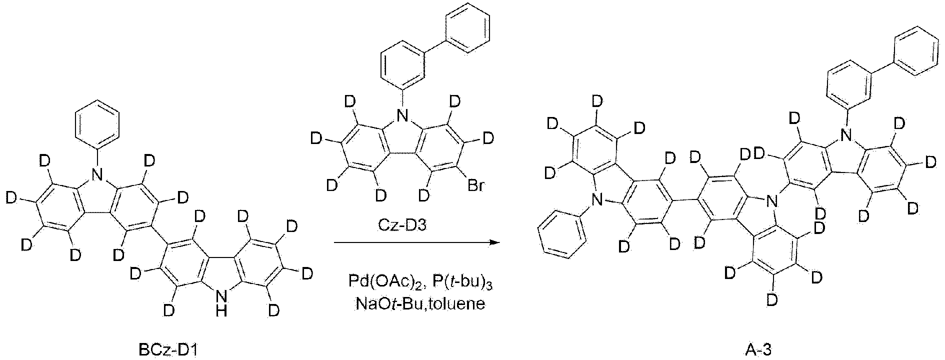

The same procedure as in Synthesis Example 1-1, with the exception of using Cz-D3 (10.0 g, 23.6 mmol) instead of Cz-D1, was conducted to afford the target compound A-3 (13.2 g, yield 75%).

Mass (Calcd.: 747.02, Found: 747 g/mol)

### [SYNTHESIS EXAMPLE 4] Synthesis of A-4

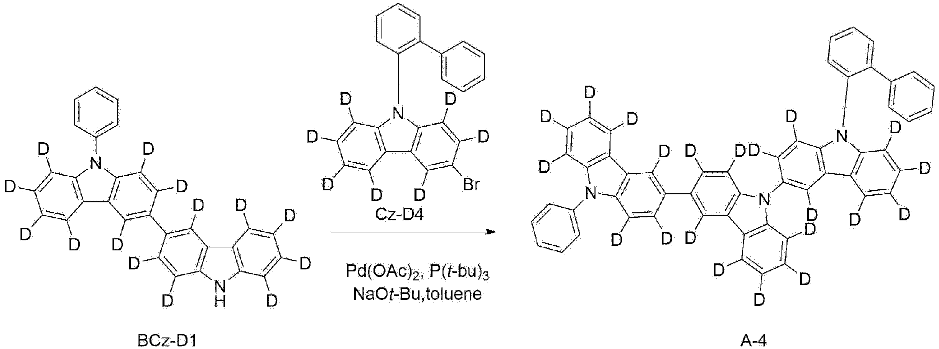

The same procedure as in Synthesis Example 1, with the exception of using Cz-D4 (10.0 g, 23.6 mmol) instead of Cz-D1, was conducted to afford the target compound A-4 (12.2 g, yield 69%).

Mass (Calcd.: 747.02, Found: 747 g/mol)

### [SYNTHESIS EXAMPLE 5] Synthesis of A-5

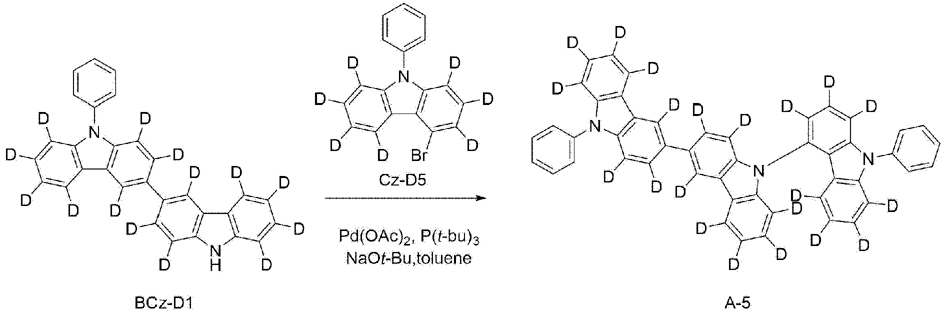

The same procedure as in Synthesis Example 1, with the exception of using Cz-D5 (9.3 g, 23.6 mmol) instead of Cz-D1, was conducted to afford the target compound A-5 (8.73 g, yield 55%).

Mass (Calcd.: 670.93, Found: 670 g/mol)

### [SYNTHESIS EXAMPLE 6] Synthesis of A-6

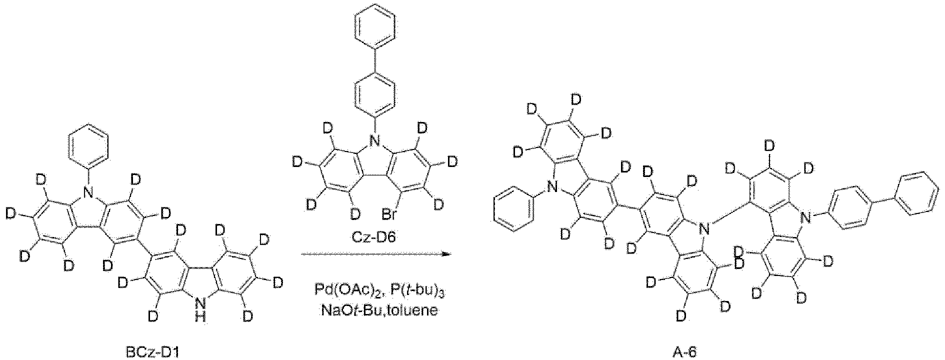

The same procedure as in Synthesis Example 1, with the exception of using Cz-D6 (10.0 g, 23.6 mmol) instead of Cz-D1, was conducted to afford the target compound A-6 (7.42 g, yield 42%).

Mass (Calcd.: 747.02, Found: 747 g/mol)

### [SYNTHESIS EXAMPLE 7] Synthesis of A-7

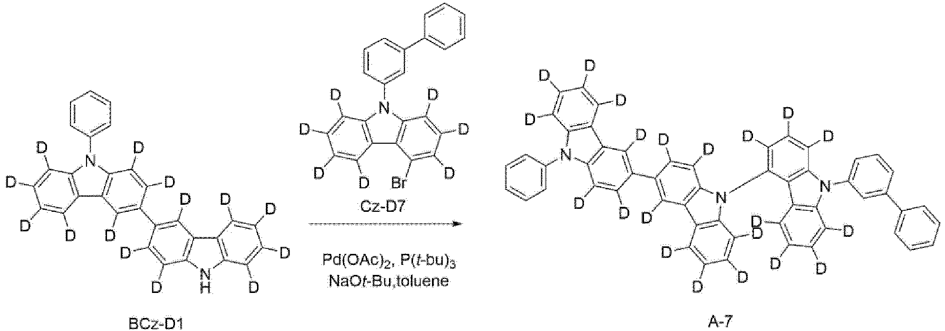

The same procedure as in Synthesis Example 1, with the exception of using Cz-D7 (10.0 g, 23.6 mmol) instead of Cz-D1, was conducted to afford the target compound A-7 (8.83 g, yield 50%).

Mass (Calcd.: 747.02, Found: 747 g/mol)

### [SYNTHESIS EXAMPLE 8] Synthesis of A-8

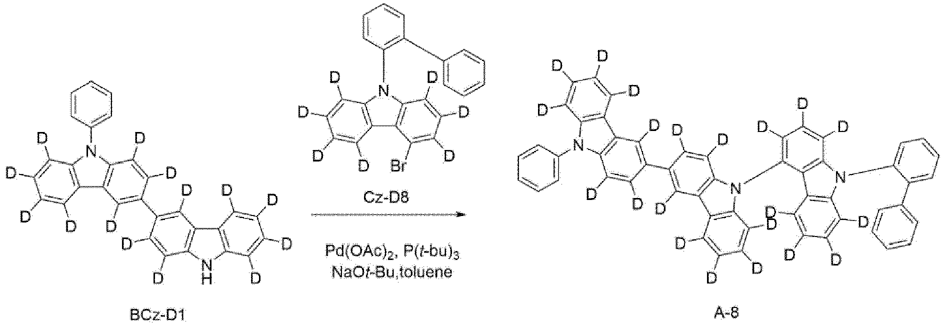

The same procedure as in Synthesis Example 1, with the exception of using Cz-D8 (10.0 g, 23.6 mmol) instead of Cz-D1, was conducted to afford the target compound A-8 (9.89 g, yield 56%).

Mass (Calcd.: 747.02, Found: 747 g/mol)

### [SYNTHESIS EXAMPLE 9] Synthesis of A-9

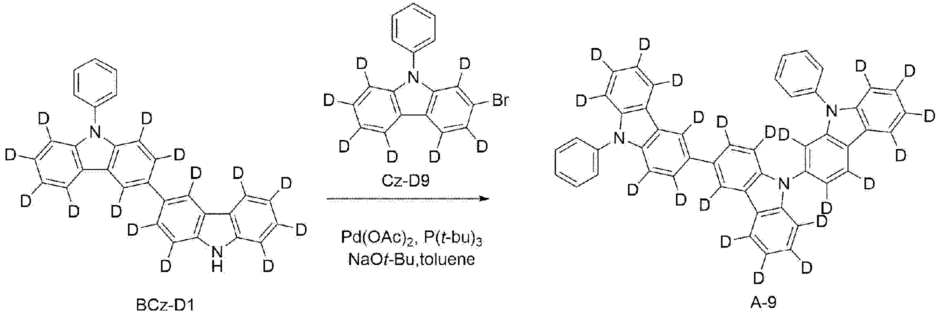

The same procedure as in Synthesis Example 1, with the exception of using Cz-D9 (9.3 g, 23.6 mmol) instead of Cz-D1, was conducted to afford the target compound A-9 (8.41 g, yield 53%).

Mass (Calcd.: 670.93, Found: 670 g/mol)

### [SYNTHESIS EXAMPLE 10] Synthesis of A-10

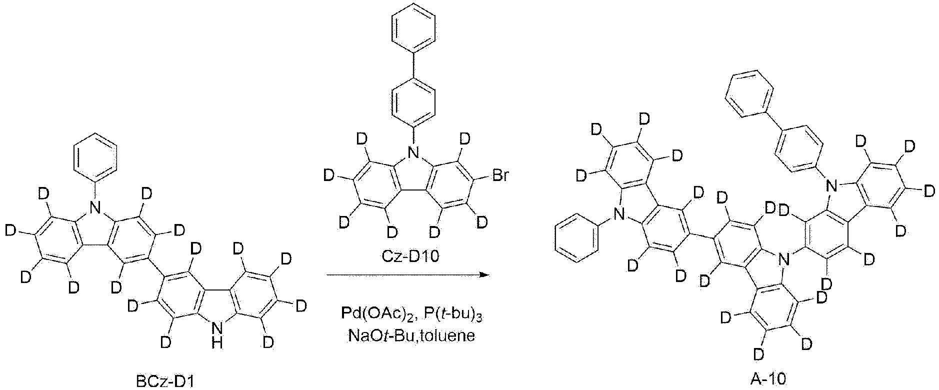

The same procedure as in Synthesis Example 1, with the exception of using Cz-D10 (10.0 g, 23.6 mmol) instead of Cz-D1, was conducted to afford the target compound A-10 (8.66 g, yield 49%).

Mass (Calcd.: 747.02, Found: 747 g/mol)

### [SYNTHESIS EXAMPLE 11] Synthesis of A-11

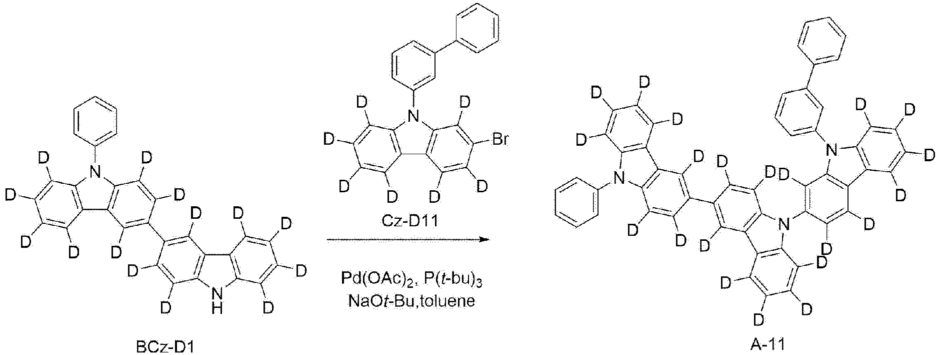

The same procedure as in Synthesis Example 1, with the exception of using Cz-D11 (10.0 g, 23.6 mmol) instead of Cz-D1, was conducted to afford the target compound A-11 (9.01 g, yield 51%).

Mass (Calcd.: 747.02, Found: 747 g/mol)

### [SYNTHESIS EXAMPLE 12] Synthesis of A-12

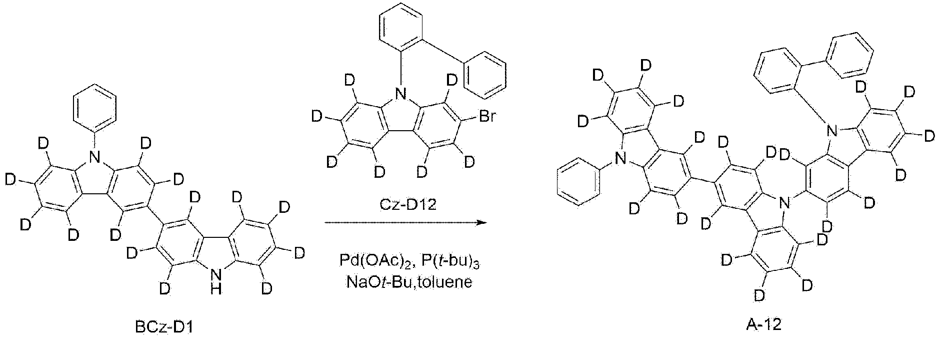

The same procedure as in Synthesis Example 1, with the exception of using Cz-D12 (10.0 g, 23.6 mmol) instead of Cz-D1, was conducted to afford the target compound A-12 (9.19 g, yield 52%).

Mass (Calcd.: 747.02, Found: 747 g/mol)

### [SYNTHESIS EXAMPLE 13] Synthesis of A-13

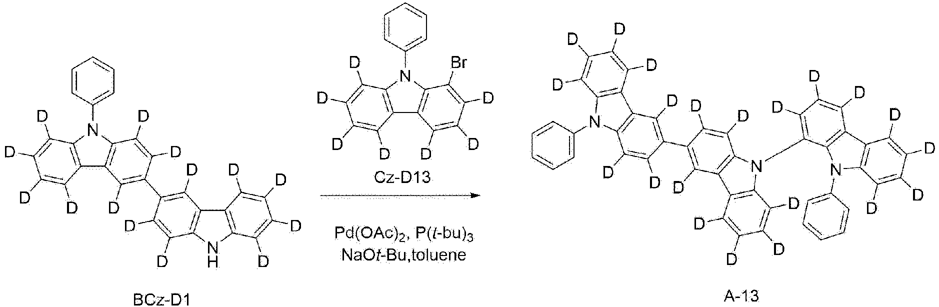

The same procedure as in Synthesis Example 1, with the exception of using Cz-D13 (9.3 g, 23.6 mmol) instead of Cz-D1, was conducted to afford the target compound A-13 (9.52 g, yield 60%).

Mass (Calcd.: 670.93, Found: 670 g/mol)

### [SYNTHESIS EXAMPLE 14] Synthesis of A-14

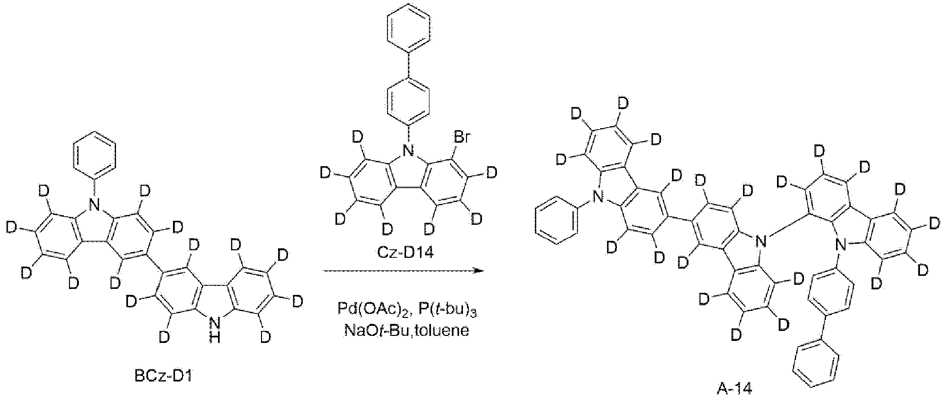

The same procedure as in Synthesis Example 1, with the exception of using Cz-D14 (10.0 g, 23.6 mmol) instead of Cz-D1, was conducted to afford the target compound A-14 (10.78 g, yield 61%).

Mass (Calcd.: 747.02, Found: 747 g/mol)

### [SYNTHESIS EXAMPLE 15] Synthesis of A-15

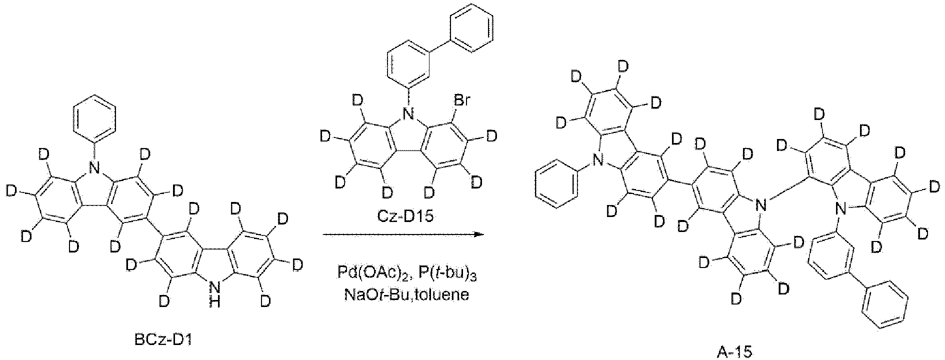

The same procedure as in Synthesis Example 1, with the exception of using Cz-D15 (10.0 g, 23.6 mmol) instead of Cz-D1, was conducted to afford the target compound A-15 (11.13 g, yield 63%).

Mass (Calcd.: 747.02, Found: 747 g/mol)

### [SYNTHESIS EXAMPLE 16] Synthesis of A-16

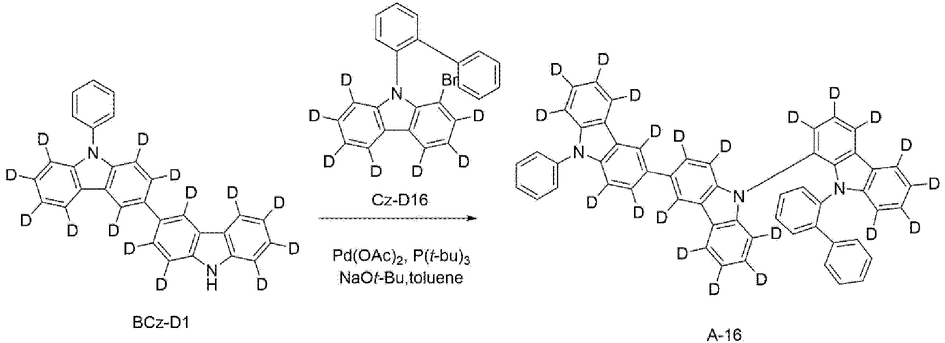

The same procedure as in Synthesis Example 1, with the exception of using Cz-D16 (10.0 g, 23.6 mmol) instead of Cz-D1, was conducted to afford the target compound A-16 (9.02 g, yield 51%).

Mass (Calcd.: 747.02, Found: 747 g/mol)

### [SYNTHESIS EXAMPLE 17] Synthesis of B-1

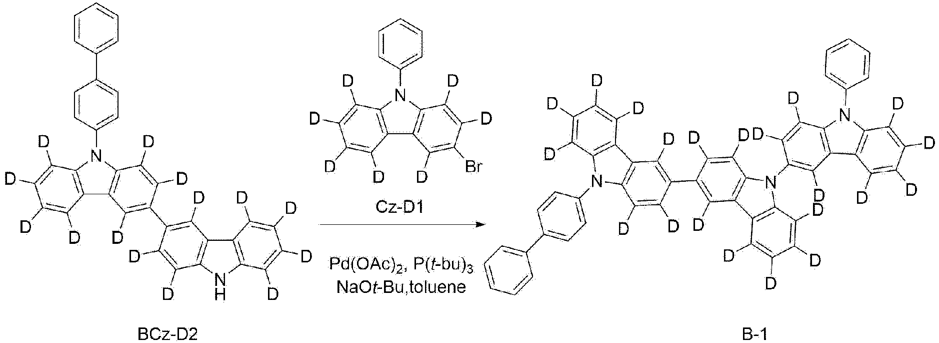

Under a nitrogen atmosphere, a mixture of BCz-D2 (10.0 g, 20.1 mmol), Cz-D1 (7.9 g, 24.1 mmol), Pd(OAc)₂(1.15 g, 1.0 mmol), P(*t*-Bu)₃(0.49 ml, 2.0 mmol), NaO(t-Bu) (3.85 g, 40.1 mmol), and toluene (100 ml) was stirred at 110°C for 5 hours. After completion of the reaction, the reaction mixture was concentrated by removing toluene, and the solid salt was purified by recrystallization to afford the target compound B-1 (10.2 g, yield 62%).

Mass (Calcd.: 747.02, Found: 747 g/mol)

### [SYNTHESIS EXAMPLE 18] Synthesis of B-2

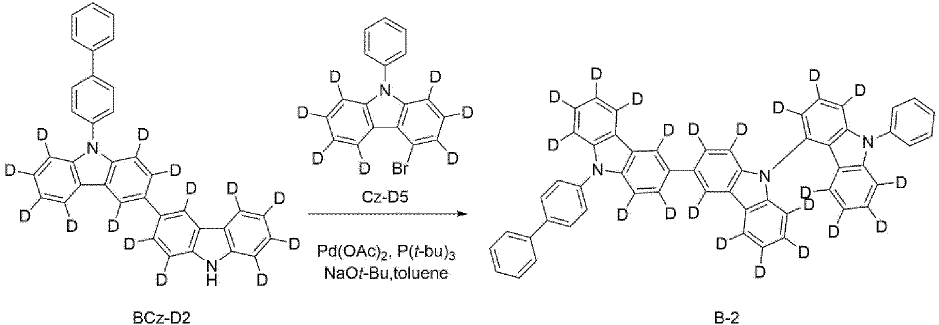

The same procedure as in Synthesis Example 17, with the exception of using Cz-D5 (7.9 g, 24.1 mmol) instead of Cz-D1, was conducted to afford the target compound B-2 (8.5 g, yield 48%).

Mass (Calcd.: 747.02, Found: 747 g/mol)

### [SYNTHESIS EXAMPLE 19] Synthesis of B-3

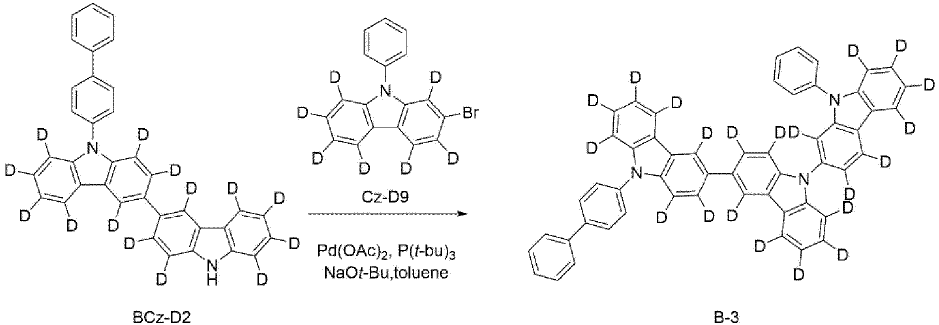

The same procedure as in Synthesis Example 17, with the exception of using Cz-D9 (7.9 g, 24.1 mmol) instead of Cz-D1, was conducted to afford the target compound B-3 (11.1 g, yield 63%).

Mass (Calcd.: 747.02, Found: 747 g/mol)

### [SYNTHESIS EXAMPLE 20] Synthesis of B-4

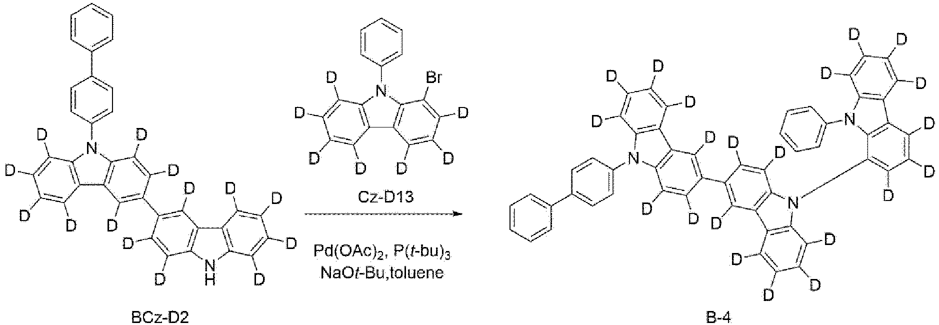

The same procedure as in Preparation Example 1-1, with the exception of using Cz-D13 (7.9 g, 24.1 mmol) instead of Cz-D1, was conducted to afford the target compound B-4 (7.42 g, yield 42%).

Mass (Calcd.: 747.02, Found: 747 g/mol)

### [SYNTHESIS EXAMPLE 21] Synthesis of C-1

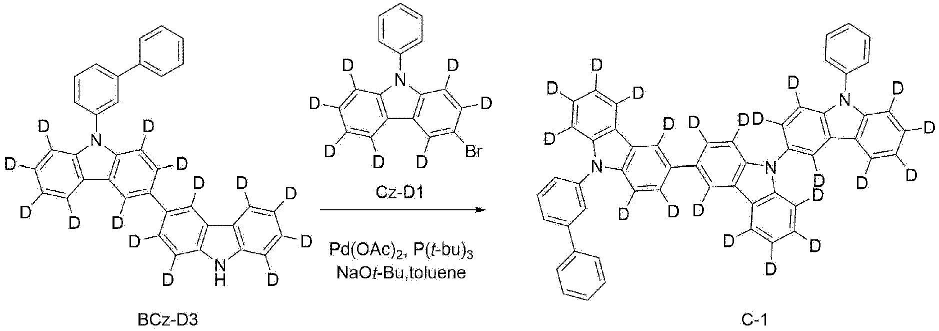

Under a nitrogen atmosphere, a mixture of BCz-D3 (10.0 g, 20.1 mmol), Cz-D1 (7.9 g, 24.1 mmol), Pd(OAc)₂(1.15 g, 1.0 mmol), P(*t*-Bu)₃(0.49 ml, 2.0 mmol), NaO(t-Bu) (3.85 g, 40.1 mmol), and toluene (100 ml) was stirred at 110°C for 5 hours. After completion of the reaction, the reaction mixture was concentrated by removing toluene, and the solid salt was purified by recrystallization to afford the target compound C-1 (9.4 g, yield 63%).

Mass (Calcd.: 747.02, Found: 747 g/mol)

### [SYNTHESIS EXAMPLE 22] Synthesis of C-2

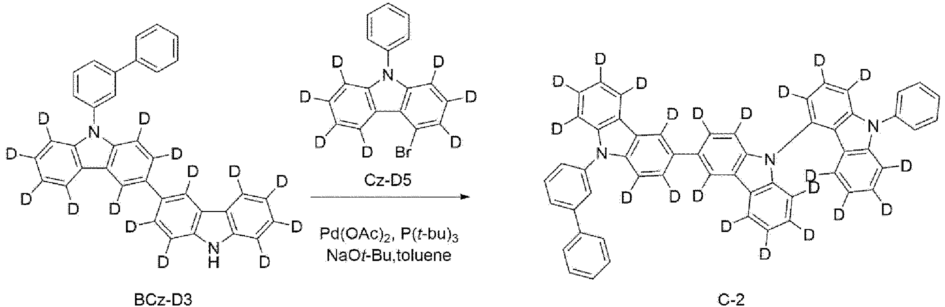

The same procedure as in Synthesis Example 21, with the exception of using Cz-D5 (7.9 g, 24.1 mmol) instead of Cz-D1, was conducted to afford the target compound C-2 (7.78 g, yield 44%).

Mass (Calcd.: 747.02, Found: 747 g/mol)

### [SYNTHESIS EXAMPLE 23] Synthesis of C-3

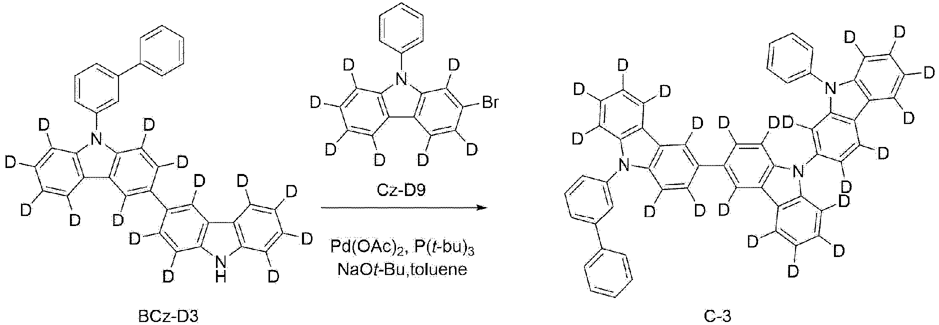

The same procedure as in Synthesis Example 21, with the exception of using Cz-D9 (7.9 g, 24.1 mmol) instead of Cz-D1, was conducted to afford the target compound C-3 (11.67 g, yield 66%).

Mass (Calcd.: 747.02, Found: 747 g/mol)

### [SYNTHESIS EXAMPLE 24] Synthesis of C-4

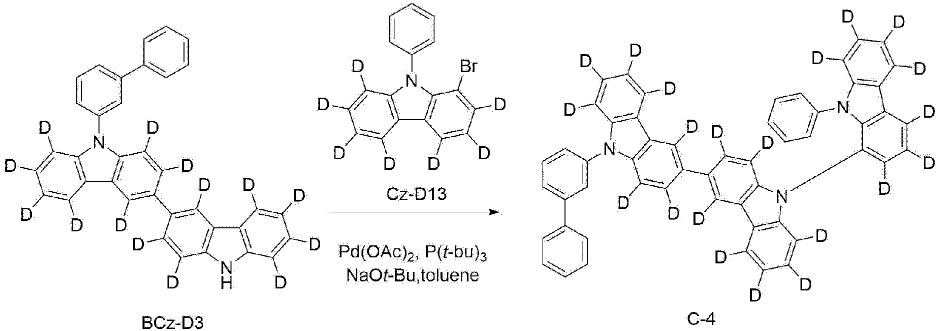

The same procedure as in Synthesis Example 21, with the exception of using Cz-D13 (7.9 g, 24.1 mmol) instead of Cz-D1, was conducted to afford the target compound C-4 (6.89 g, yield 39%).

Mass (Calcd.: 747.02, Found: 747 g/mol)

### [SYNTHESIS EXAMPLE 25] Synthesis of D-1

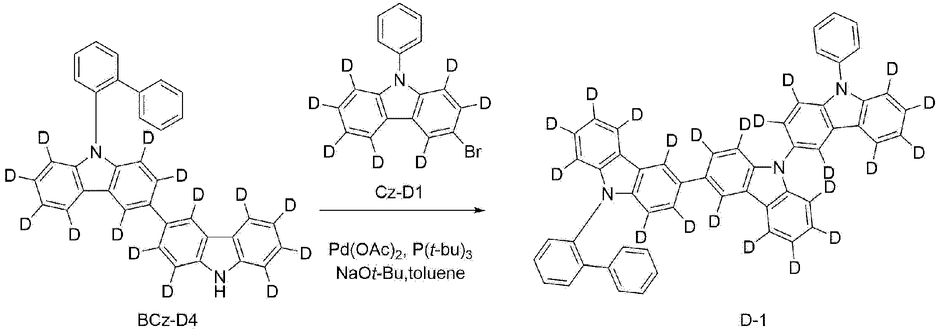

Under a nitrogen atmosphere, a mixture of BCz-D4 (10.0 g, 20.1 mmol), Cz-D1 (7.9 g, 24.1 mmol), Pd(OAc)₂(1.15 g, 1.0 mmol), P(*t*-Bu)₃(0.49 ml, 2.0 mmol), NaO(*t*-Bu) (3.85 g, 40.1 mmol), and toluene (100 ml) was stirred at 110°C for 5 hours. After completion of the reaction, the reaction mixture was concentrated by removing toluene, and the solid salt was purified by recrystallization to afford the target compound D-1 (8.1 g, yield 54%).

Mass (Calcd.: 747.02, Found: 747 g/mol)

### [SYNTHESIS EXAMPLE 26] Synthesis of D-2

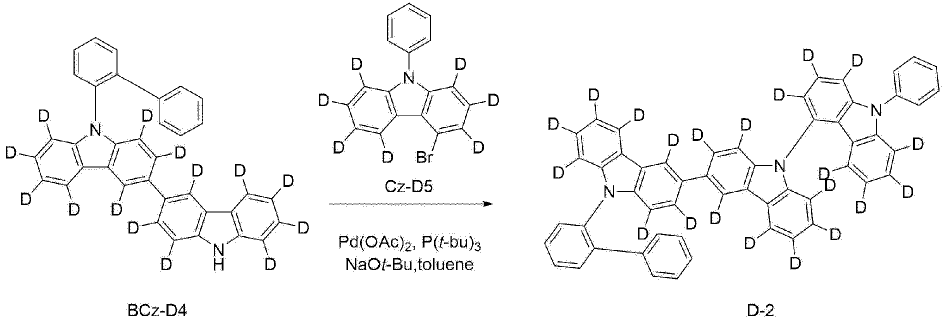

The same procedure as in Synthesis Example 25, with the exception of using Cz-D5 (7.9 g, 24.1 mmol) instead of Cz-D1, was conducted to afford the target compound D-2 (7.24 g, yield 41%).

Mass (Calcd.: 747.02, Found: 747 g/mol)

### [SYNTHESIS EXAMPLE 27] Synthesis of D-3

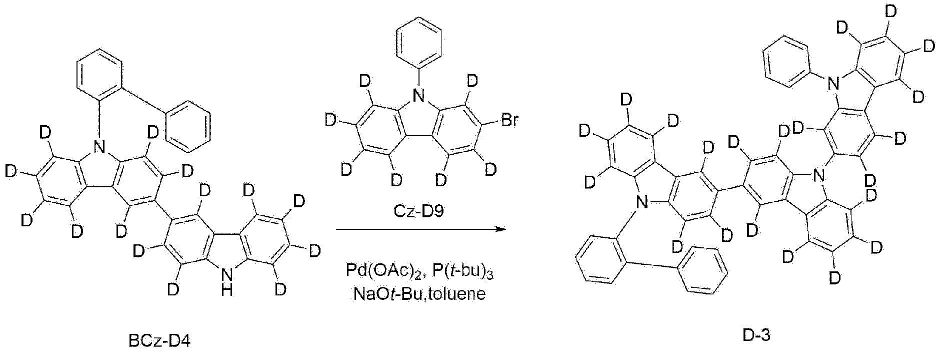

The same procedure as in Synthesis Example 25, with the exception of using Cz-D9 (7.9 g, 24.1 mmol) instead of Cz-D1, was conducted to afford the target compound D-3 (8.41 g, yield 51%).

Mass (Calcd.: 747.02, Found: 747 g/mol)

### [SYNTHESIS EXAMPLE 28] Synthesis of D-4

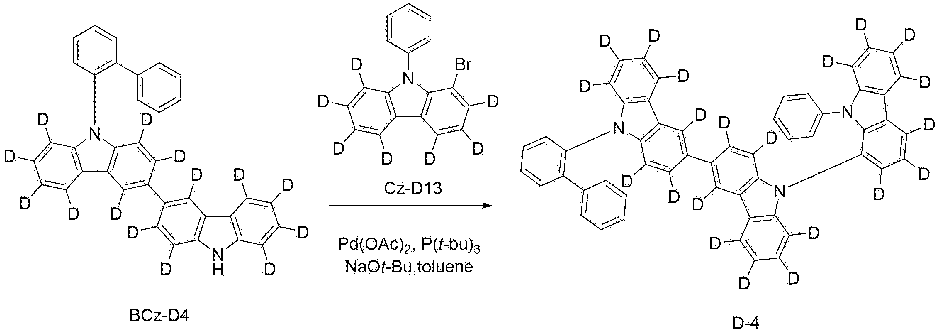

The same procedure as in Synthesis Example 25, with the exception of using Cz-D13 (7.9 g, 24.1 mmol) instead of Cz-D1, was conducted to afford the target compound D-4 (5.47 g, yield 31%).

Mass (Calcd.: 747.02, Found: 747 g/mol)

### [SYNTHESIS EXAMPLES: Second Host]

### [PREPARATION EXAMPLE 6] Synthesis of ACz-1

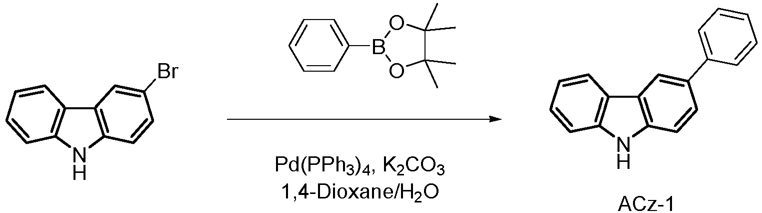

Under a nitrogen atmosphere, a mixture of 3-bromo-9H-carbazole (100.0 g, 406.3 mmol), 4,4,5,5-tetramethyl-2-phenyl-1,3,2-dioxaborolane (99.5 g, 487.6 mmol), Pd(PPh₃)₄ (23.5 g, 20.3 mmol), K₂CO₃(14 0. 4 g, 1,015.8 mmol), and 1,4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-1 (64.3 g, yield 65%).

Mass (Calcd.: 243.31, Found: 243 g/mol)

### [PREPARATION EXAMPLE 7] Synthesis of ACz-2

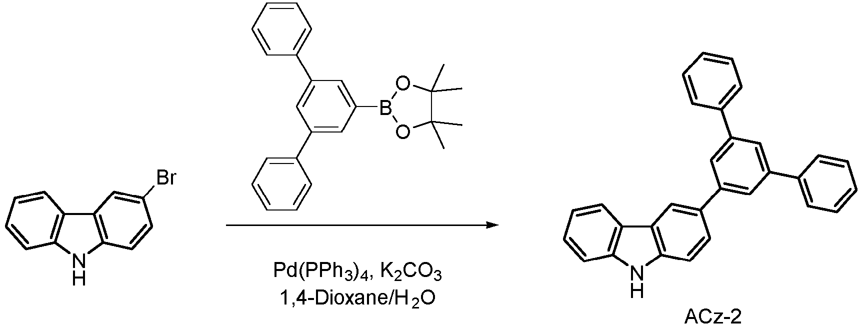

Under a nitrogen atmosphere, a mixture of 3-bromo-9H-carbazole (100.0 g, 406.3 mmol), 2-([1,1':3',1',-terphenyl]-5'-yl)-4,4,5,5-tetramethyl-1,3,2-dioxaborolane (173.7 g, 487.6 mmol), Pd(PPh₃)₄(23.5 g, 20.3 mmol), K₂CO₃ (140.4 g, 1,015.8 mmol), and 1, 4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-2 (82.0 g, yield 51%).

Mass (Calcd.: 395.51, Found: 395 g/mol)

### [PREPARATION EXAMPLE 8] Synthesis of ACz-3

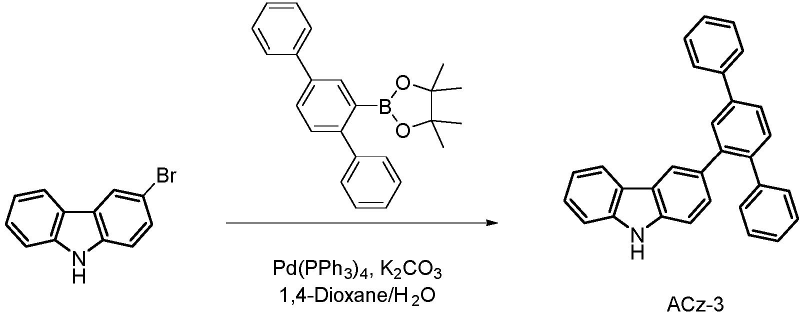

Under a nitrogen atmosphere, a mixture of 3-bromo-9H-carbazole (100.0 g, 406.3 mmol), 2-([1,1':4',1',-terphenyl]-2'-yl)-4,4,5,5-tetramethyl-1,3,2-dioxaborolane (173.7 g, 487.6 mmol), Pd(PPh₃)₄(23.5 g, 20.3 mmol), K₂CO₃ (140.4 g, 1,015.8 mmol), and 1, 4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-3 (70.7 g, yield 44%).

Mass (Calcd.: 395.51, Found: 395 g/mol)

### [PREPARATION EXAMPLE 9] Synthesis of ACz-4

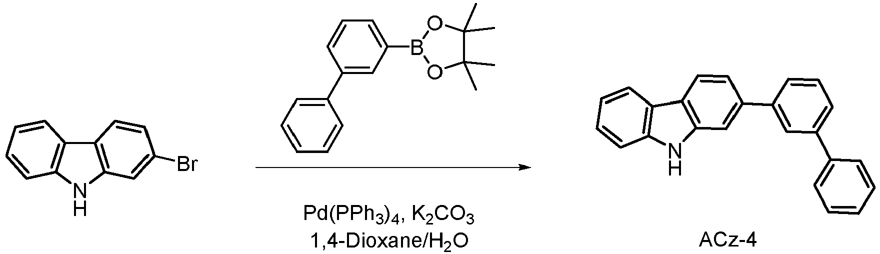

Under a nitrogen atmosphere, a mixture of 2-bromo-9H-carbazole (100.0 g, 406.3 mmol), 2-([1,1'-biphenyl]-3-yl)-4,4,5,5-tetramethyl-1,3,2-dioxaborolane (136.6 g, 487.6 mmol), Pd(PPh₃)₄(23.5 g, 20.3 mmol), K₂CO₃(140.4 g, 1,015.8 mmol), and 1,4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-4 (85.7 g, yield 66%).

Mass (Calcd.: 319.41, Found: 319 g/mol)

### [PREPARATION EXAMPLE 10] Synthesis of ACz-5

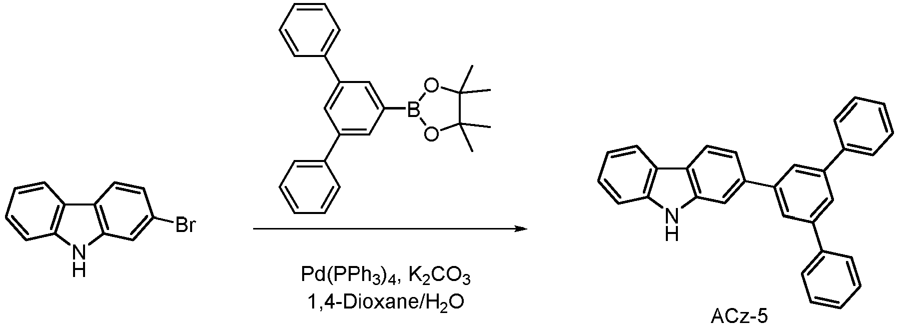

Under a nitrogen atmosphere, a mixture of 2-bromo-9H-carbazole (100.0 g, 406.3 mmol), 2-([1,1':3',1',-terphenyl]-5'-yl)-4,4,5,5-tetramethyl-1,3,2-dioxaborolane (173.7 g, 487.6 mmol), Pd(PPh₃)₄(23.5 g, 20.3 mmol), K₂CO₃(140.4 g, 1,015.8 mmol), and 1,4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-5 (83.6 g, yield 52%).

Mass (Calcd.: 395.51, Found: 395 g/mol)

### [PREPARATION EXAMPLE 11] Synthesis of ACz-6

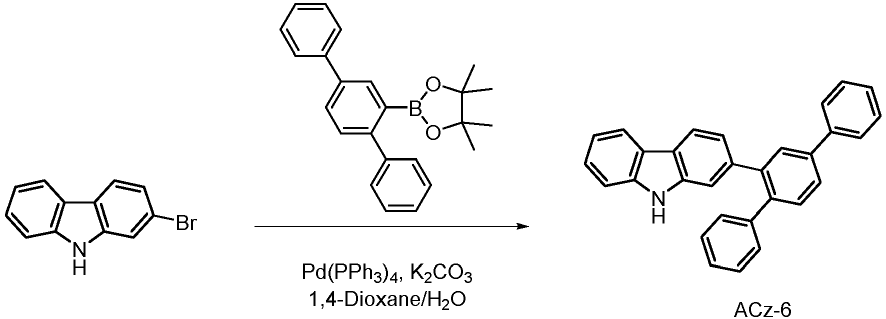

Under a nitrogen atmosphere, a mixture of 2-bromo-9H-carbazole (100.0 g, 406.3 mmol), 2-([1,1':4',1',-terphenyl]-2'-yl)-4,4,5,5-tetramethyl-1,3,2-dioxaborolane (173.7 g, 487.6 mmol), Pd(PPh₃)₄(23.5 g, 20.3 mmol), K₂CO₃(140.4 g, 1,015.8 mmol), and 1,4-dioxane/H₂O (1000 ml/250 ml) was stirred at 120°C for 4 hours.

After completion of the reaction, the reaction mixture was subjected to extraction with methylene chloride, and extract was added with MgSO₄ and filtered. The organic layer thus obtained was cleared of the solvent and purified by column chromatography (Hexane:DCM = 9:1 (v/v)) to afford ACz-6 (65.9 g, yield 41%).

Mass (Calcd.: 395.51, Found: 395 g/mol)

### [SYNTHESIS EXAMPLE 29] Synthesis of E-1

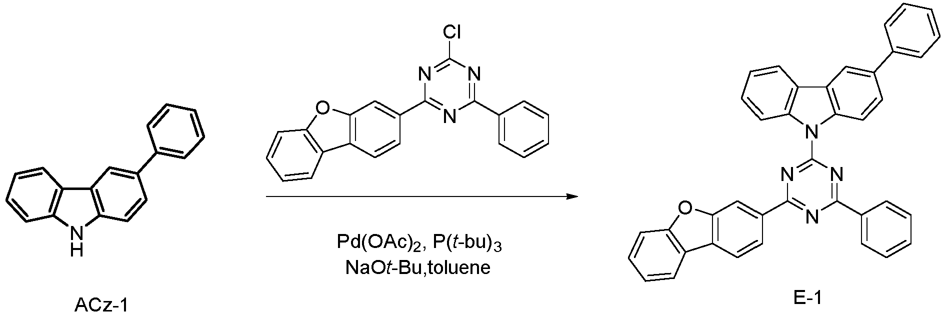

Under a nitrogen atmosphere, a mixture of ACz-1 (10.0 g, 41.1 mmol), 2-chloro-4-(dibenzo[b,d]furan-3-yl)-6-phenyl-1,3,5-triazine (17.6 g, 49.3 mmol), Pd(OAc)₂(2.37 g, 2.1 mmol), P( *t*-Bu)₃(1.0 ml, 4.1 mmol), NaO(*t*-Bu) (7.9 g, 82.2 mmol), and toluene (100 ml) was stirred at 110°C for 5 hours. After completion of the reaction, the reaction mixture was concentrated by removing toluene, and the solid salt was filtered and purified by recrystallization to afford the target compound E-1 (14.9 g, yield 64%).

Mass (Calcd.: 564.65, Found: 564 g/mol)

### [SYNTHESIS EXAMPLE 30] Synthesis of E-2

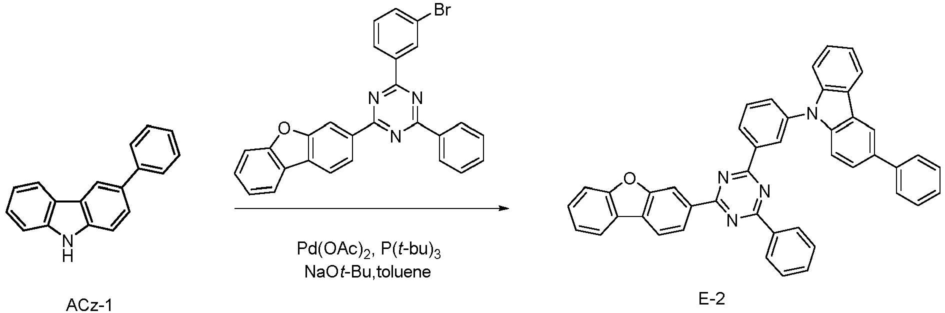

The same procedure as in Synthesis Example 29, with the exception of using 2-(3-bromophenyl)-4-(dibenzo[b,d]furan-3-yl)-6-phenyl-1,3,5-triazine (23.6 g, 49.3 mmol) instead of 2-chloro-4-(dibenzo[b,d]furan-3-yl)-6-phenyl-1,3,5-triazine, was conducted to afford the target compound E-2 (16.1 g, yield 61%).

Mass (Calcd.: 640.75, Found: 640 g/mol)

### [SYNTHESIS EXAMPLE 31] Synthesis of E-3

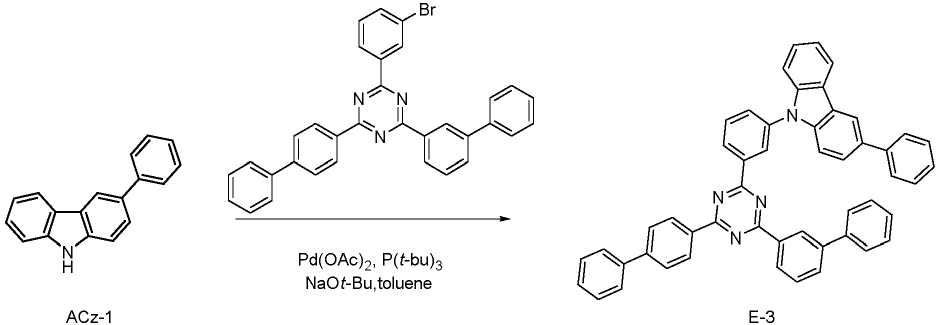

The same procedure as in Synthesis Example 29, with the exception of using 2-([1,1'-biphenyl]-3-yl)-4-([1,1'-biphenyl]-4-yl)-6-(3-bromophenyl)-1,3,5-triazine (26.7 g, 49.3 mmol) instead of 2-chloro-4-(dibenzo[b,d]furan-3-yl)-6-phenyl-1,3,5-triazine, was conducted to afford the target compound E-3 (19.4 g, yield 67%).

Mass (Calcd.: 702.86, Found: 702 g/mol)

### [SYNTHESIS EXAMPLE 32] Synthesis of E-4

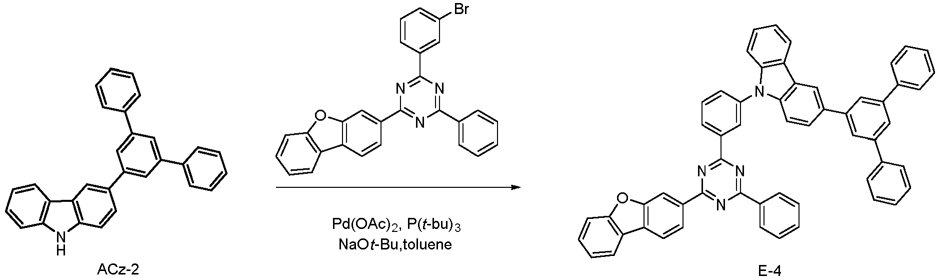

Under a nitrogen atmosphere, a mixture of ACz-2 (10.0 g, 25.3 mmol), 2-(3-bromophenyl)-4-(dibenzo[b,d]furan-3-yl)-6-phenyl-1,3,5-triazine (14.5 g, 30.3 mmol), Pd(OAc)₂(1.5 g, 1.3 mmol), P(*t*-Bu)₃(0.6 ml, 2.5 mmol), NaO(*t*-Bu) (4.9 g, 50.6 mmol), and toluene (100 ml) was stirred at 110°C for 5 hours. After completion of the reaction, the reaction mixture was concentrated by removing toluene, and the solid salt was purified by recrystallization to afford the target compound E-4 (10.4 g, yield 52%).

Mass (Calcd.: 792.94, Found: 792 g/mol)

### [SYNTHESIS EXAMPLE 33] Synthesis of E-5

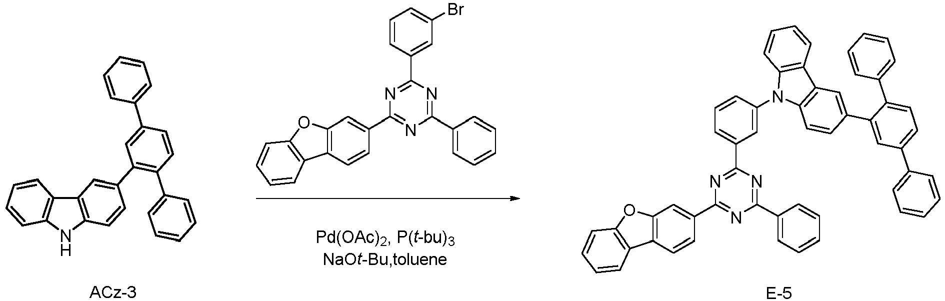

The same procedure as in Synthesis Example 32, with the exception of using ACz-3 (10.0 g, 25.3 mmol) instead of ACz-2 (10.0 g, 25.3 mmol), was conducted to afford the target compound E-5 (9.6 g, yield 48%).

Mass (Calcd.: 792.94, Found: 792 g/mol)

### [SYNTHESIS EXAMPLE 34] Synthesis of E-6

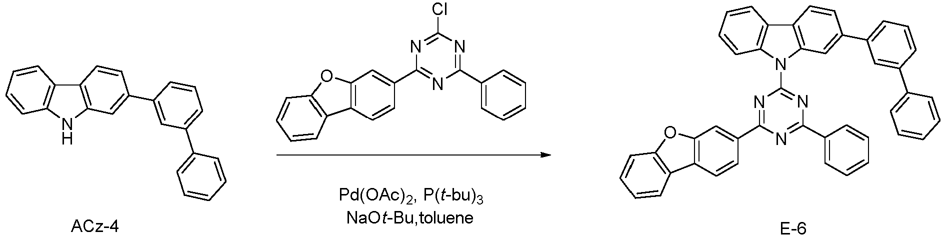

Under a nitrogen atmosphere, ACz-4 (10.0 g, 31.3 mmol), 2-chloro-4-(dibenzo[b,d]furan-3-yl)-6-phenyl-1,3,5-triazine (13.4 g, 37.6 mmol), Pd(OAc)₂(1.8 g, 1.6 mmol), P(*t*-Bu)₃(0.8 ml, 3.1 mmol), NaO(*t*-Bu) (6.0 g, 62.6 mmol), and toluene (100 ml) was stirred at 110°C for 5 hours. After completion of the reaction, the reaction mixture was concentrated by removing toluene, and the solid salt was purified by recrystallization to afford the target compound E-6 (10.2 g, yield 51%).

Mass (Calcd.: 640.75, Found: 640 g/mol)

### [SYNTHESIS EXAMPLE 35] Synthesis of E-7

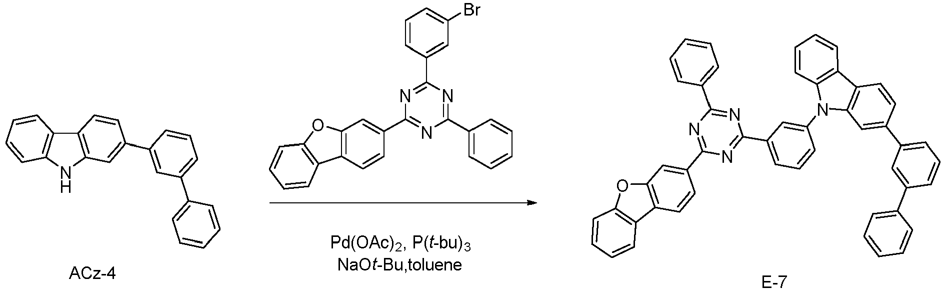

The same procedure as in Synthesis Example 34, with the exception of using 2-(3-bromophenyl)-4-(dibenzo[b,d]furan-3-yl)-6-phenyl-1,3,5-triazine (18.0 g, 37.6 mmol) instead of 2-chloro-4-(dibenzo[b,d]furan-3-yl)-6-phenyl-1,3,5-triazine, was conducted to afford the target compound E-7 (11.9 g, yield 53%).

Mass (Calcd.: 716.84, Found: 716 g/mol)

### [SYNTHESIS EXAMPLE 36] Synthesis of E-8

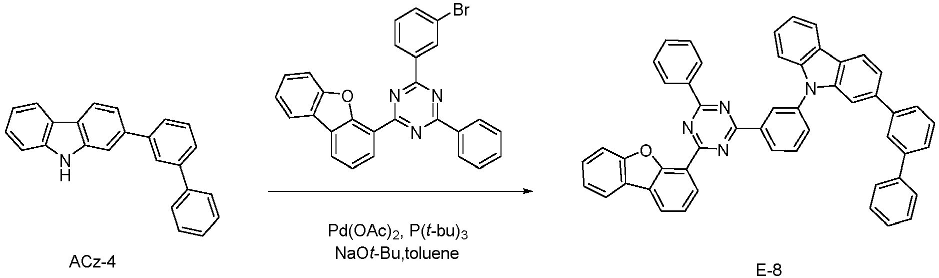

The same procedure as in Synthesis Example 34, with the exception of using2-(3-bromophenyl)-4-(dibenzo[b,d]furan-4-yl)-6-phenyl-1,3,5-triazine (18.0 g, 37.6 mmol) instead of 2-chloro-4-(dibenzo[b,d]furan-3-yl)-6-phenyl-1,3,5-triazine, was conducted to afford the target compound E-8 (9.9 g, yield 44%).

Mass (Calcd.: 716.84, Found: 716 g/mol)

### [SYNTHESIS EXAMPLE 37] Synthesis of E-9

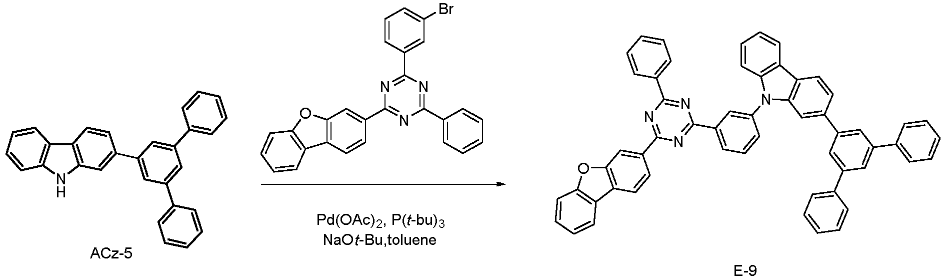

Under a nitrogen atmosphere, a mixture of ACz-5 (10.0 g, 25.3 mmol), 2-(3-bromophenyl)-4-(dibenzo[b,d]furan-3-yl)-6-phenyl-1,3,5-triazine (14.5 g, 30.3 mmol), Pd(OAc)₂(1.5 g, 1.3 mmol), P(*t*-Bu)₃(0.6 ml, 2.5 mmol), NaO (*t*-Bu) (4.9 g, 50.6 mmol), and toluene (100 ml) was stirred at 110°C for 5 hours. After completion of the reaction, the reaction mixture was concentrated by removing toluene, and the solid salt was purified by recrystallization to afford the target compound E-9 (9.2 g, yield 46%).

Mass (Calcd.: 792.94, Found: 792 g/mol)

### [SYNTHESIS EXAMPLE 38] Synthesis of E-10

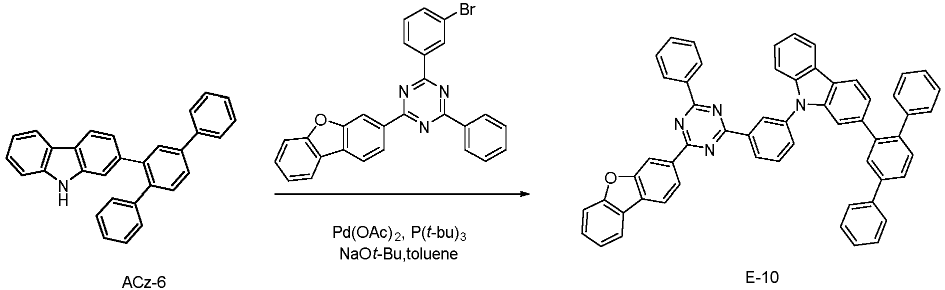

The same procedure as in Synthesis Example 37, with the exception of using ACz-6 (10.0 g, 25.3 mmol) instead of ACz-5 (10.0 g, 25.3 mmol), was conducted to afford the target compound E-10 (7.8 g, yield 39%).

Mass (Calcd.: 792.94, Found: 792 g/mol)

### [EXAMPLE 1] Fabrication of Green Organic EL Device

After purifying compound A-1 synthesized in Synthesis Example 1 and compound E-1 synthesized in Synthesis Example 29 through high-purity sublimation using methods known in the art, blue organic EL devices were fabricated according to the following process.

First, a glass substrate with an indium tin oxide (ITO) thin film coating of 1500 Å thickness was cleansed by ultrasonication with distilled water. After cleansing with distilled water, ultrasonic cleansing was performed with solvents such as isopropyl alcohol, acetone, and methanol. The substrate was dried and then transferred to a UV ozone cleaner (Power Sonic 405, Hwashin Tech), where the substrate was cleaned with UV for 5 minutes before being transferred to a vacuum deposition machine.

On the prepared ITO transparent electrode, organic electroluminescent elements were fabricated by sequentially depositing HT + 2 wt% PA (100 Å) / HT (1200 Å) / HA (300 Å) / 60 wt% compound A-1 + 30 wt% compound E-1 + 10 wt% Ir(ppy)₃(400 Å) / EA (50 Å) / ET + LiQ (300 Å_1:1 molar ratio) / LiF (10 Å) / Al (1000 Å).

The structures of HT, PA, HA, EA, ET, and Ir(ppy)₃ used in this process are shown below:

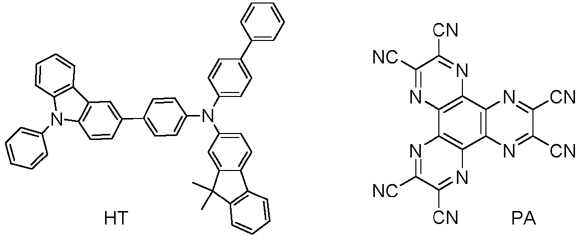

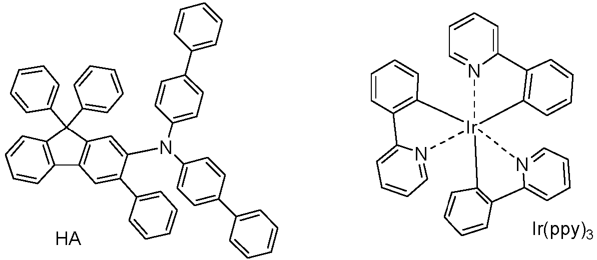

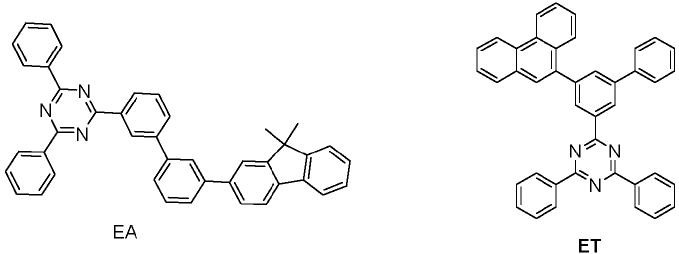

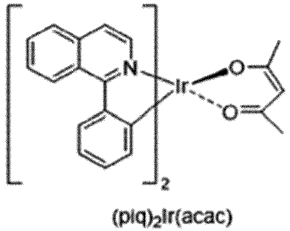

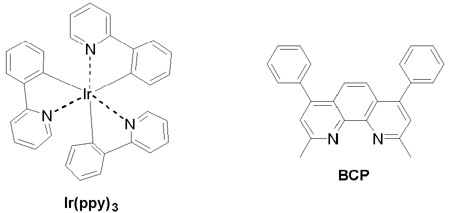

### [EXAMPLES 2 - 280] Fabrication of Green Organic EL Devices

The same procedure as in Example 1, with the exception of using compounds A-2 to D-4 synthesized in Synthesis Examples 2-28 and compounds E-2 to E-10 synthesized in Synthesis Examples 30-38, instead of compound A-1 and compound E-1, respectively, as emission host materials, was conducted to fabricate green organic EL devices (see Table 1, below).

### [COMPARATIVE EXAMPLE 1] Fabrication of Green Organic EL Device

The same procedure as in Example 1, with the exception of using HT-1 and ET-1, instead of compounds A-1 and E-1, respectively, as emission host materials, was conducted to fabricate a green organic EL device. The structures of compounds HT-1 and ET-1 used in Comparative Example 1 are as follows:

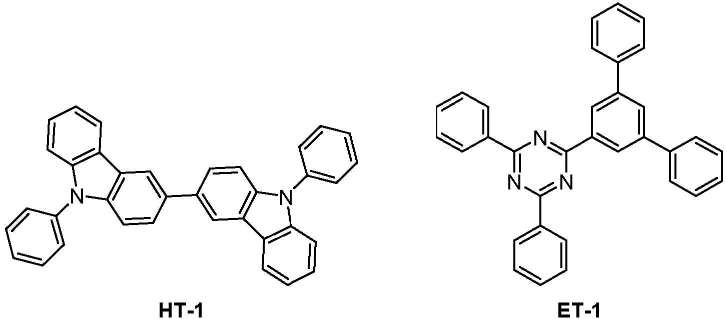

### [COMPARATIVE EXAMPLE 2] Fabrication of Green Organic EL Device

The same procedure as in Example 1, with the exception of using A-1 and ET-1, instead of compounds A-1 and E-1, respectively, as emission host materials, was conducted to fabricate a green organic EL device.

### [COMPARATIVE EXAMPLE 3] Fabrication of Green Organic EL Device

The same procedure as in Example 1, with the exception of using B-2 and ET-2, instead of compounds A-1 and E-1, respectively, as emission host materials, was conducted to fabricate a green organic EL device. The structures of compound ET-2 used in Comparative Example 3 are as follows:

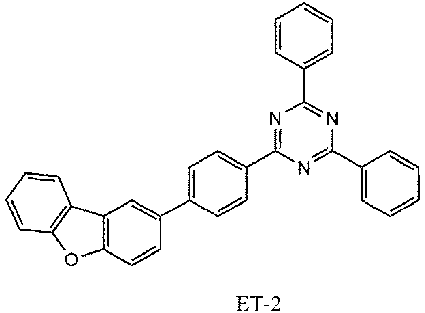

### [COMPARATIVE EXAMPLE 4] Fabrication of Green Organic EL Device

The same procedure as in Example 1, with the exception of using C-3 and ET-3, instead of compounds A-1 and E-1, respectively, as emission host materials, was conducted to fabricate a green organic EL device. The structures of compounds ET-3 used in Comparative Example 4 are as follows:

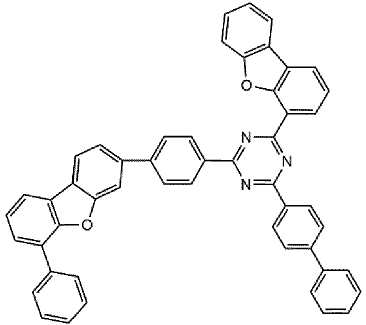

### [COMPARATIVE EXAMPLE 5] Fabrication of Green Organic EL Device

The same procedure as in Example 1, with the exception of using D-4 and ET-4, instead of compounds A-1 and E-1, respectively, as emission host materials, was conducted to fabricate a green organic EL device. The structures of compounds ET-4 used in Comparative Example 5 are as follows:

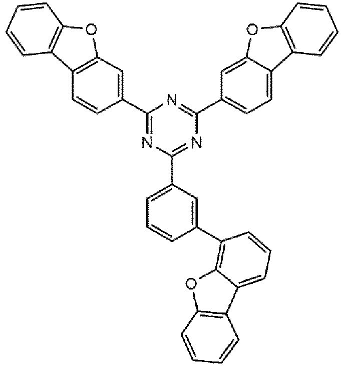

### [EVALUATION EXAMPLE 1]

The green organic EL devices fabricated in Examples 1 to 280 and Comparative Examples 1 to 5 were measured for driving voltage, current efficiency, and emission peak at a current density of 10 mA/cm², and the results are summarized in Table 1 below.

**TABLE 1**

| Sample | 1^{st} Host | 2^{nd} Host | Driving Volt. (V) | EL Peak (nm) | Current Efficiency (cd/A) | Lifespan (hrs., T97) |
|---|---|---|---|---|---|---|
| Ex. 1 | A-1 | E-1 | 4.45 | 516 | 65.4 | 310 |
| Ex. 2 | A-1 | E-2 | 4.56 | 516 | 64.2 | 332 |
| Ex. 3 | A-1 | E-3 | 4.84 | 518 | 66.1 | 322 |
| Ex. 4 | A-1 | E-4 | 4.45 | 518 | 64.3 | 329 |
| Ex. 5 | A-1 | E-5 | 4.56 | 518 | 65.1 | 321 |
| Ex. 6 | A-1 | E-6 | 4.52 | 517 | 61.4 | 334 |
| Ex. 7 | A-1 | E-7 | 4.74 | 515 | 65.4 | 331 |
| Ex. 8 | A-1 | E-8 | 4.48 | 516 | 64.2 | 300 |
| Ex. 9 | A-1 | E-9 | 4.56 | 516 | 66.1 | 310 |
| Ex. 10 | A-1 | E-10 | 4.84 | 518 | 64.3 | 304 |
| Ex. 11 | A-2 | E-1 | 4.45 | 518 | 65.1 | 324 |
| Ex. 12 | A-2 | E-2 | 4.54 | 518 | 61.4 | 315 |
| Ex. 13 | A-2 | E-3 | 4.65 | 517 | 64.3 | 342 |
| Ex. 14 | A-2 | E-4 | 4.48 | 515 | 62.3 | 321 |
| Ex. 15 | A-2 | E-5 | 4.56 | 518 | 64.2 | 333 |
| Ex. 16 | A-2 | E-6 | 4.84 | 518 | 66.1 | 342 |
| Ex. 17 | A-2 | E-7 | 4.45 | 517 | 64.3 | 351 |
| Ex. 18 | A-2 | E-8 | 4.54 | 515 | 61.4 | 321 |
| Ex. 19 | A-2 | E-9 | 4.65 | 517 | 65.4 | 333 |
| Ex. 20 | A-2 | E-10 | 4.55 | 515 | 64.2 | 342 |
| Ex. 21 | A-3 | E-1 | 4.67 | 518 | 66.1 | 351 |
| Ex. 22 | A-3 | E-2 | 4.54 | 518 | 64.3 | 321 |
| Ex. 23 | A-3 | E-3 | 4.56 | 517 | 65.1 | 334 |
| Ex. 24 | A-3 | E-4 | 4.45 | 515 | 61.4 | 331 |
| Ex. 25 | A-3 | E-5 | 4.52 | 516 | 64.3 | 300 |
| Ex. 26 | A-3 | E-6 | 4.74 | 516 | 62.3 | 310 |
| Ex. 27 | A-3 | E-7 | 4.54 | 515 | 64.2 | 321 |
| Ex. 28 | A-3 | E-8 | 4.65 | 518 | 66.1 | 333 |
| Ex. 29 | A-3 | E-9 | 4.55 | 518 | 64.3 | 342 |
| Ex. 30 | A-3 | E-10 | 4.67 | 517 | 65.1 | 351 |
| Ex. 31 | A-4 | E-1 | 4.54 | 515 | 61.4 | 321 |
| Ex. 32 | A-4 | E-2 | 4.56 | 517 | 65.4 | 333 |
| Ex. 33 | A-4 | E-3 | 4.45 | 515 | 64.2 | 342 |
| Ex. 34 | A-4 | E-4 | 4.56 | 518 | 66.1 | 351 |
| Ex. 35 | A-4 | E-5 | 4.48 | 518 | 64.3 | 321 |
| Ex. 36 | A-4 | E-6 | 4.81 | 517 | 65.1 | 334 |
| Ex. 37 | A-4 | E-7 | 4.45 | 515 | 61.4 | 331 |
| Ex. 38 | A-4 | E-8 | 4.56 | 516 | 62.3 | 310 |
| Ex. 39 | A-4 | E-9 | 4.48 | 515 | 64.2 | 321 |
| Ex. 40 | A-4 | E-10 | 4.81 | 518 | 66.1 | 333 |
| Ex. 41 | A-5 | E-1 | 4.54 | 518 | 64.3 | 342 |
| Ex. 42 | A-5 | E-2 | 4.65 | 517 | 65.1 | 351 |
| Ex. 43 | A-5 | E-3 | 4.55 | 515 | 61.4 | 321 |
| Ex. 44 | A-5 | E-4 | 4.67 | 517 | 65.4 | 333 |
| Ex. 45 | A-5 | E-5 | 4.54 | 515 | 64.2 | 342 |
| Ex. 46 | A-5 | E-6 | 4.56 | 518 | 66.1 | 351 |
| Ex. 47 | A-5 | E-7 | 4.56 | 518 | 64.2 | 321 |
| Ex. 48 | A-5 | E-8 | 4.84 | 516 | 66.1 | 333 |
| Ex. 49 | A-5 | E-9 | 4.45 | 518 | 64.3 | 342 |
| Ex. 50 | A-5 | E-10 | 4.54 | 518 | 64.2 | 321 |
| Ex. 51 | A-6 | E-1 | 4.65 | 518 | 66.1 | 333 |
| Ex. 52 | A-6 | E-2 | 4.48 | 517 | 64.3 | 342 |
| Ex. 53 | A-6 | E-3 | 4.56 | 517 | 65.1 | 351 |
| Ex. 54 | A-6 | E-4 | 4.84 | 515 | 61.4 | 321 |
| Ex. 55 | A-6 | E-5 | 4.45 | 518 | 62.4 | 334 |
| Ex. 56 | A-6 | E-6 | 4.54 | 515 | 61.4 | 331 |
| Ex. 57 | A-6 | E-7 | 4.48 | 518 | 62.4 | 341 |
| Ex. 58 | A-6 | E-8 | 4.81 | 516 | 64.2 | 342 |
| Ex. 59 | A-6 | E-9 | 4.54 | 515 | 66.1 | 351 |
| Ex. 60 | A-6 | E-10 | 4.65 | 518 | 64.3 | 321 |
| Ex. 61 | A-7 | E-1 | 4.55 | 518 | 65.1 | 334 |
| Ex. 62 | A-7 | E-2 | 4.67 | 517 | 61.4 | 331 |
| Ex. 63 | A-7 | E-3 | 4.54 | 515 | 61.2 | 320 |
| Ex. 64 | A-7 | E-4 | 4.45 | 518 | 64.3 | 342 |
| Ex. 65 | A-7 | E-5 | 4.54 | 518 | 64.2 | 321 |
| Ex. 66 | A-7 | E-6 | 4.65 | 518 | 66.1 | 333 |
| Ex. 67 | A-7 | E-7 | 4.48 | 517 | 64.3 | 342 |
| Ex. 68 | A-7 | E-8 | 4.56 | 517 | 65.1 | 351 |
| Ex. 69 | A-7 | E-9 | 4.84 | 518 | 64.2 | 321 |
| Ex. 70 | A-7 | E-10 | 4.45 | 517 | 63.1 | 333 |
| Ex. 71 | A-8 | E-1 | 4.54 | 515 | 66.5 | 342 |
| Ex. 72 | A-8 | E-2 | 4.48 | 516 | 61.8 | 351 |
| Ex. 73 | A-8 | E-3 | 4.45 | 515 | 60.7 | 321 |
| Ex. 74 | A-8 | E-4 | 4.56 | 516 | 64.3 | 334 |
| Ex. 75 | A-8 | E-5 | 4.48 | 516 | 62.3 | 331 |
| Ex. 76 | A-8 | E-6 | 4.81 | 518 | 62.4 | 341 |
| Ex. 77 | A-8 | E-7 | 4.54 | 516 | 64.2 | 342 |
| Ex. 78 | A-8 | E-8 | 4.65 | 515 | 66.1 | 351 |
| Ex. 79 | A-8 | E-9 | 4.55 | 518 | 64.3 | 321 |
| Ex. 80 | A-8 | E-10 | 4.81 | 516 | 61.2 | 320 |
| Ex. 81 | A-9 | E-1 | 4.56 | 518 | 62.4 | 341 |
| Ex. 82 | A-9 | E-2 | 4.58 | 518 | 66.2 | 332 |
| Ex. 83 | A-9 | E-3 | 4.89 | 517 | 63.1 | 322 |
| Ex. 84 | A-9 | E-4 | 4.56 | 515 | 66.5 | 329 |
| Ex. 85 | A-9 | E-5 | 4.52 | 516 | 61.8 | 300 |
| Ex. 86 | A-9 | E-6 | 4.74 | 515 | 60.7 | 310 |
| Ex. 87 | A-9 | E-7 | 4.84 | 518 | 64.1 | 315 |
| Ex. 88 | A-9 | E-8 | 4.45 | 518 | 64.3 | 342 |
| Ex. 89 | A-9 | E-9 | 4.54 | 518 | 62.3 | 321 |
| Ex. 90 | A-9 | E-10 | 4.65 | 517 | 65.4 | 333 |
| Ex. 91 | A-10 | E-1 | 4.55 | 515 | 64.2 | 342 |
| Ex. 92 | A-10 | E-2 | 4.67 | 518 | 66.1 | 351 |
| Ex. 93 | A-10 | E-3 | 4.54 | 518 | 64.3 | 321 |
| Ex. 94 | A-10 | E-4 | 4.56 | 517 | 65.1 | 334 |
| Ex. 95 | A-10 | E-5 | 4.45 | 515 | 61.4 | 331 |
| Ex. 96 | A-10 | E-6 | 4.52 | 516 | 64.3 | 300 |
| Ex. 97 | A-10 | E-7 | 4.74 | 516 | 62.3 | 310 |
| Ex. 98 | A-10 | E-8 | 4.54 | 518 | 62.3 | 321 |
| Ex. 99 | A-10 | E-9 | 4.65 | 517 | 65.4 | 333 |
| Ex. 100 | A-10 | E-10 | 4.55 | 516 | 61.8 | 342 |
| Ex. 101 | A-11 | E-1 | 4.67 | 515 | 60.7 | 351 |
| Ex. 102 | A-11 | E-2 | 4.54 | 518 | 64.1 | 321 |
| Ex. 103 | A-11 | E-3 | 4.56 | 518 | 64.3 | 334 |
| Ex. 104 | A-11 | E-4 | 4.45 | 518 | 62.3 | 304 |
| Ex. 105 | A-11 | E-5 | 4.54 | 517 | 65.4 | 320 |
| Ex. 106 | A-11 | E-6 | 4.56 | 515 | 64.2 | 321 |
| Ex. 107 | A-11 | E-7 | 4.45 | 518 | 66.1 | 333 |
| Ex. 108 | A-11 | E-8 | 4.56 | 518 | 64.3 | 342 |
| Ex. 109 | A-11 | E-9 | 4.48 | 517 | 65.1 | 321 |
| Ex. 110 | A-11 | E-10 | 4.48 | 515 | 61.4 | 333 |
| Ex. 111 | A-12 | E-1 | 4.81 | 516 | 64.3 | 342 |
| Ex. 112 | A-12 | E-2 | 4.54 | 516 | 62.3 | 351 |
| Ex. 113 | A-12 | E-3 | 4.65 | 518 | 62.3 | 321 |
| Ex. 114 | A-12 | E-4 | 4.56 | 518 | 64.3 | 334 |
| Ex. 115 | A-12 | E-5 | 4.45 | 518 | 62.3 | 304 |
| Ex. 116 | A-12 | E-6 | 4.54 | 517 | 65.4 | 320 |
| Ex. 117 | A-12 | E-7 | 4.56 | 515 | 64.2 | 321 |
| Ex. 118 | A-12 | E-8 | 4.45 | 518 | 66.1 | 333 |
| Ex. 119 | A-12 | E-9 | 4.56 | 518 | 64.3 | 342 |
| Ex. 120 | A-12 | E-10 | 4.48 | 517 | 65.1 | 321 |
| Ex. 121 | A-13 | E-1 | 4.48 | 515 | 61.4 | 333 |
| Ex. 122 | A-13 | E-2 | 4.81 | 516 | 64.3 | 342 |
| Ex. 123 | A-13 | E-3 | 4.55 | 516 | 61.8 | 342 |
| Ex. 124 | A-13 | E-4 | 4.67 | 515 | 60.7 | 351 |
| Ex. 125 | A-13 | E-5 | 4.54 | 518 | 64.1 | 321 |
| Ex. 126 | A-13 | E-6 | 4.56 | 518 | 64.3 | 334 |
| Ex. 127 | A-13 | E-7 | 4.45 | 518 | 62.3 | 304 |
| Ex. 128 | A-13 | E-8 | 4.54 | 517 | 65.4 | 320 |
| Ex. 129 | A-13 | E-9 | 4.56 | 515 | 64.2 | 321 |
| Ex. 130 | A-13 | E-10 | 4.45 | 518 | 66.1 | 333 |
| Ex. 131 | A-14 | E-1 | 4.56 | 518 | 64.3 | 342 |
| Ex. 132 | A-14 | E-2 | 4.48 | 517 | 65.1 | 321 |
| Ex. 133 | A-14 | E-3 | 4.48 | 515 | 61.4 | 333 |
| Ex. 134 | A-14 | E-4 | 4.81 | 516 | 64.3 | 342 |
| Ex. 135 | A-14 | E-5 | 4.54 | 516 | 62.3 | 351 |
| Ex. 136 | A-14 | E-6 | 4.65 | 518 | 62.3 | 321 |
| Ex. 137 | A-14 | E-7 | 4.55 | 517 | 65.4 | 334 |
| Ex. 138 | A-14 | E-8 | 4.67 | 515 | 64.2 | 331 |
| Ex. 139 | A-14 | E-9 | 4.54 | 518 | 66.1 | 341 |
| Ex. 140 | A-14 | E-10 | 4.45 | 518 | 64.3 | 304 |
| Ex. 141 | A-15 | E-1 | 4.54 | 517 | 65.1 | 320 |
| Ex. 142 | A-15 | E-2 | 4.45 | 518 | 62.3 | 304 |
| Ex. 143 | A-15 | E-3 | 4.54 | 517 | 65.4 | 320 |
| Ex. 144 | A-15 | E-4 | 4.56 | 515 | 64.2 | 321 |
| Ex. 145 | A-15 | E-5 | 4.45 | 518 | 66.1 | 333 |
| Ex. 146 | A-15 | E-6 | 4.56 | 518 | 64.3 | 342 |
| Ex. 147 | A-15 | E-7 | 4.48 | 517 | 65.1 | 321 |
| Ex. 148 | A-15 | E-8 | 4.48 | 515 | 61.4 | 333 |
| Ex. 149 | A-15 | E-9 | 4.81 | 516 | 64.3 | 342 |
| Ex. 150 | A-15 | E-10 | 4.54 | 516 | 62.3 | 351 |
| Ex. 151 | A-16 | E-1 | 4.65 | 518 | 62.3 | 321 |
| Ex. 152 | A-16 | E-2 | 4.56 | 518 | 64.3 | 334 |
| Ex. 153 | A-16 | E-3 | 4.45 | 518 | 62.3 | 304 |
| Ex. 154 | A-16 | E-4 | 4.54 | 517 | 65.4 | 320 |
| Ex. 155 | A-16 | E-5 | 4.56 | 515 | 64.2 | 321 |
| Ex. 156 | A-16 | E-6 | 4.45 | 518 | 66.1 | 333 |
| Ex. 157 | A-16 | E-7 | 4.56 | 518 | 64.3 | 342 |
| Ex. 158 | A-16 | E-8 | 4.48 | 517 | 65.1 | 321 |
| Ex. 159 | A-16 | E-9 | 4.48 | 515 | 61.4 | 333 |
| Ex. 160 | A-16 | E-10 | 4.81 | 516 | 64.3 | 342 |
| Ex. 161 | B-1 | E-1 | 4.55 | 516 | 61.8 | 342 |
| Ex. 162 | B-1 | E-2 | 4.67 | 515 | 60.7 | 351 |
| Ex. 163 | B-1 | E-3 | 4.54 | 518 | 64.1 | 321 |
| Ex. 164 | B-1 | E-4 | 4.56 | 518 | 64.3 | 334 |
| Ex. 165 | B-1 | E-5 | 4.45 | 518 | 62.3 | 304 |
| Ex. 166 | B-1 | E-6 | 4.54 | 517 | 65.4 | 320 |
| Ex. 167 | B-1 | E-7 | 4.56 | 515 | 64.2 | 321 |
| Ex. 168 | B-1 | E-8 | 4.45 | 518 | 66.1 | 333 |
| Ex. 169 | B-1 | E-9 | 4.56 | 518 | 64.3 | 342 |
| Ex. 170 | B-1 | E-10 | 4.48 | 517 | 65.1 | 321 |
| Ex. 171 | B-2 | E-1 | 4.48 | 515 | 61.4 | 333 |
| Ex. 172 | B-2 | E-2 | 4.81 | 516 | 64.3 | 342 |
| Ex. 173 | B-2 | E-3 | 4.54 | 516 | 62.3 | 351 |
| Ex. 174 | B-2 | E-4 | 4.65 | 518 | 66.1 | 341 |
| Ex. 175 | B-2 | E-5 | 4.55 | 518 | 64.3 | 304 |
| Ex. 176 | B-2 | E-6 | 4.54 | 517 | 65.1 | 320 |
| Ex. 177 | B-2 | E-7 | 4.56 | 518 | 62.3 | 304 |
| Ex. 178 | B-2 | E-8 | 4.45 | 517 | 65.4 | 320 |
| Ex. 179 | B-2 | E-9 | 4.56 | 515 | 64.2 | 321 |
| Ex. 180 | B-2 | E-10 | 4.48 | 518 | 66.1 | 333 |
| Ex. 181 | B-3 | E-1 | 4.48 | 518 | 64.3 | 342 |
| Ex. 182 | B-3 | E-2 | 4.81 | 517 | 65.1 | 321 |
| Ex. 183 | B-3 | E-3 | 4.54 | 515 | 61.4 | 333 |
| Ex. 184 | B-3 | E-4 | 4.65 | 516 | 64.3 | 342 |
| Ex. 185 | B-3 | E-5 | 4.55 | 516 | 62.3 | 351 |
| Ex. 186 | B-3 | E-6 | 4.67 | 518 | 62.3 | 321 |
| Ex. 187 | B-3 | E-7 | 4.54 | 518 | 64.3 | 334 |
| Ex. 188 | B-3 | E-8 | 4.45 | 518 | 62.3 | 304 |
| Ex. 189 | B-3 | E-9 | 4.54 | 517 | 65.4 | 320 |
| Ex. 190 | B-3 | E-10 | 4.65 | 515 | 64.2 | 321 |
| Ex. 191 | B-4 | E-1 | 4.55 | 518 | 66.1 | 333 |
| Ex. 192 | B-4 | E-2 | 4.67 | 518 | 64.3 | 342 |
| Ex. 193 | B-4 | E-3 | 4.54 | 517 | 65.1 | 321 |
| Ex. 194 | B-4 | E-4 | 4.56 | 515 | 61.4 | 333 |
| Ex. 195 | B-4 | E-5 | 4.54 | 516 | 64.3 | 342 |
| Ex. 196 | B-4 | E-6 | 4.65 | 516 | 61.8 | 342 |
| Ex. 197 | B-4 | E-7 | 4.55 | 515 | 60.7 | 351 |
| Ex. 198 | B-4 | E-8 | 4.67 | 518 | 64.1 | 321 |
| Ex. 199 | B-4 | E-9 | 4.56 | 518 | 64.3 | 342 |
| Ex. 200 | B-4 | E-10 | 4.48 | 517 | 65.1 | 321 |
| Ex. 201 | C-1 | E-1 | 4.48 | 515 | 61.4 | 333 |
| Ex. 202 | C-1 | E-2 | 4.81 | 516 | 64.3 | 342 |
| Ex. 203 | C-1 | E-3 | 4.54 | 516 | 62.3 | 351 |
| Ex. 204 | C-1 | E-4 | 4.65 | 518 | 66.1 | 341 |
| Ex. 205 | C-1 | E-5 | 4.55 | 518 | 64.3 | 304 |
| Ex. 206 | C-1 | E-6 | 4.54 | 517 | 65.1 | 320 |
| Ex. 207 | C-1 | E-7 | 4.56 | 518 | 62.3 | 304 |
| Ex. 208 | C-1 | E-8 | 4.45 | 517 | 65.4 | 320 |
| Ex. 209 | C-1 | E-9 | 4.56 | 515 | 64.2 | 321 |
| Ex. 210 | C-1 | E-10 | 4.48 | 518 | 66.1 | 333 |
| Ex. 211 | C-2 | E-1 | 4.48 | 518 | 64.3 | 342 |
| Ex. 212 | C-2 | E-2 | 4.81 | 517 | 65.1 | 321 |
| Ex. 213 | C-2 | E-3 | 4.54 | 515 | 61.4 | 333 |
| Ex. 214 | C-2 | E-4 | 4.65 | 516 | 64.3 | 342 |
| Ex. 215 | C-2 | E-5 | 4.55 | 516 | 62.3 | 351 |
| Ex. 216 | C-2 | E-6 | 4.67 | 518 | 62.3 | 321 |
| Ex. 217 | C-2 | E-7 | 4.54 | 518 | 64.3 | 334 |
| Ex. 218 | C-2 | E-8 | 4.45 | 518 | 62.3 | 304 |
| Ex. 219 | C-2 | E-9 | 4.81 | 516 | 64.3 | 342 |
| Ex. 220 | C-2 | E-10 | 4.54 | 516 | 62.3 | 321 |
| Ex. 221 | C-3 | E-1 | 4.65 | 518 | 66.1 | 333 |
| Ex. 222 | C-3 | E-2 | 4.55 | 518 | 64.3 | 342 |
| Ex. 223 | C-3 | E-3 | 4.54 | 517 | 65.1 | 351 |
| Ex. 224 | C-3 | E-4 | 4.56 | 518 | 62.3 | 321 |
| Ex. 225 | C-3 | E-5 | 4.45 | 517 | 65.4 | 334 |
| Ex. 226 | C-3 | E-6 | 4.56 | 515 | 64.2 | 331 |
| Ex. 227 | C-3 | E-7 | 4.48 | 518 | 66.1 | 341 |
| Ex. 228 | C-3 | E-8 | 4.48 | 518 | 64.3 | 304 |
| Ex. 229 | C-3 | E-9 | 4.81 | 517 | 65.1 | 320 |
| Ex. 230 | C-3 | E-10 | 4.54 | 515 | 61.4 | 321 |
| Ex. 231 | C-4 | E-1 | 4.65 | 516 | 64.3 | 333 |
| Ex. 232 | C-4 | E-2 | 4.55 | 516 | 62.3 | 342 |
| Ex. 233 | C-4 | E-3 | 4.67 | 518 | 62.3 | 320 |
| Ex. 234 | C-4 | E-4 | 4.54 | 518 | 64.3 | 341 |
| Ex. 235 | C-4 | E-5 | 4.45 | 518 | 62.3 | 332 |
| Ex. 236 | C-4 | E-6 | 4.54 | 517 | 65.4 | 322 |
| Ex. 237 | C-4 | E-7 | 4.65 | 515 | 64.2 | 329 |
| Ex. 238 | C-4 | E-8 | 4.67 | 516 | 62.3 | 321 |
| Ex. 239 | C-4 | E-9 | 4.54 | 515 | 64.3 | 334 |
| Ex. 240 | C-4 | E-10 | 4.67 | 517 | 62.3 | 304 |
| Ex. 241 | D-1 | E-1 | 4.54 | 515 | 64.3 | 342 |
| Ex. 242 | D-1 | E-2 | 4.65 | 518 | 62.3 | 321 |
| Ex. 243 | D-1 | E-3 | 4.55 | 518 | 66.1 | 333 |
| Ex. 244 | D-1 | E-4 | 4.67 | 517 | 64.3 | 342 |
| Ex. 245 | D-1 | E-5 | 4.54 | 515 | 65.1 | 351 |
| Ex. 246 | D-1 | E-6 | 4.56 | 518 | 62.3 | 321 |
| Ex. 247 | D-1 | E-7 | 4.45 | 516 | 65.4 | 334 |
| Ex. 248 | D-1 | E-8 | 4.54 | 516 | 64.2 | 331 |
| Ex. 249 | D-1 | E-9 | 4.56 | 515 | 66.1 | 341 |
| Ex. 250 | D-1 | E-10 | 4.45 | 518 | 64.3 | 304 |
| Ex. 251 | D-2 | E-1 | 4.55 | 516 | 65.1 | 320 |
| Ex. 252 | D-2 | E-2 | 4.67 | 516 | 61.4 | 321 |
| Ex. 253 | D-2 | E-3 | 4.54 | 515 | 64.3 | 333 |
| Ex. 254 | D-2 | E-4 | 4.56 | 518 | 62.3 | 342 |
| Ex. 255 | D-2 | E-5 | 4.45 | 518 | 62.3 | 320 |
| Ex. 256 | D-2 | E-6 | 4.45 | 518 | 62.3 | 351 |
| Ex. 257 | D-2 | E-7 | 4.54 | 517 | 65.4 | 321 |
| Ex. 258 | D-2 | E-8 | 4.65 | 515 | 64.2 | 334 |
| Ex. 259 | D-2 | E-9 | 4.67 | 516 | 62.3 | 304 |
| Ex. 260 | D-2 | E-10 | 4.54 | 515 | 64.3 | 320 |
| Ex. 261 | D-3 | E-1 | 4.67 | 517 | 62.3 | 321 |
| Ex. 262 | D-3 | E-2 | 4.54 | 515 | 64.3 | 333 |
| Ex. 263 | D-3 | E-3 | 4.65 | 518 | 62.3 | 342 |
| Ex. 264 | D-3 | E-4 | 4.55 | 518 | 66.1 | 321 |
| Ex. 265 | D-3 | E-5 | 4.67 | 517 | 64.3 | 333 |
| Ex. 266 | D-3 | E-6 | 4.54 | 515 | 64.2 | 342 |
| Ex. 267 | D-3 | E-7 | 4.56 | 516 | 62.3 | 351 |
| Ex. 268 | D-3 | E-8 | 4.45 | 515 | 64.3 | 321 |
| Ex. 269 | D-3 | E-9 | 4.55 | 517 | 62.3 | 334 |
| Ex. 270 | D-3 | E-10 | 4.67 | 515 | 64.3 | 331 |
| Ex. 271 | D-4 | E-1 | 4.54 | 518 | 62.3 | 341 |
| Ex. 272 | D-4 | E-2 | 4.56 | 518 | 66.1 | 304 |
| Ex. 273 | D-4 | E-3 | 4.45 | 517 | 64.3 | 320 |
| Ex. 274 | D-4 | E-4 | 4.54 | 515 | 65.1 | 321 |
| Ex. 275 | D-4 | E-5 | 4.56 | 518 | 62.3 | 333 |
| Ex. 276 | D-4 | E-6 | 4.45 | 516 | 65.4 | 342 |
| Ex. 277 | D-4 | E-7 | 4.56 | 516 | 64.2 | 320 |
| Ex. 278 | D-4 | E-8 | 4.48 | 515 | 66.1 | 341 |
| Ex. 279 | D-4 | E-9 | 4.55 | 518 | 66.1 | 321 |
| Ex. 280 | D-4 | E-10 | 4.67 | 517 | 64.3 | 333 |
| C. Ex. 1 | HT-1 | ET-1 | 6.01 | 517 | 45.3 | 250 |
| C. Ex. 2 | A-1 | ET-1 | 5.98 | 517 | 46.2 | 203 |
| C. Ex. 3 | B-2 | ET-2 | 5.89 | 519 | 44.3 | 245 |
| C. Ex. 4 | C-3 | ET-3 | 5.96 | 517 | 45.2 | 227 |
| C. Ex. 5 | D-4 | ET-4 | 5.67 | 518 | 46.1 | 233 |

As shown in Table 1, the green organic EL devices of Examples 1-280, in which specific first host and second host compounds (A-1 to E-10) were used as the emission layer materials according to the present disclosure, exhibited superior performance in terms of efficiency, driving voltage, and lifespan compared to the green organic EL device of Comparative Example 1, which used conventional HT-1 and ET-1. Additionally, the green organic EL devices of Examples 1-280, which utilized the superior donor-type first host combined with the conventional N-type host, showed better efficiency and driving voltage characteristics compared to the green organic EL devices of Comparative Examples 2 to 5. Particularly, significant improvements in device lifespan were observed.

## Claims

1. A composition for an organic electroluminescent device, the composition comprising:
a first host represented by the following Chemical Formula 1; and
a second host represented by the following Chemical Formula 2: 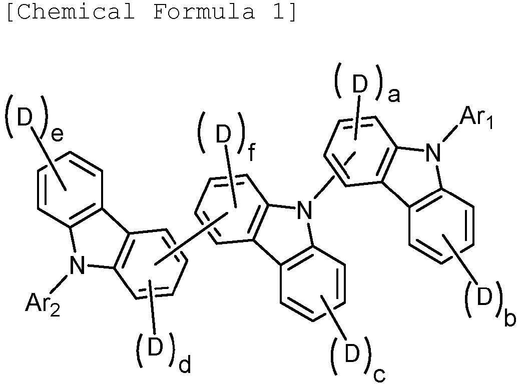 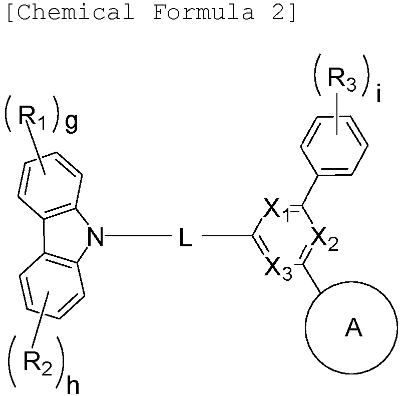
wherein,
Ar₁ and Ar₂ are same or different from each other, and are each independently selected from the group consisting of an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀,
X₁ to X₃ are same or different from each other, and are each independently N or C(R₆), provided that at least two of X₁ to X₃ being each N,
L is a single bond or is selected from the group consisting of an arylene group of C₆-C₆₀ and a heteroarylene group of 5 to 60 nuclear atoms,
A is a substituent represented by the following Chemical Formula 3 or 4: 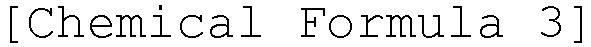 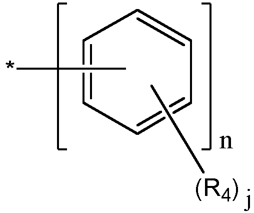 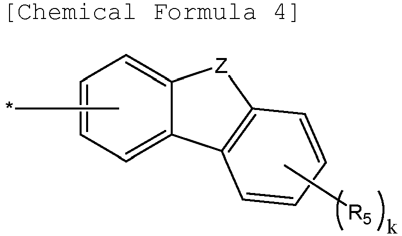
wherein,
Z is selected from the group consisting of O, S, Se, and C(R₇)(R₈),
R₁ to R₈, which are same or different, are each independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group of 3 to 40 nuclear atoms, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkyl phosphine oxide group of C₁-C₄₀, an aryl phosphine oxide group of C₆-C₆₀, an aryl phosphine oxide group of C₆-C₆₀, and an arylamine group of C₆-C₆₀, or may bond with an adjacent groups to form a fused ring,
a, d, and f are each independently an integer of 0 to 3,
b, c, e, g, i, j, and k are each independently an integer of 0 to 4,
n is an integer of 1 to 3,
in Chemical Formula 1, the hydrogen atoms on the benzene rings in the carbazole moiety with no deuterium atoms substituted therein are substituted by a substituent selected from the group consisting of an alkyl group of C₁-C₄₀, an aryl group of C₆-C₄₀, and a heteroaryl group of 5 to 40 nuclear atoms,
the arylene group and heteroarylene group of L and the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group and fused ring of Ar₁ to Ar₂ and R₁ to R₈ are each independently substituted with one or more substituents selected from the group consisting of a deuterium atom (D), a halogen group, a cyano group, a nitro group, an alkenyl group of C₂-C₄₀, an alkynyl group of C₂-C₄₀, a cycloalkyl group of C₃-C₄₀, a heterocycloalkyl group of 3 to 40 nuclear atoms, an alkyl group of C₁-C₄₀, an aryl group of C₆-C₆₀, a heteroaryl group of 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an aryl phosphine oxide group of C₆-C₆₀, an aryl phosphine oxide group of C₆-C₆₀, and an arylamine group of C₆-C₆₀, and when the substituents are plural in number, the substituents are the same as or different from each other.

2. The composition of claim 1, wherein the first host contains at least 21 deuterium atoms (D).

3. The composition of claim 1, wherein Ar₁ and Ar₂ are same or different from each other, and are each independently selected from the substituents S1 to S9: 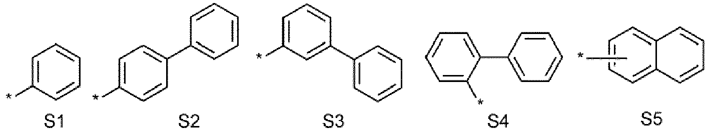 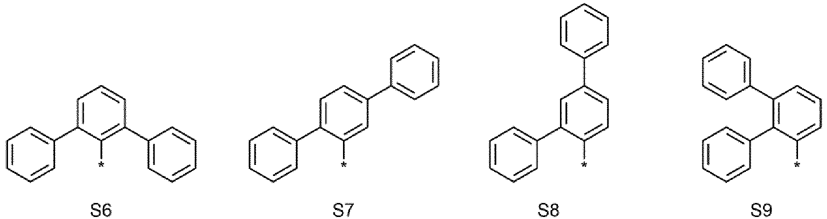 wherein, * represents a bonding site to Chemical Formula 1.

4. The composition of claim 1, wherein the first host is a compound represented by the following Chemical Formula 1A: 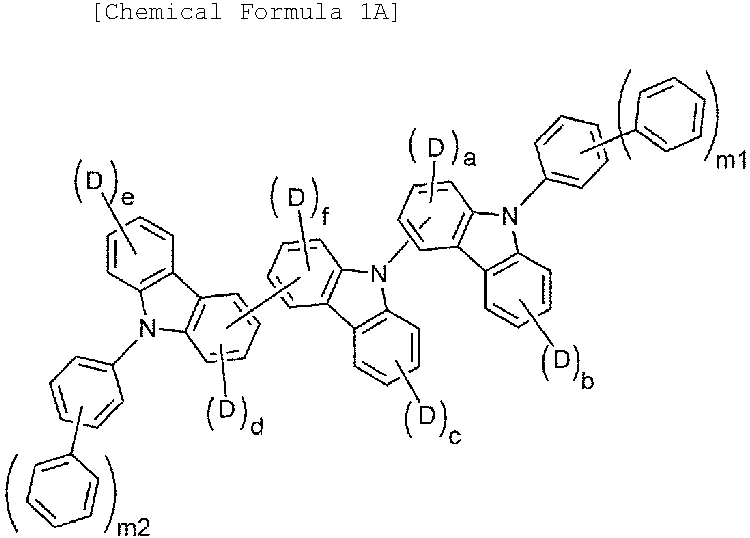 wherein,
a, b, c, d, e, and f are each as defined in Chemical Formula 1, and
m1 and m2 are each 0 or 1.

5. The composition of claim 1, wherein the first host is a compound represented by any one of the following Chemical Formulas 1a to 1d: 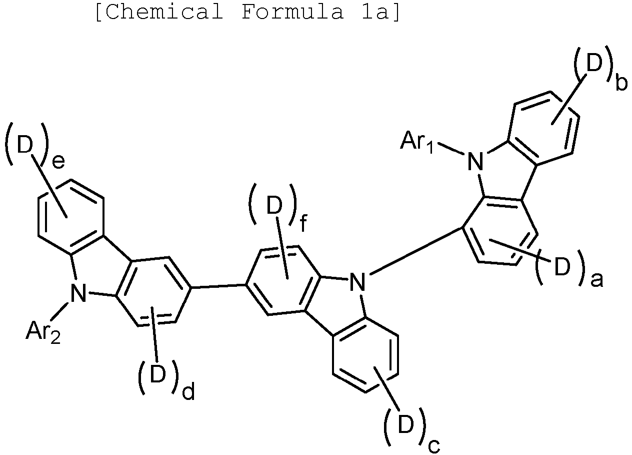 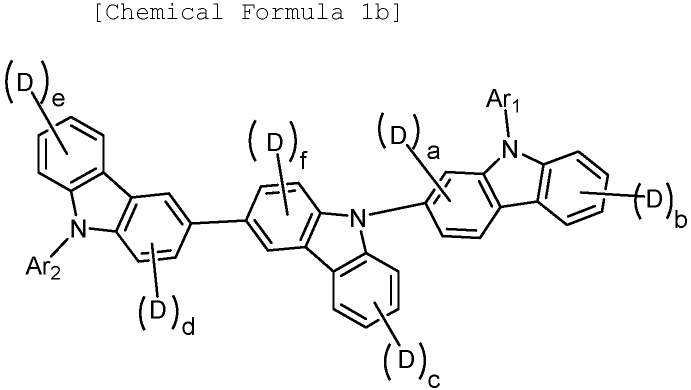 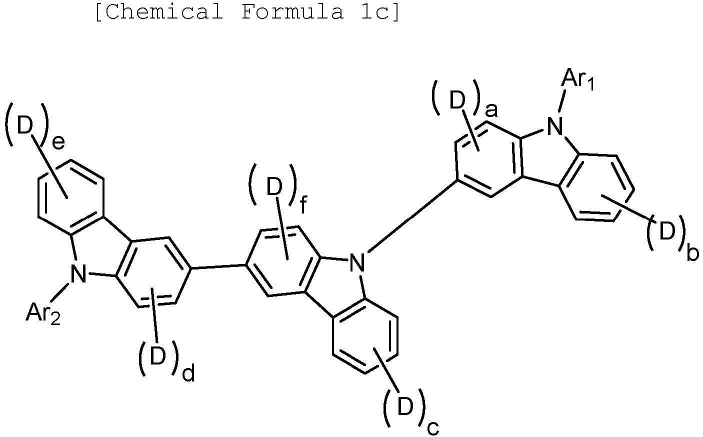 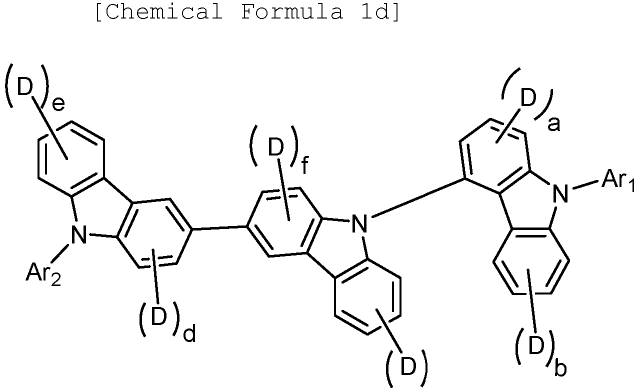 wherein,
a, b, c, d, e, f, Ar₁, and Ar₂ are each as defined in claim 1.

6. The composition of claim 1, wherein the first host is selected from the group consisting of the following compounds A-1 to D-4:

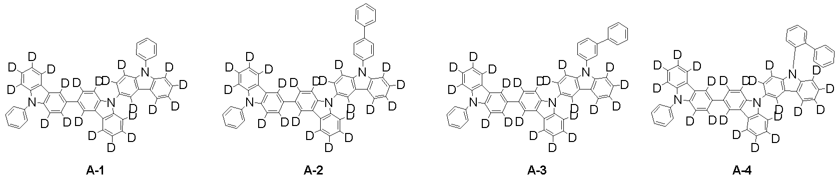

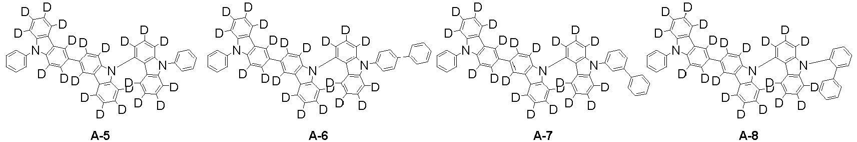

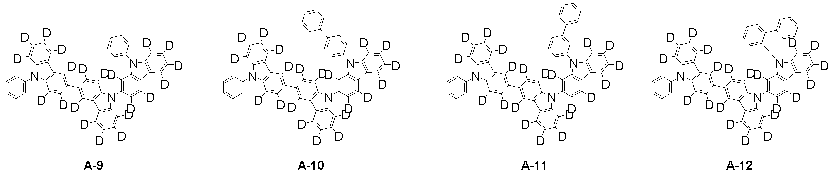

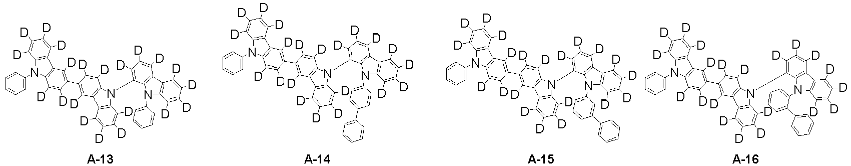

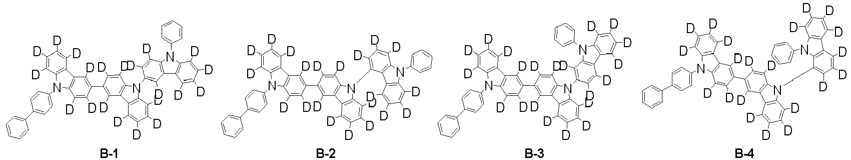

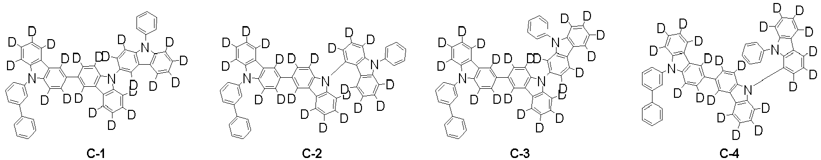

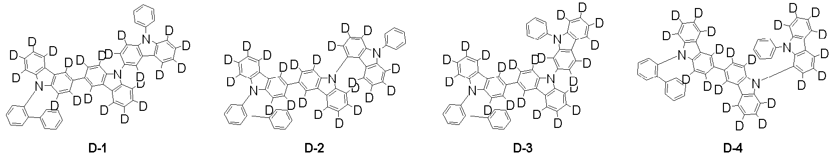

7. The composition of claim 1, wherein the second host is represented by the following Chemical Formula 5 or 6: 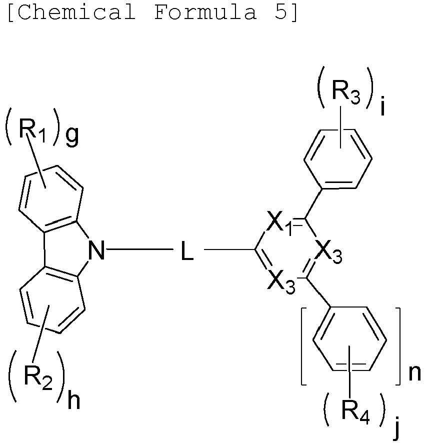 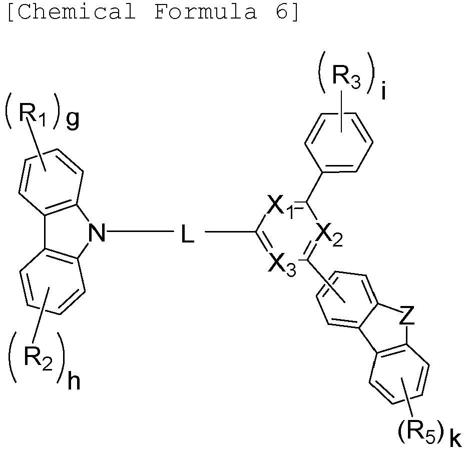 wherein,
X₁- X₃, Z, L, R₁ to R₅, g, h, i, j, k, and n are each as defined in claim 1.

8. The composition of claim 1, wherein the second host is a compound represented by any one of the following Chemical Formulas 7 to 10: 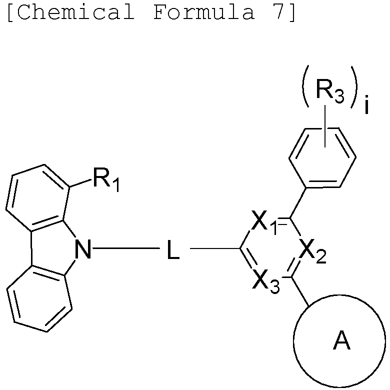 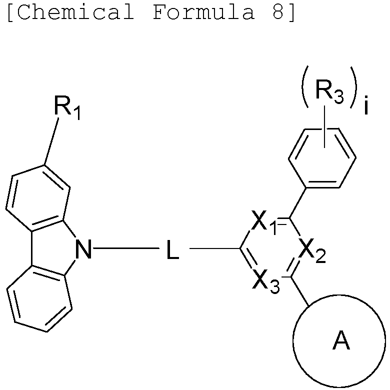 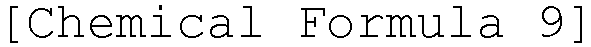 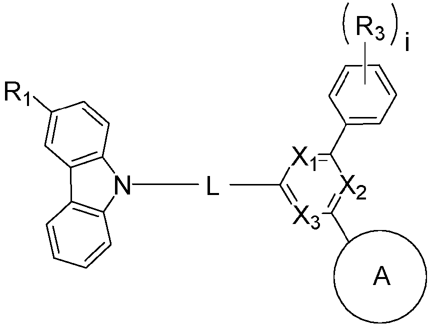 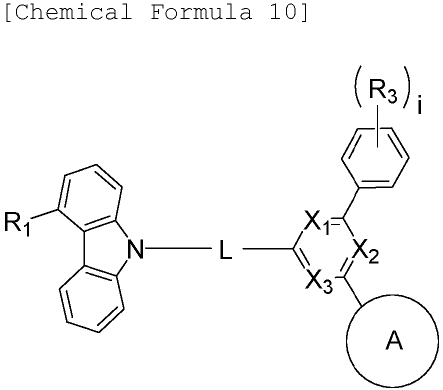 wherein,
X₁- X₃, A, L, R₁, R₃, and i are each as defined in claim 1.

9. The composition of claim 8, wherein R₁ is selected from the following structural formulas: 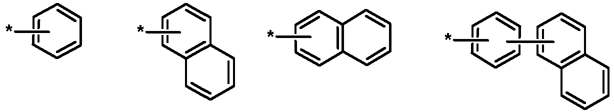 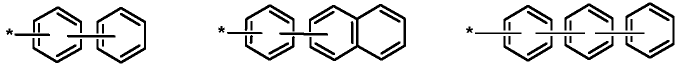 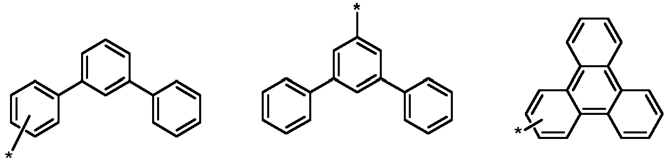 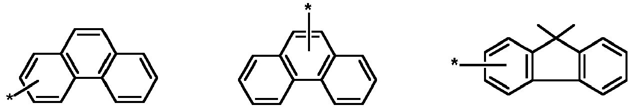 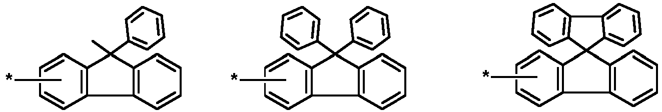 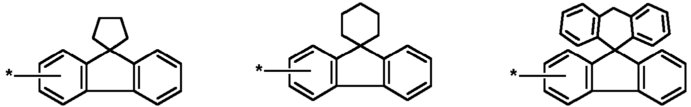 wherein,
* indicates a bonding site to Chemical Formula 2.

10. The composition of claim 1, wherein the second host is a compound represented by any one of the following Chemical Formulas 11 to 17: 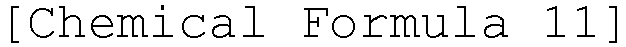 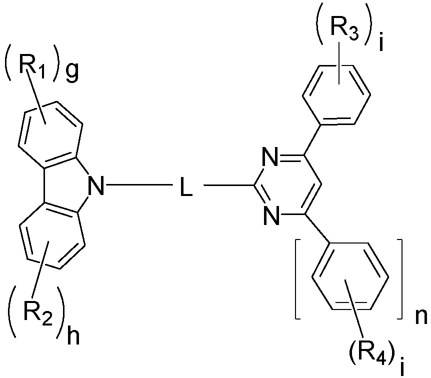 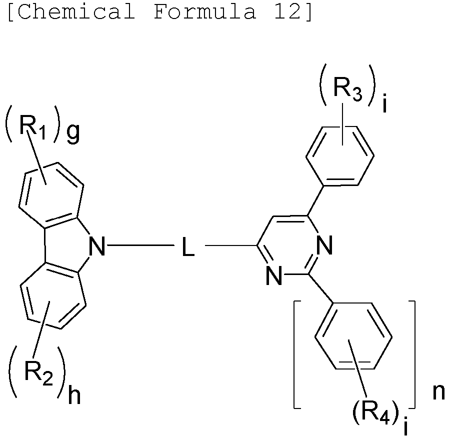 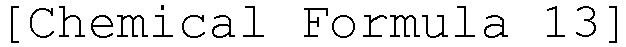 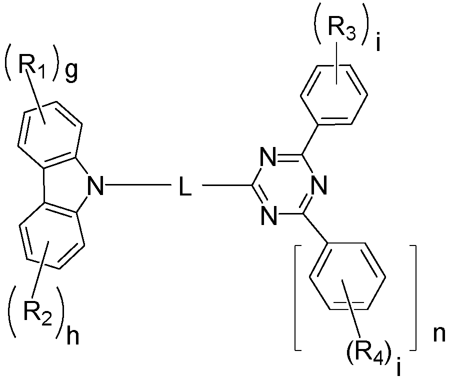 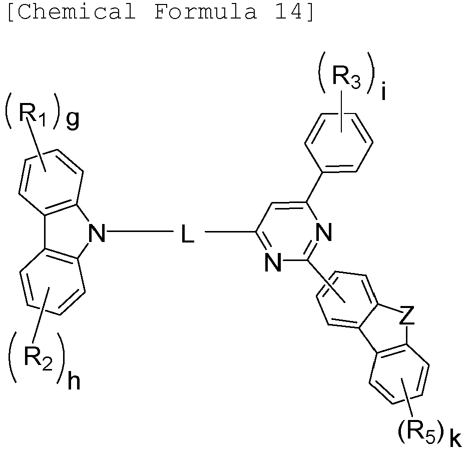 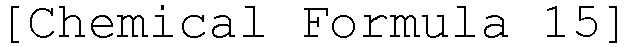 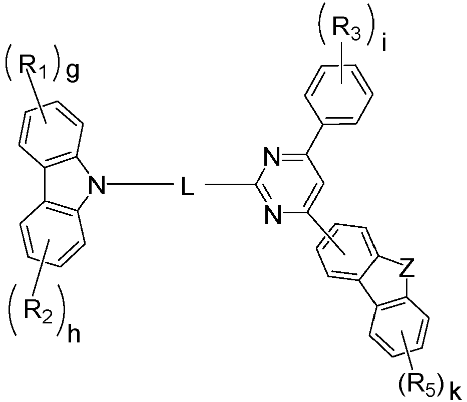 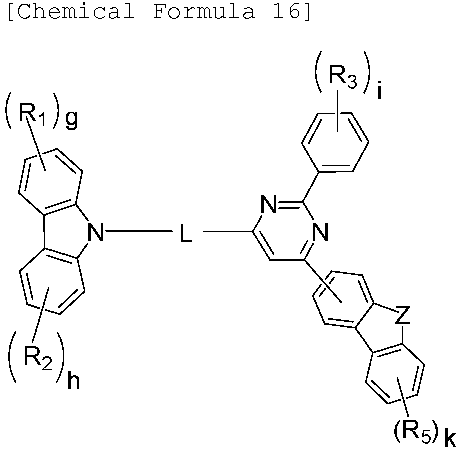 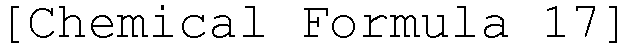 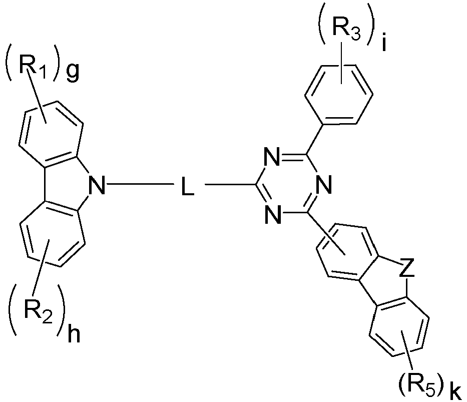 wherein,
Z, L, R₁ to R₅, g, h, i, j, k, and n are each as defined in claim 1.

11. The composition of claim 1, wherein L is a single bond or a linker selected from the following structural formulas: 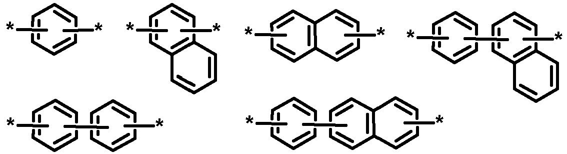 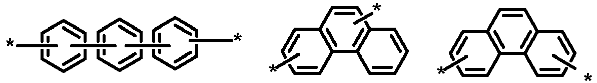 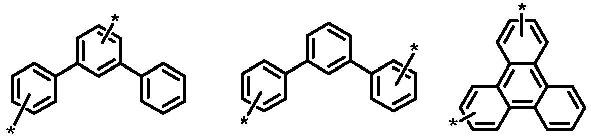 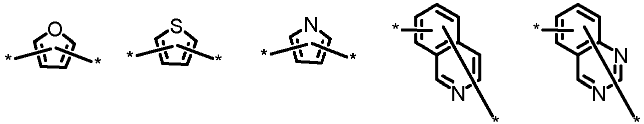 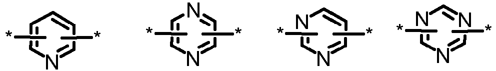 wherein,
* indicates a bonding site to Chemical Formula 2.

12. The composition of claim 1, wherein the second host is selected from the group consisting of the following compounds E-1 to E-10:

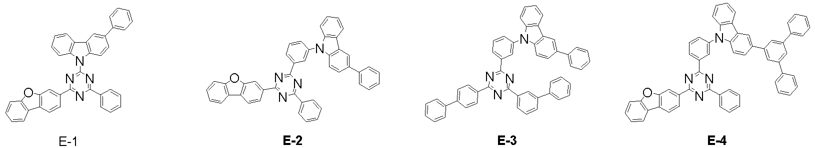

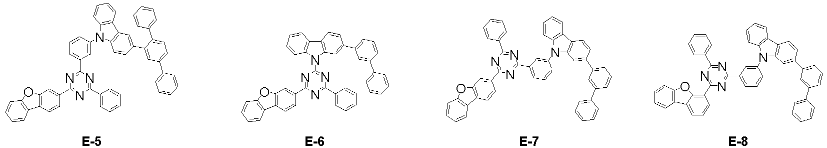

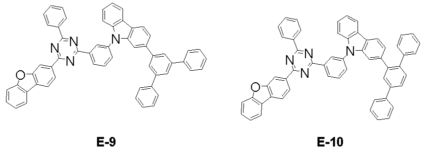

13. The composition of claim 1, wherein the first host and the second host are contained at a weight ratio of 1 : 99 to 99 : 1.

14. The composition of claim 1, wherein the composition further comprises a phosphorescent dopant.

15. The composition of claim 14, wherein the phosphorescent comprises iridium (Ir) or platinum (Pt).

16. An organic electroluminescent device, comprising:
an anode;
a cathode; and
at least one organic layer interposed between the anode and the cathode,
wherein the at least one organic layer comprises the composition of any one of claims 1 to 15.

17. The organic electroluminescent device of claim 16, wherein the at least one organic layer comprises an emission layer and the composition is contained in the emission layer.
